# EUROPEAN PATENT SPECIFICATION

(11) **EP 1 786 242 B1**
(45) Date of publication and mention of the grant of the patent: **27.08.2014**
(21) Application number: 05761819.1
(22) Date of filing: 22.07.2005
(51) Int. Cl.: H05B 33/12, H05B 33/14, H05B 33/22

(54) **ORGANIC ELECTROLUMINESCENCE DEVICE, DISPLAY APPARATUS AND LIGHTING APPARATUS**
ORGANISCHES ELEKTROLUMINESZENZBAUELEMENT, DISPLAYVORRICHTUNG UND BELEUCHTUNGSVORRICHTUNG
DISPOSITIF ÉLECTROLUMINESCENT ORGANIQUE, APPAREIL D'AFFICHAGE ET APPAREIL D'ÉCLAIRAGE

(30) Priority: 05.08.2004 JP 2004229165
(43) Date of publication of application: 16.05.2007
(73) Proprietor: KONICA MINOLTA HOLDINGS, INC., Tokyo 100-0005 (JP)
(72) Inventor: SUZURI, Yoshiyuki Konica Minolta Tech. Center, Inc, Hachioji-shi, Tokyo 192-8505 (JP); KITA, Hiroshi Konica Minolta Tech. Center, Inc., Hachioji-shi, Tokyo 192-8505 (JP); KAWAKAMI Akira Tec. Res. Ass. for Adv. Display Mat, Koganei-shi, Tokyo 184-0012 (JP)
(74) Representative: Stuttard, Garry Philip
(86) International application number: PCT/JP2005/013484
(87) International publication number: WO 2006/013738

(56) References cited:
- EP-A1- 1 784 056
- WO-A1-2004/060026
- JP-A- 08 078 163
- JP-A- 2001 313 180
- JP-A- 2005 183 213
- TOKIMASA S.: 'Aoiro/Shiroiro Rin Hikari Yuki El Soshi heno Torikumi to Kadai' FPD INTERNATIONAL 2004 PRESEMINAR DAI 4 KAI YUKI EL PANEL, ZAIRYO KARA NO CHOJUMYOKA 23 April 2004, pages 7 - 17
- SATO Y.: 'Organic Electroluminescence' MATERIAL AND TECHNOLOGIES, DAI 1 PAN, KABUSHIKI KAISHA CMC SHUPPAN HAKKO 31 May 2004, pages 215 - 222

## Description

### FIELD OF THE INVENTION

The present invention relates to an organic electroluminescence element exhibiting a high efficiency and small color deviation.

### BACKGROUND

An organic electroluminescence element (also simply referred to as an organic EL element) is excellent in visibility since it is self emitting, as well as can be made light weighted including a drive circuit because of capability of being driven at a low voltage as small as several V - several tens V. Therefore, an organic EL element is expected to be utilized as a thin layer display, an illuminator and a backlight.

Further, an organic EL element is also characterized by having plenty of color variations. Further, it is also characterized in that various emissions are possible by color mixture which combines a plural number of emission colors.

Among emission colors, needs to white emission is particularly high and white emission can be also utilized as a backlight. Further, white emission can be separated into pixels of blue, green and red by use of color filters.

A method to perform such white emission includes the following two types of methods.
1. To dope a plural number of emission compounds in one light emission layer.
2. To combine a plural number of colors from a plural number of light emission layers.

For example, in the case of achieving white color by three colors of blue (B), green (G) and red (R), as shown in case 1, it is necessary to perform four source evaporation of B, G, R and a host compound when a vacuum evaporation method is employed as an element preparation method, resulting in very difficult control.

Further, there is also a method to coat B, G, R and a host compound having been dissolved or dispersed in a solution, however, heretofore, there is a problem that a coating type organic EL element is inferior in durability compared to an evaporation type.

On the other hand, there is proposed method 2 to combine a plural number of light emission layers. In the case of employing an evaporation method, method 2 is easier compared to 1.

As an organic electroluminescence to perform such a white emission, proposed are those in which two layers of a blue-emission layer as a short wavelength emission and a red-emission layer as a long wavelength emission are accumulated to provide white emission as color mixture of the both light emission layers (For example, refer to patent literature 1.).

However, in those in which two light emission layers having different emission colors (different peak wavelengths) are accumulated, layer properties may be varied or a degree of transport properties of a hole (a positive hole) and an electron may be varied depending on two light emission layers, accompanied with a drive time of an element, that is, changes of emission time and applied voltage, to cause shift of the emission center, resulting in easy variation of chromaticity.

Particularly, in the case of obtaining white as a color mixture of two light emission layers, the problem becomes notable since white is more sensitive to chromaticity variation compared to other colors.

In an organic EL element which performs color mixture emission from a plural number of light emission layers having different peak wavelengths, as a method to depress chromaticity variation accompanied with driving time and voltage change as much as possible, disclosed is one in which not less than 3 layers of light emission layers, which perform emission of different peak wavelengths, are alternately accumulated (For example, refer to patent literature 2.).

Further, in an accumulation structure of not less than two layers, disclosed has been a method to design a thickness of a light emission layer and a ratio of an organic host material to a fluorescent material based on an emission efficiency as a parameter (For example, refer to patent literature 3.).

This alternative accumulation has an effect of hardly causing color deviation even when some deviation is caused in injection balance of a carrier. However, emission efficiency is low and energy transfer between layers is caused resulting in recognized deviation in whiteness, and it has been proved to be still insufficient as white emission.

Further, as an example of achieving white by a combination of a plural number of light emission layers includes an example in which an intermediate layer is provided between two layers of light emission layers having different emission colors (For example, refer to non-patent literature 1).

However, problems of the above-described technologies include the following three points, which were left as problems to be solved:
1. An emission color is shifted by voltage (current).
2. Efficiency does not reach the theoretical limit.
3. Preparation is complicated by providing an intermediate layer.

[Patent Literature 1] JP-A 7-142169 (hereinafter JP-A refers to Japanese Patent Publication Open to Public Inspection No.)
[Patent Literature 2] JP-A 2003-187977
[Patent Literature 3] JP-A 2004-63349
[Non-patent Literature 1] Applied Physics Letters, Vol. 83, 2459 (2003) and Advanced Materials, Vol. 14, No. 2, 147
EP 1784056A1 describes an organic electroluminescent element comprising an anode, a cathode, at least two light emission layers provided between the anode and cathode; and at least one intermediate layer provided between two light emission layers.
WO 2004/060026A1 describes a white organic light-emitting element with high emission efficiency. In particular, the emission spectrum has peaks in the respective wavelength regions of the colours red, green and blue.
JP 2005-183213A describes an organic electroluminescent element which has a plurality of light emitting units providing organic electroluminescent light emission. The light emitting units are connected in series. Different colours are obtained by mixing the colours of the light emission units.
JP 08-78163A describes a stable light emitting layer which is formed without using a solution application method. The light emitting layer is formed by inserting a carrier recombining area control layer between a hole transport layer and an electron transport layer.
JP 2001-313180 describes an organic electroluminescent element comprising a substrate, an anode, a hole carrier layer, a plurality of luminous layers, an electron carrier layer and a cathode which are formed on the substrate successively.

### SUMMARY OF THE INVENTION

An object of the present invention is to provide a highly efficient white-multicolor emitting organic electroluminescence element, which is free from color deviation under a minute voltage·current change.
To achieve the above-described object, an aspect of the present invention provides an organic electroluminescence element comprising: an anode and a cathode having therebetween two or more light emission layers exhibiting different emission peaks and an intermediate layer provided between the light emission layers, wherein the light emission layers comprise a phosphorescent compound as a light emission compound selected from: 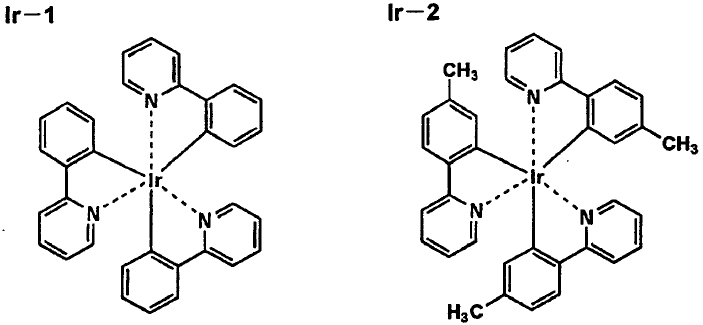 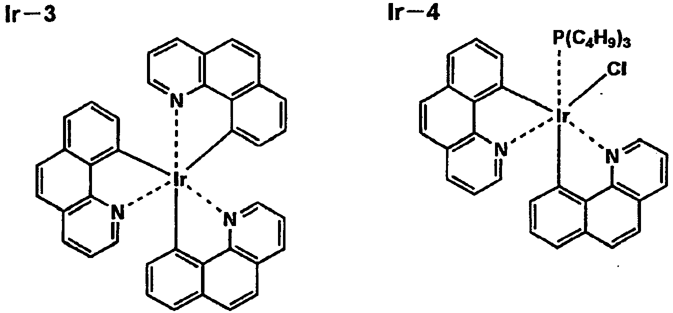 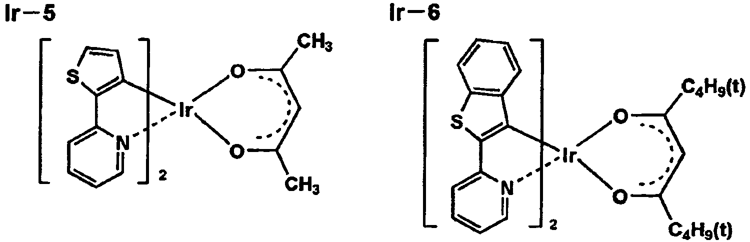 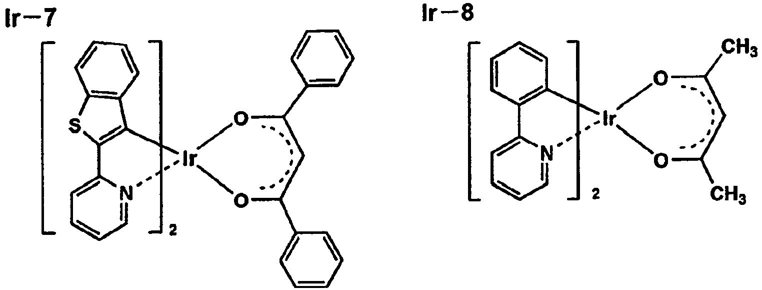 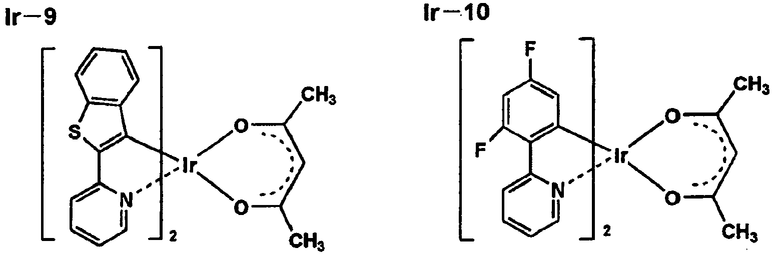 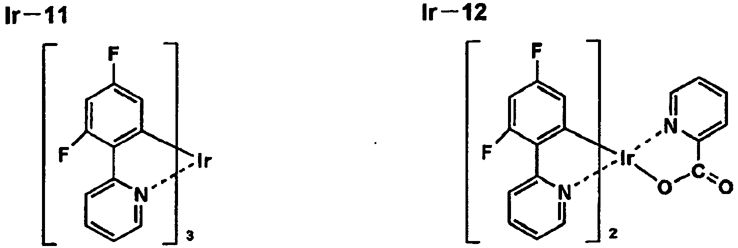 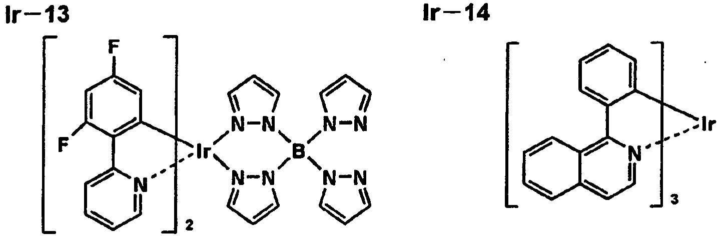 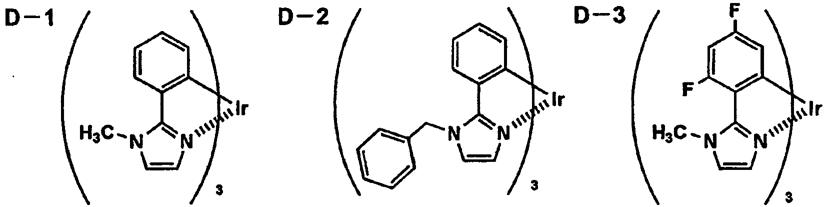 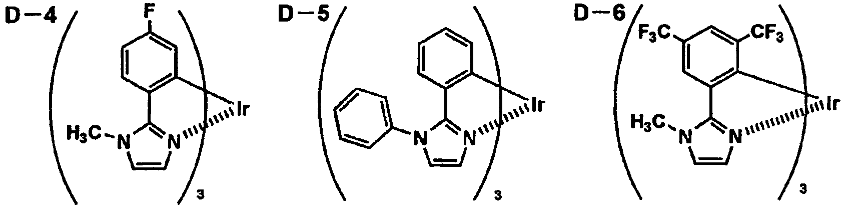 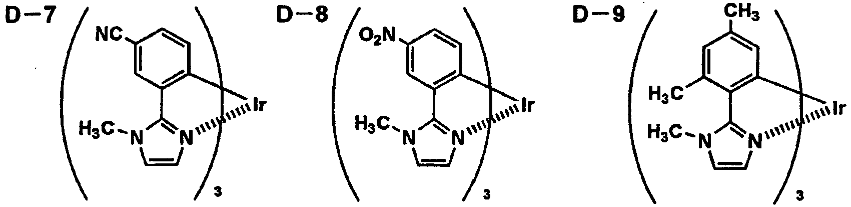 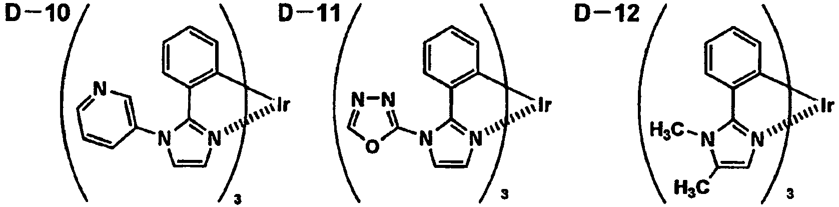 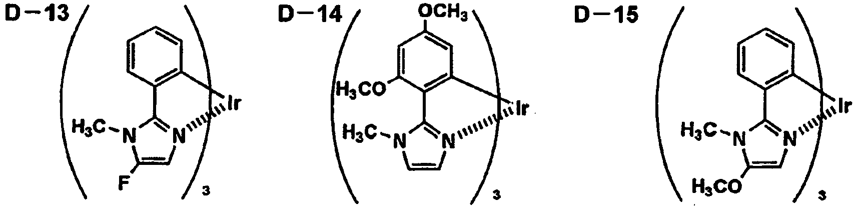 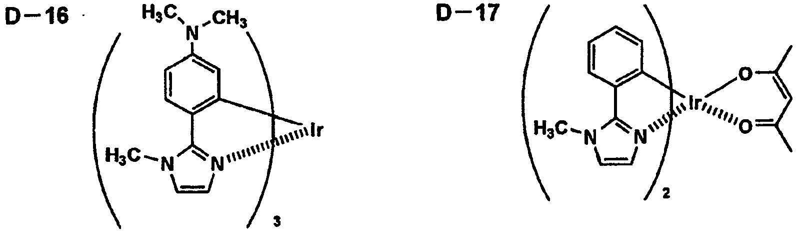 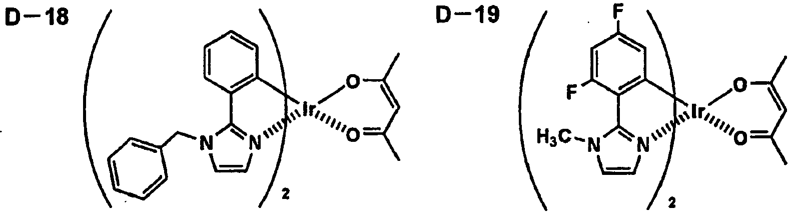 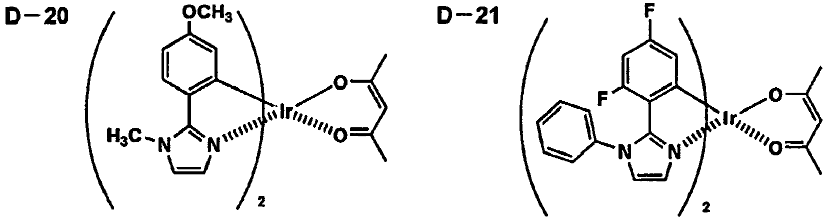 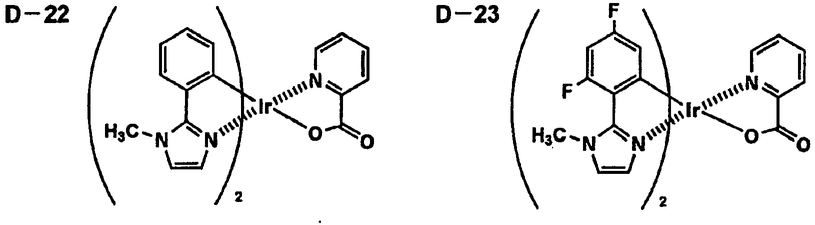 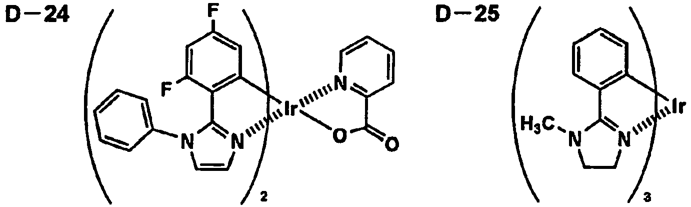 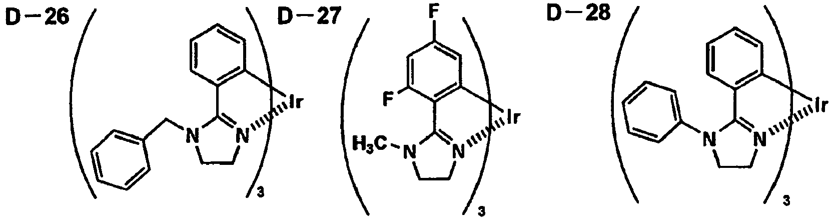 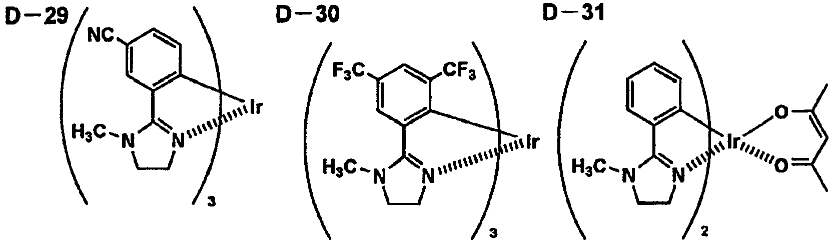 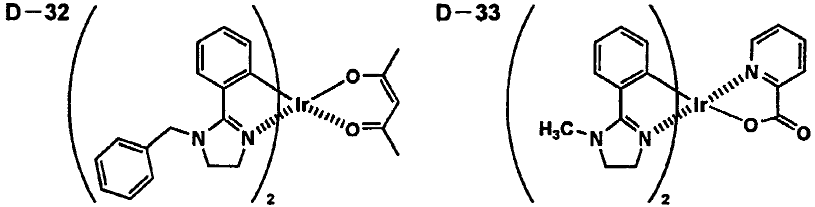 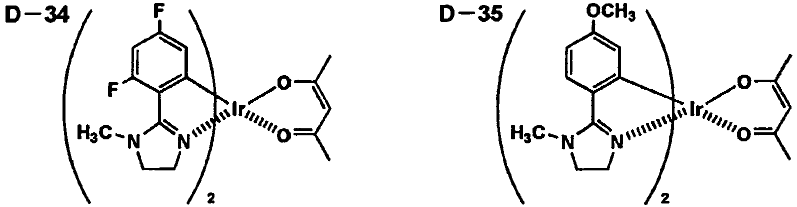 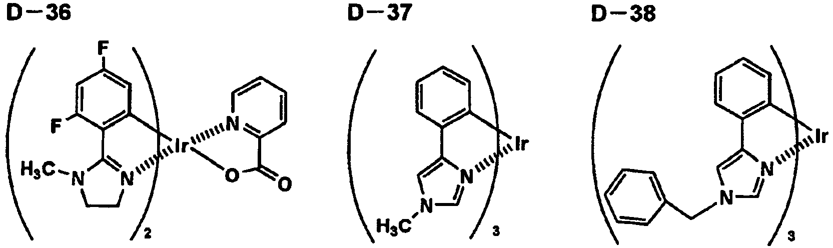 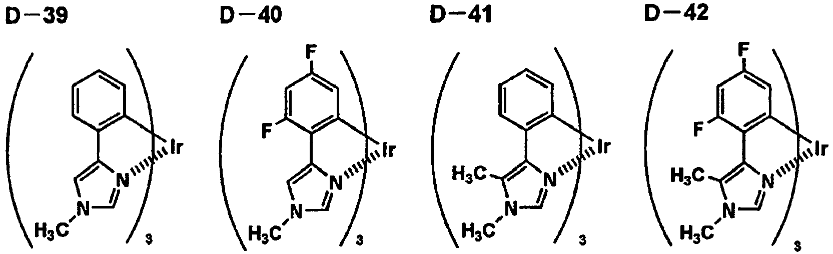 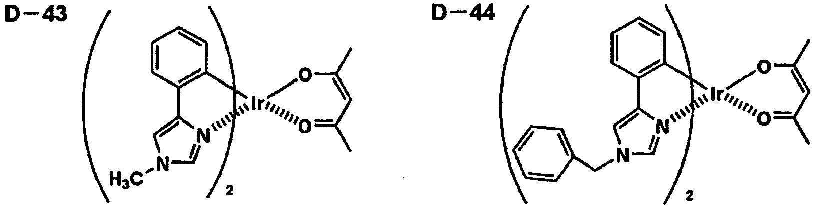 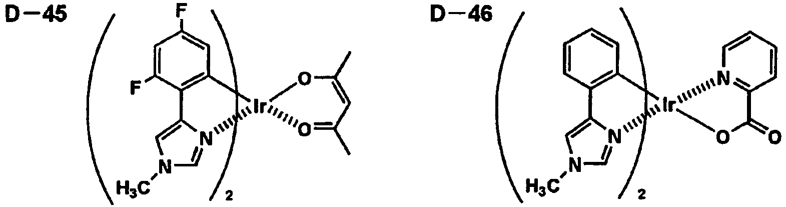 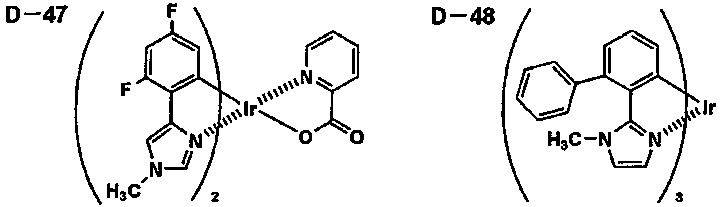 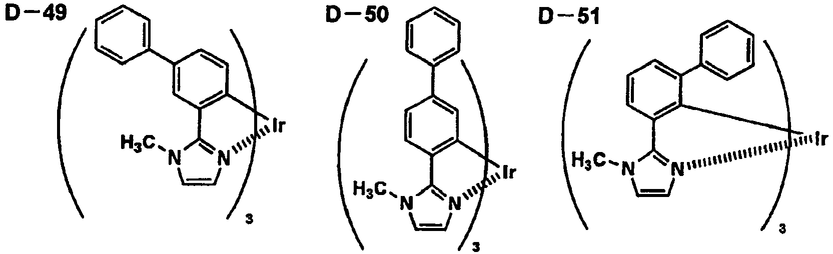 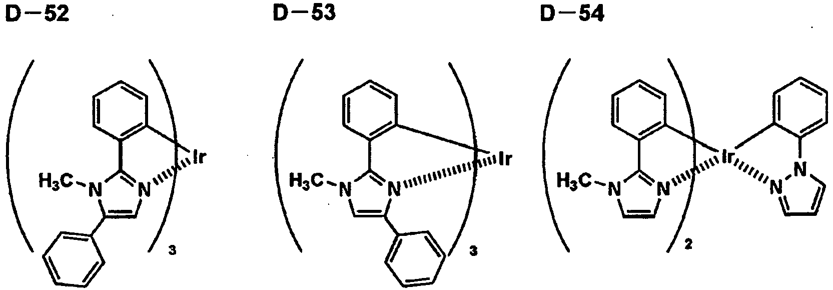 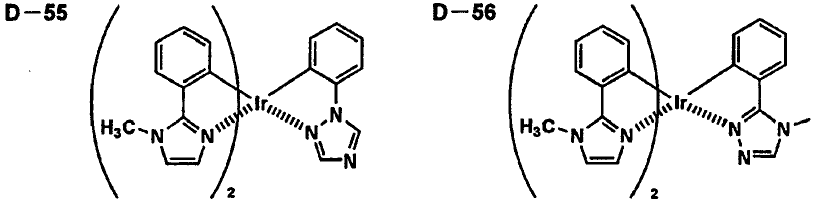 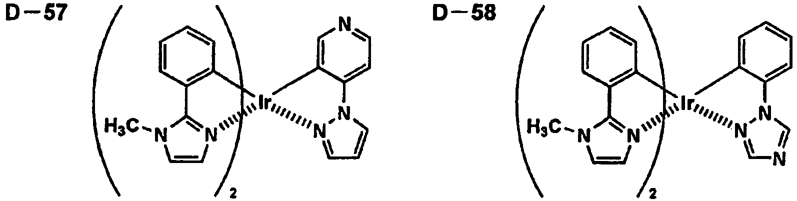 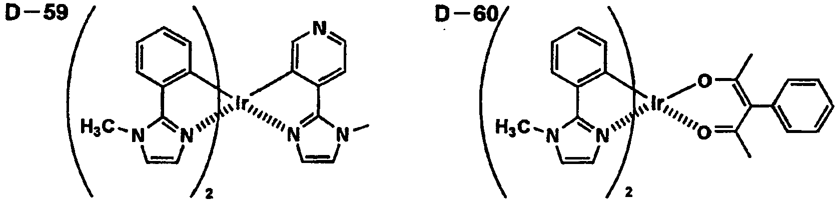 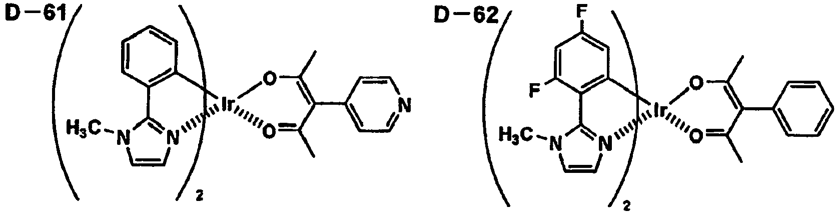 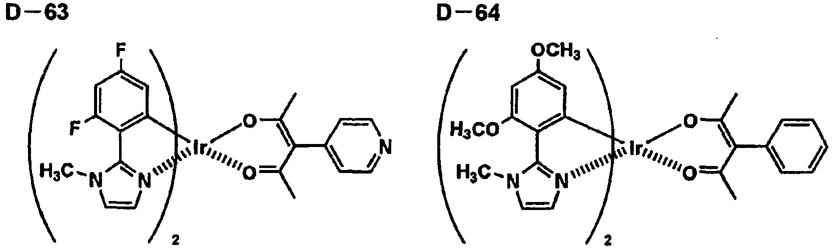 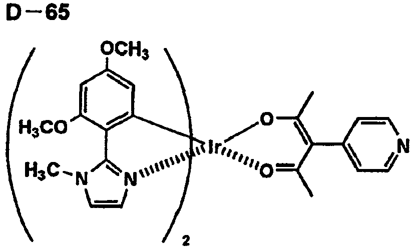 and a host compound selected from: 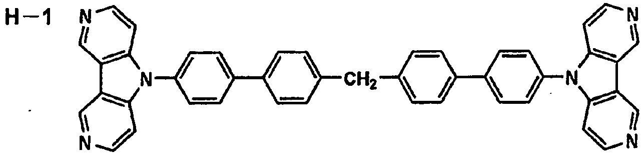 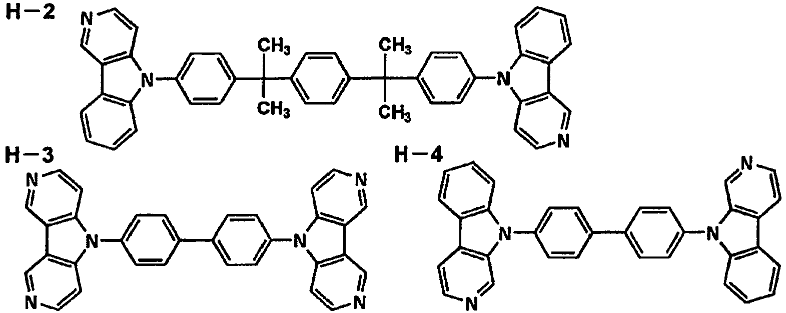 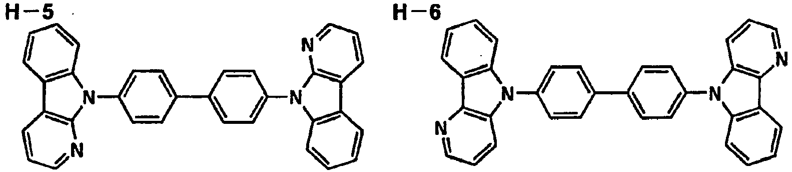 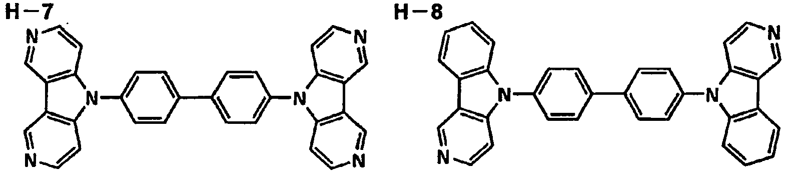 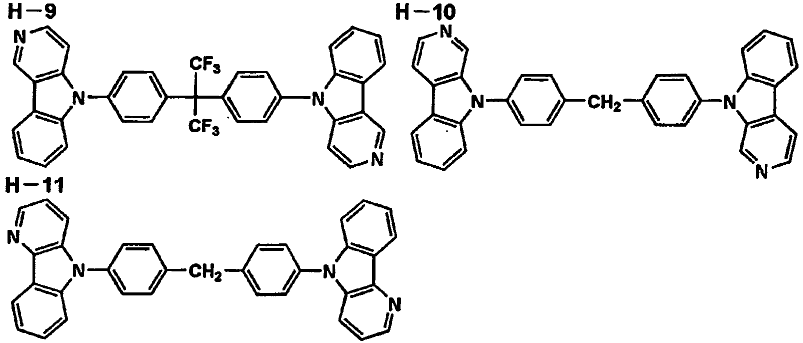 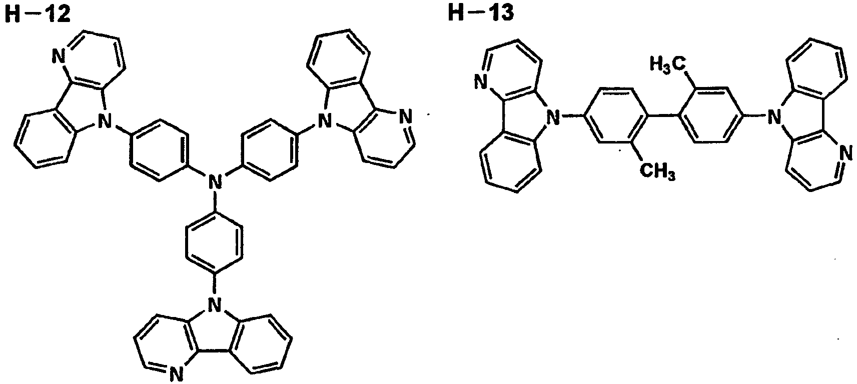 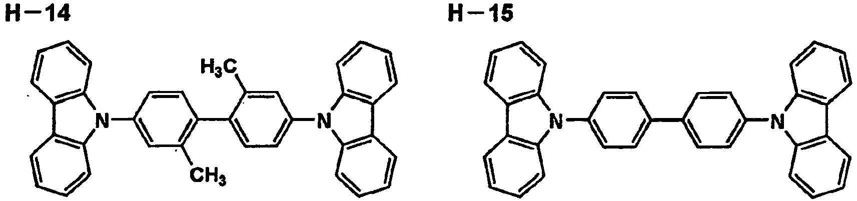 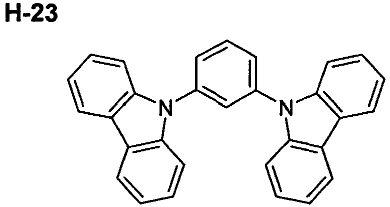 an excited triplet energy of a compound forming the intermediate layer is larger than an excited triplet energy of the phosphorescent compound and the compound forming the intermediate layer is selected from: 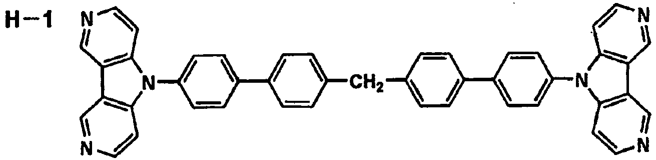 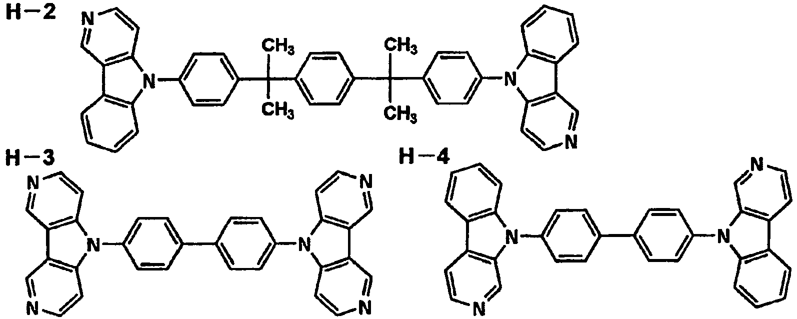 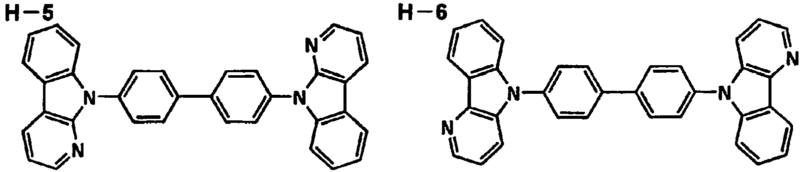 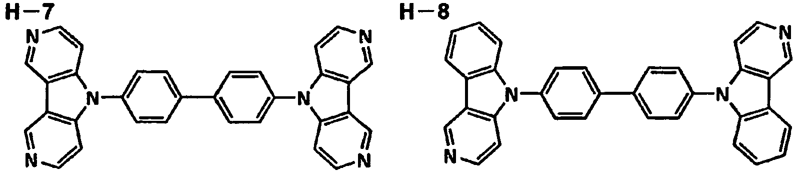 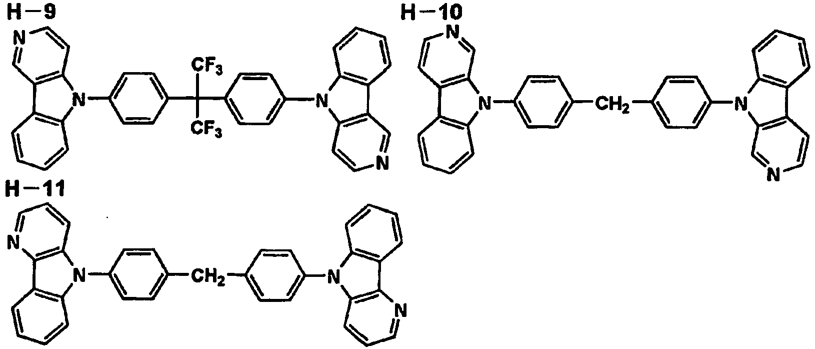 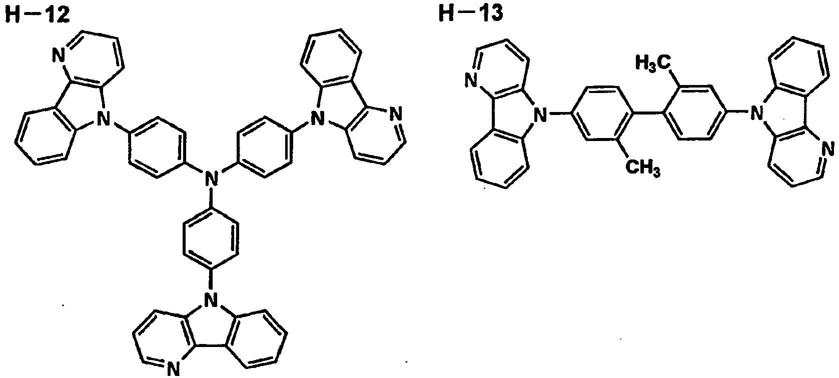 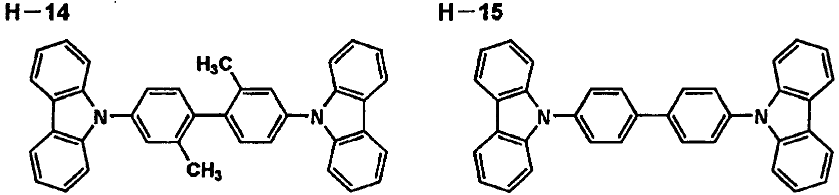 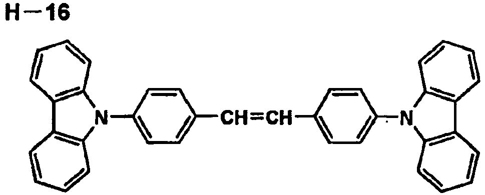 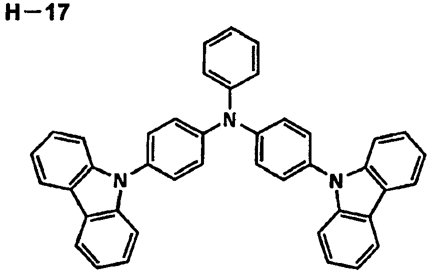 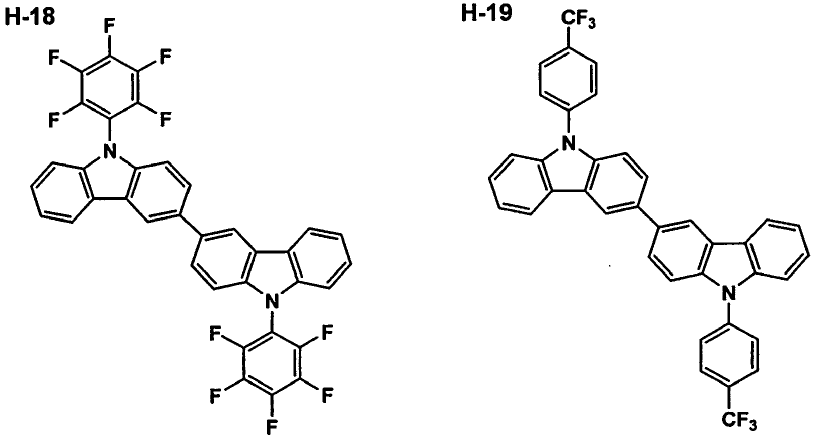 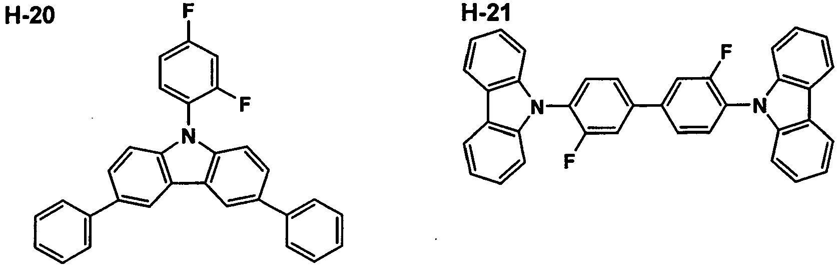 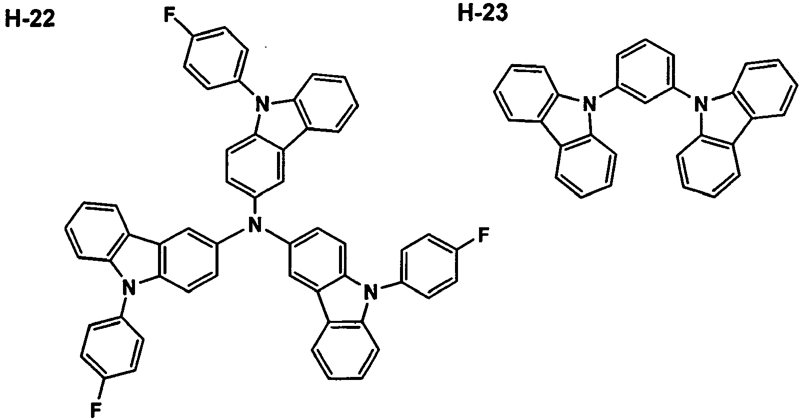 and: 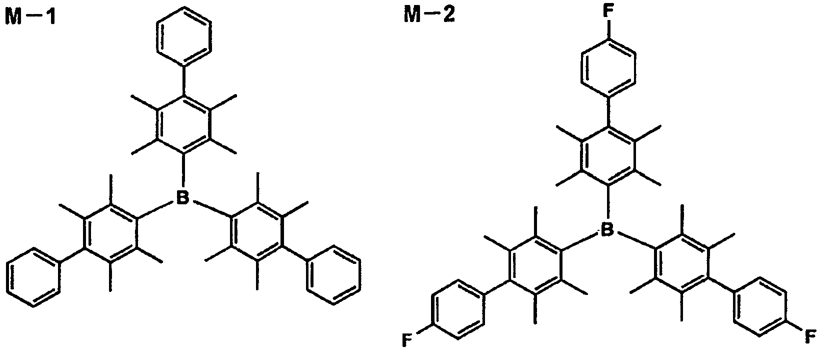 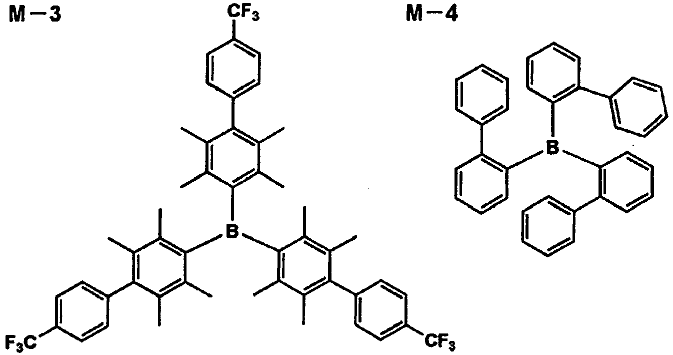 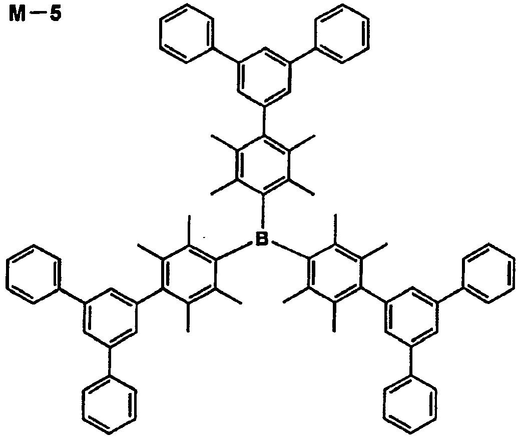 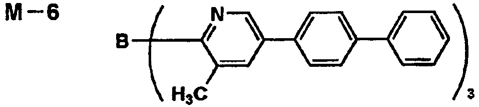 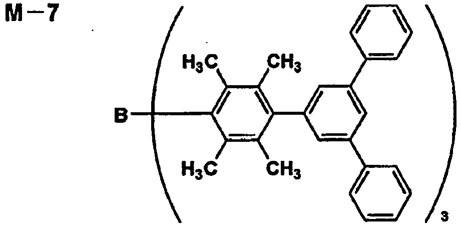 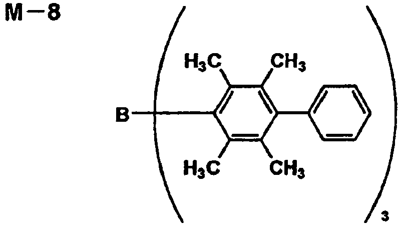 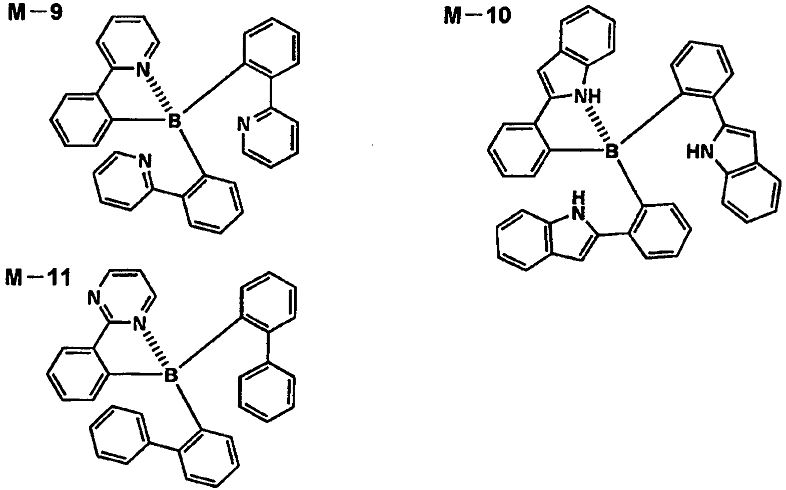 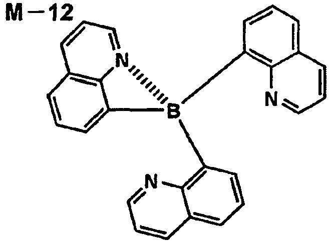 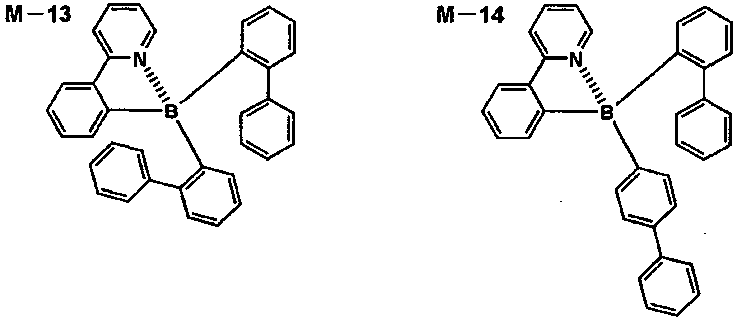 and with the proviso that when the host compound of each of the two or more light emission layers is the same, the compound forming the intermediate layer is different from the host compound.

### BRIEF DESCRIPTION OF THE DRAWINGS

Fig. 1 is a drawing to show a layer structure of an organic EL element.
Fig. 2 is a drawing to show layer structures of light emission layers of an organic EL element of an embodiment of the present invention.
Fig. 3 is a drawing to show layer structures of light emission layers of an organic EL element of an embodiment of the present invention.
Fig. 4 is a drawing to show layer structures of light emission layers of an organic EL element of an embodiment of the present invention.
Fig. 5 is a drawing to show layer structures of light emission layers of an organic EL element of an embodiment of the present invention.
Fig. 6 is a drawing to show layer structures of light emission layers of an organic EL element of an embodiment of the present invention.
Fig. 7 is a drawing to show layer structures of light emission layers of an organic EL element of an embodiment of the present invention.
Fig. 8 is a schematic drawing to show an example of display constituted of an organic EL element.
Fig. 9 is a schematic drawing of a display portion.
Fig. 10 is a schematic drawing of a pixel.
Fig. 11 is a schematic drawing of a passive matrix type full color display.
Fig. 12 is a schematic drawing of an illuminator.

### DESCRIPTION OF PREFERRED EMBODIMENTS

The above object of the present invention is achieved by the organic electroluminescence element hereinbefore defined in the aspect of the invention.

Preferably a thickness of the intermediate layer is larger than a Förster distance between two light emission compounds, each light emission compound being independently contained in one of the light emission layers sandwiching the intermediate layer.

Preferably the organic electroluminescence element further comprises a hole blocking layer between a light emission layer and the cathode, the hole blocking layer being adjacent to the light emission layer.

Preferably the organic electroluminescence element further comprises an electron blocking layer between a light emission layer and the anode, the electron blocking layer being adjacent to the light emission layer.

In the following, the most preferable embodiments to practice the present invention will be explained. However, the present invention is not limited thereto.

According to an embodiment of the present invention, a white-emitting organic EL element, which hardly generates color deviation accompanied by voltage variation and has improved emission efficiency, can be obtained by utilizing a phosphorescent compound in different light emission layers and accumulating said layers alternately, or periodically, or randomly.

In an embodiment of the present invention, both of color balance and efficiency can be obtained by shutting exciton in a light emission layer.

That is, in an embodiment of the present invention, triplet excitons have been successfully shut in a light emission layer effectively by providing a intermediate layer (intermediate layers) between laminated light emission layers and by utilizing a material having excited triplet energy (T1) higher (larger) than that of a phosphorescent compound (phosphorescent dopant) in the intermediate layer (intermediate layers).

Further, by setting a thickness of the intermediate layer to not less than the Förster distance, energy transfer between excitons has been inhibited, whereby color deviation has been decreased and a highly efficient element has been successfully obtained.

### (Layer Structure of Organic EL Element)

A layer structure of an organic EL element according to embodiments of the present invention will be explained referring to the drawings. However the present invention is not limited thereto.

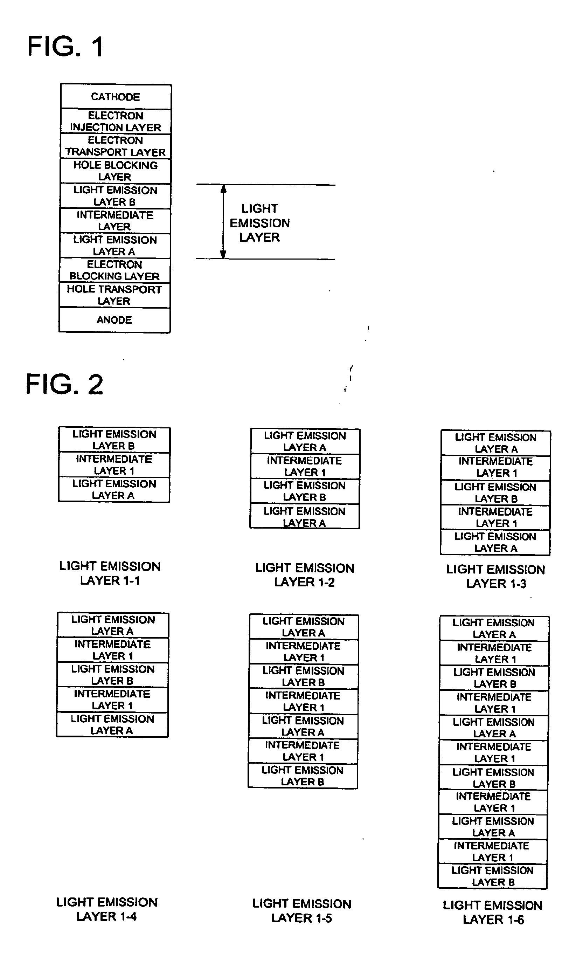

In the element structure shown in fig. 1, an emission layer (having a structure including two kinds of emission layers: emission layer A/intermediate layer/emission layer B) is sandwiched by an electron blocking layer and a hole blocking layer.

These layers are not necessarily required, however, by this arrangement, since carriers of electron·hole are shut in an emission layer and further an exciton, which is generated by recombination of an electron and a hole, can be shut in an emission layer, it is preferable to arrange an electron blocking layer and a hole blocking layer.

As materials to form an electron blocking layer and a hole blocking layer, those well known in the art can be utilized.

Since an electron blocking layer shut in an electron not to escape from an emission layer, a material to form an electron blocking layer has an electron affinity of not larger than that of a material to form an emission layer.

Since a hole blocking layer shut in an hole not to escape from an emission layer, a material to form a hole blocking layer has an ionization potential of not smaller than that of a material to form an emission layer.

Further, to shut in a triplet exciton generated by recombination, a material to form a positive hole blocking layer and an electron blocking layer preferably has an excited triplet energy not smaller than that (T1) of a phosphorescent compound in an emission layer.

Further, it is preferable to arrange a positive hole transport layer and an electron transport layer so as to sandwich the inhibition layers. As a hole transport layer and an electron transport layer, materials well known in the art can be utilized. It is preferable to utilize a material having a high conductivity with respect to decrease of the driving voltage.

A hole transport layer having a high p-property and an electron transfer having a high n-property, which have been subjected to impurity doping, can be utilized.

Examples thereof are described in such as JP-A Nos. 4-297076, 2000-196140 and 2001-102175; and J. Appl. Phys., 95, 5773 (2004).

Further, an emission layer is provided with a structure containing two kinds of emission layers, that is emission layer A/intermediate layer/emission layer B, and by utilizing a material, which has an excited triplet energy higher than that of a phosphorescent compound, for an intermediate layer and a host material, it is possible to effectively shut a triplet exciton of an emission layer in the emission layer, whereby a highly efficient element can be obtained.

Further, by setting the thickness of an intermediate layer not smaller than the Förster distance, inter-layer Förster energy transfer between different emission layers can be inhibited to decrease color deviation, whereby an element having further high efficiency can be obtained.

As such a material constituting an intermediate layer and a host material, materials well known in the art can be utilized.

Preferable are an intermediate layer material and a host material which are provided with excited triplet energy not smaller than that of the phosphorescent compound having the largest excited triplet energy among phosphorescent compounds contained in an emission layer.

For example, in the case of utilizing a phosphorescent compound as each emission material in a white element comprising three colors of blue, green and red, blue phosphorescent compound has the largest excited triplet energy.

Preferable are an intermediate layer material and a host material having excited triplet energy not smaller than that of a blue phosphorescent compound.

Since an intermediate layer material and a host material take a role of carrier transfer, materials having carrier transport ability are preferable. Carrier mobility is utilized as a physical property which represents carrier transport ability, and carrier mobility of an organic material is generally depends on electric field intensity.

A material having high dependence on electric field intensity is liable to break the balance of injection and transport of positive hole and electron.

As an intermediate layer material and a host material, materials having a smaller dependence on electric field intensity are preferable.

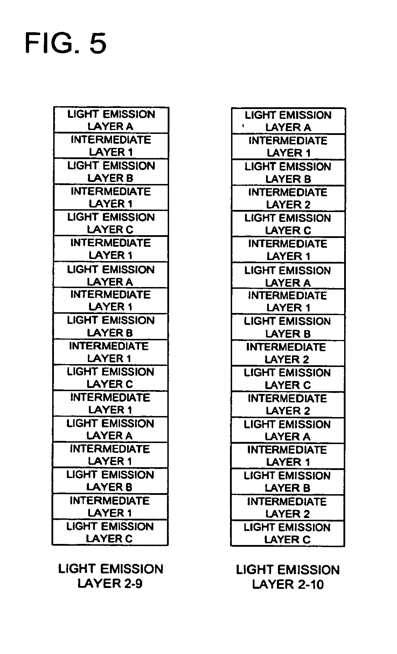

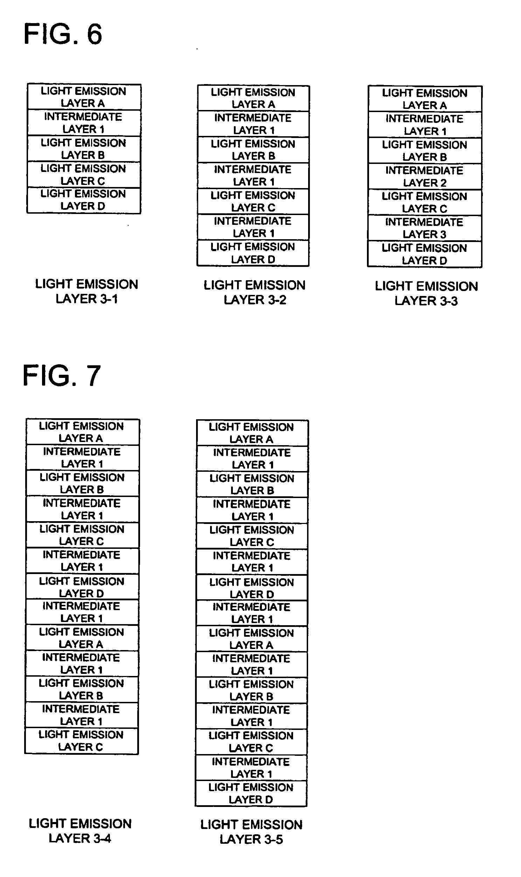

Next a structure of an emission layer, including the aforesaid structure of "emission layer A/intermediate layer/emission layer B" will be shown in figs. 2 - 7, however, the present invention is not limited thereto.

The layer order of emission layers may be either regular or random. Further, an intermediate layer may not be arranged in every place but only at least one layer may be arranged at a necessary place.

In an embodiment of the present invention, at least two kinds of light emission layers are provided. However, 2 - 4 kinds are preferably provided and most preferable is to provide 3 kinds of light emission layers.

Different emission layers means that the maximum emission wavelengths, when emission peak is measured by PL measurement, have a difference of at least 10 nm.

In PL measurement, vacuum evaporation film of an emission dopant and a host compound having the composition utilized in an emission layer is prepared on a quartz substrate. A thin layer, comprising such as polymer prepared by a wet process, can be prepared by means of spin coating or dipping. Next, with respect to thus prepared evaporation film (a thin layer), emission is measured by use of a fluorophotometer to determine the maximum emission wavelength.

As an organic EL element having at least two kinds of emission layers, color at the time of being lit is not specifically limited, however, preferably becomes white.

For example, in the case of emission layers comprising two kinds, it is preferable to obtain white by a combination of emission layers which emit blue and yellow, or blue green and red.

Further, in the case of emission layers comprising three kinds, it is preferable to obtain white by a combination of emission layers which emit blue, green and red.

In this manner, an organic EL element of the present invention can be applied for various light sources such as an illuminator and a backlight.

For example, in the case of emission layers comprising four kinds, white can be obtained by a combination of blue, blue green, yellow and red. In addition, it is also possible to utilize one more layer to make color correction of white comprising blue, green and red.

Further, emission color is not limited to white.

By emitting monochrome (such as blue, green and red) from a plural number of different emission layers, more delicate adjustment of color is possible.

The alignment order of a plural number of emission layers may have a regular period or may be random. The alignment order exhibiting minimum deviation of chromaticity when voltage (current) is applied on an element is preferable.

Those provided with a regular period is preferable.

For example, preferable are emission layers 1-3, 1-5, 1-6, 2-5, 2-6, 2-7, 2-8, 2-9, 2-10 and 3-5 shown in figs. 2 - 7. Herein, each emission layers A, B, C, D, etc. is an emission layer having a different emission wavelength, respectively, and each intermediate layers 1 - 3 is also an intermediate layer constituted of a different intermediate layer material, respectively.

In this manner, it is possible to make emission color barely change when voltage (current) is varied, even in the case of the emission position being shifted in the thickness direction.

Energy transfer between emission dopants to each adjacent emission layer proceeds in a Förster type, however, alignment order of each emission layers can be determined based on a combination having a small Förster distance.

Further, it is possible to change current-voltage characteristics by selecting a host material.

The total thickness of an emission layer is not specifically limited, however, is preferably 5 - 100 nm, more preferably 7 - 50 nm and most preferably 10 - 40 nm.

Each layer thickness in a plural number of constituent emission layers of the emission layer is preferably 1 - 20 nm. These can be selected depending on element driving voltage, chromaticity deviation against voltage (current), energy transfer and difficulty of preparation.

### (Förster Type Energy Transfer)

Dominant energy transfer in an organic EL element is primarily a Förster type, however, energy transfer distance is large in a Förster type.

In Förster type energy transfer, basically, it is an important factor that an overlap integral intensity of emission spectrum of a doner molecule and absorption spectrum of an acceptor molecule is large.

In the case of a fluorescence emission compound, since fluorescence quantum efficiency and a molar extinction coefficient are large when the spectra overlap, the energy transfer distance is increased.

Also in a phosphorescence emission compound, energy transfer occurs similar to a fluorescence emission compound in the case of T←G absorption being observed.

Förster distance refers to a distance at which probability of energy transfer and probability of internal conversion is 1/1, and energy transfer becomes dominant at a distance shorter than this while energy transfer hardly occurs at a longer distance.

With respect to Förster energy transfer and Förster distance, p. 368 of "Principles of Fluorescence Spectroscopy", by Joseph R. Lacowicz, published by Kluwer Academic Plenum Publishers, can be referred to.

Since a phosphorescent compound has a short energy transfer distance of a Förster type and energy transfer barely occurs between each emission layers, multilayer structure comprising thin layers becomes possible to easily achieve a desired color as well as to restrain efficiency decrease.

As a principle in energy transfer, "spin preservation law" is effected. Therefore, energy transfer from a singlet to a singlet or from a triplet to a triplet occurs, however, T←G absorption (direct excitation from a ground state to an excited triplet) seldom occurs in the case of general organic materials. Further, also in a phosphorescent compound, only some T←G absorption is observed and Förster type energy transfer from a triplet to a triplet seldom occurs.

However, the energy transfer is confirmed to occur at a short distance, and, for example, the Förster distance in energy transfer from FIr (pic) (Ir-12) to btpIr (acec) (Ir-9) can be estimated to be 2.3 nm. This is small as an energy transfer distance, however, such as color deviation and efficiency decrease caused thereby are big problems in a white-emitting element. The embodiment of the present invention has made it possible to prepare a white-emitting organic electroluminescence element, which exhibits little color deviation and is highly efficient, by utilizing a phosphorescent compound and further providing an intermediate layer.

The measured Förster distances are shown in Table 1.

**TABLE 1**

| | Förster energy transfer distance (nm) |
|---|---|
| Ir-12 → Ir-9 | 2.3 |
| Ir-12 → Ir-1 | 1.8 |
| Ir-13 → Ir-9 | 2.4 |
| Ir-13 → Ir-1 | 1.9 |
| Ir-1 → Ir-9 | 1.8 |

The measurement followed the method described in "Principles of Fluorescence Spectroscopy", by Joseph R. Lacowicz, published by Kluwer Academic Plenum Publishers.

In other phosphorescent compounds described in examples, the distance was similarly not more than 3 nm. Therefore, it is clear that energy transfer is effectively depressed when an intermediate layer has a thickness of not less than 2.5 - 3 nm, whereby an element which exhibits a high efficiency and little color deviation can be prepared.

It is naturally possible to decrease a layer thickness of an intermediate layer with respect to a combination of phosphorescent compounds having a small energy transfer distance.

To utilize different compounds for all the materials may provide a big load to manufacturing processes and manufacturing apparatuses.

In an embodiment of the present invention, it is possible to simplify a manufacturing apparatus by utilizing an identical material as a host compound and a material to constitute an intermediate layer, and further it is possible to prepare an accumulated structure comprising several layers by only open and close operations of a shutter of a dopant utilized for vacuum evaporation.

### (Emission layer)

In an embodiment of the present invention, since energy transfer between emission dopants to each adjacent emission layers proceeds in a Förster type, the alignment order of each emission layer can be determined depending on combinations having a small Förster distance.

Further, it is possible to change current-voltage characteristics by selecting a host material.

The total thickness of an emission layer is not specifically limited, however, is preferably 5 - 100 nm, more preferably 7 - 50 nm and most preferably 10 - 40 nm.

Each layer thickness of a plural number of emission layers constituting the emission layer is preferably 1 - 20 nm and more preferably 2 - 10 nm.

These can be selected in view of element driving voltage, chromaticity deviation against voltage (current), energy transfer and difficulty of manufacturing.

In an embodiment of the present invention, it is necessary to contain a phosphorescent compound in at least one layer in a constitution of these emission layers, and a phosphorescent compound is preferably contained in every emission layer.

### (Emission Host and Emission Dopant)

The mixing ratio of an emission dopant against a host compound, which is a primary component in an emission layer, is preferably in a range of 0.1 - 30 weight% based on weight.

However, in an embodiment of the present invention, it is necessary to utilize a phosphorescent compound (a phosphorescent dopant) in at least one layer of emission layers. Plural kinds of compounds may be utilized by mixing as an emission dopant, and a metal complex and a phosphorescent dopant having another structure are also preferable.

### EXAMPLE

An example of the synthesis of compound D1 is described below.

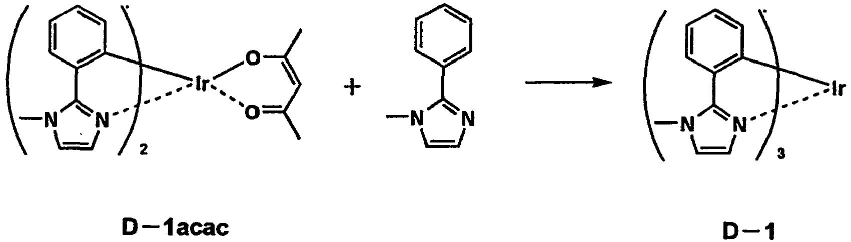

Into a 500 ml three-necked flask, 4.0 g of D-lacac, 2.6 g of phenylimidazole and 300 ml of glycerol were charged and a thermometer, a cooler were attached onto the flask. The flask was set on an oil bath stirrer and the temperature of the bath was controlled so that the content of the flask was gradually heated and held at 150 °C. The content of the flask was stirred for 5 hours for completing the reaction. Crystals were precipitated by cooling the content by room temperature. The reacting liquid was diluted by 200 ml of methanol and the crystals were separated by filtration and sufficiently washed by methanol and dried. Thus 1.6 g (36. 5%) of product was obtained. It was confirmed by ¹H-NMR and MASS that the obtained crystals were D-1.

Next, other constituting layers of the organic EL element will be described.

### <Hole blocking layer>

The hole blocking layer has the function of the electron transport layer in a wide sense and is comprised of a material which has electron transport ability and very low hole transport ability. The probability of recombination of the electron with the hole can be raised by the ability of such the material of blocking the hole while transporting the electron.

The hole blocking layer described in, for example, JP-A Nos. 11-204258 and 11-204359, and "Yuuki EL soshi to sono kougyouka saizennsenn (Organic EL element and its front of industrialization) November 30, 1998 can be applied as the hole blocking layer relating to an embodiment of the present invention. Moreover, the later-mentioned electron transport layer relating to an embodiment of the present invention can be used as the hole blocking layer relating to an embodiment of the present invention according to necessity.

### <Electron blocking layer>

The electron blocking layer comprises a material having a function of hole transportation in a wide sense while having very low ability of electron transportation. The probability of recombination of the electron with the hole can be raised by blocking the electron while transporting the hole. The constitution of the later-mentioned hole transport layer can be used as the electron blocking layer according to necessity.

The thickness the hole blocking layer or the electron blocking layer of an embodiment of the present invention is preferably 3 nm - 100 nm and more preferably 5 nm - 30 nm.

### <Hole transport layer>

The hole transport layer contains a material having the hole transport ability and includes in a wide sense a hole injection layer and the electron blocking layer. The hole transport layer may be provided singly or plurally.

The hole transport material is not specifically limited and can be optionally selected from materials usually used as a charge injection-transport material for holes and known materials used for the hole injection layer or the hole transport layer of an organic EL element.

The material of the hole transport layer is one having ability of hole injection or transportation or ability of the electron barrier and may be an inorganic or organic substance. Examples of such the material include a triazole derivative, an oxadiazole derivative, an imidazole derivative, a polyarylalkane derivative, a pyrazoline derivative, a pyrazolone derivative, a phenylenediamine derivative, an arylamine derivative, an amino-substituted chalcone derivative, an oxazole derivative, a styrylanthracene derivative, a fluorenone derivative, a hydrazone derivative, a stilbene derivative, a silazane derivative, an aniline type copolymer and an electroconductive polymer-oligomer particularly a thiophene oligomer.

The above-mentioned can be used as the material of the hole transport layer, and a porphyline compound, an aromatic tertiary amine compound and a styrylamine compound particularly an aromatic tertiary amine compound are preferably used.

Typical examples of the aromatic tertiary amine compound and the styrylamine compound include N,N,N',N'-tetrapphenyl-4,4'-diaminophenyl; N,N'-diphenyl-N,N'-bis(3-methylphenyl)-[1,1'-biphenyl]-4,4'-diamine (TPD); 2,2-bis(4-di-p-triaminophenyl)propane; 1,1-bis(4-di-p-triaminophenyl)-cyclohexane; bis(4-dimethylamino-2-methylphenyl)-phenylmethane; bis(4-di-p-triaminophenyl)phenylmethane; N,N'-diphenyl-N,N'-di(4-methoxyphenyl)-4,4'-diamonobiphenyl; N,N,N',N'-tetraphenyl-4,4'-diamonodiphenyl ether; 4,4'-bis(diphenylamino)quadriphenyl; N,N,N-tri(p-tolyl)amine; 4-(di-p-tolylamino)-4'-[4-(di-p- tolylamino-4'-[4-(di-p-tolylamino)styryl]stilbene; 4-N,N-diphenylamino-(2-diphenylvinyl)benzene; 3-methoxy-4'-N,N-diphenylaminostilbenzene; N-phenylcarbazole; ones having two condensed aromatic rings in the molecular thereof described in U.S. Patent No. 5,061,569 such as 4.4-bis[N-(1-naphthyl)-N-phenylamino]biphenyl (NPD), and ones in which three triphenylamine units are bonded in star burst state described in JP-A No. 4-308688 such as [N-(3-methylphenyl)-N-phenylamino]triphenylamine (MTDATA).

Polymer materials can be also used, in which the above material is introduced in the main chain thereof or the main chain is formed by the above material.

Inorganic compounds such as p-type Si, p-type SiC are also usable as the hole injection material or the hole transportation material. The hole transportation material preferably has high Tg.

The hole transport layer can be formed by making the above hole transportation material to a thin layer by a known method such as a vacuum vapor deposition method, a spin coat method, a casting method, an ink-jet method and a BL method. The thickness of the hole transport layer is usually approximately from 5 nm to 5,000 nm even though the thickness is not specifically limited. The hole transport layer may be a single layer compring one or two or more kinds of the above material.

A highly p-type hole transport layer doped with an impurity also can be used. Examples of that are described in JP-A Nos. 4-297076, 2000-196140 and 2001-102175, and J. Appl. Phys., 95, 5773 (2004).

### <Electron transport layer>

The electron transport layer comprises a material having electron transport ability and includes the electron injection layer and the hole blocking layer in a wide sense. The electron transport layer may be provided singly or plurally.

Hitherto, the following materials are used as the materials serving both of electron transportation and the hole blocking in the electron transport layer adjacent to the cathode side of the light emission layer when single or plural electron transport layers are provided.

The electron transport layer has a function of transporting the electron injected from the cathode to the light emission layer and the material thereof may be optionally selected from known compounds.

Examples of the material to be used in the electron transport layer, hereinafter referred to as electron transportation material, include a heterocyclic tetracarboxylic acid anhydride such as a nitro-substituted fluorene derivative, a diphenylquinone derivative, a thiopyrane dioxide derivative and naphthaleneperylene, carbodiimide, a fluorenylidenemethane derivative, a derivative of anthraquinonedimethane or anthrone and an oxadiazole derivative. Moreover, a thiadiazole derivative formed by substituting the oxygen atom in the above oxadiazole derivative and a quinoquizaline derivative having a quinoquizaline ring known as an electron withdrawing group are usable as the electron transportation material.

A polymer material in which the above material is introduced in the main chain thereof or forms the main chain thereof is constituted by the above material is also usable.

A metal complex of 8-quinolinol such as tris(8-quinolinol)aluminum (Alq₃), tris(5,7-dichloro-8-quinolinol)aluminum, tris(5,7-dibromo-8-quinolinol)-aluminum, tris(2-methyl-8-quinolinol)aluminum, tris(5-methyl-8-quinolinol)aluminum, bis(8-quinolinol)zinc (Znq) and complexes of the above in which the center metal is replaced by In, Mg, Cu, Cs, Sn, Ca or Pb are usable as the electron transportation. Moreover, a metal free or metal-containing phthalocyanine and ones formed by substituting the terminal thereof by a substituent such as an alkyl group or a sulfonic acid group can be preferably used as the electron transportation material. The styrylpirazine derivatives exemplified as the material for the light emission layer are usable and inorganic semiconductors such as n-type Si and n-type SiC are also usable as the electron transportation material.

The electron transport layer can be formed by making the above electron transportation material into a thin layer by a known method such as vacuum vapor deposit method, a spin coating method, a casting method and a LB method. The thickness of the electron transport layer is usually about 5 to 5,000 nm tough the thickness is not specifically limited. The electron transport layer may be a single layer comprising one or two or more kinds of the above-mentioned materials.

A highly n-type hole transport layer doped with an impurity also can be used. Examples of that are described in JP-A Nos. 4-297076, 2000-196140, 2001-102175, and J. Appl. Phys., 95, 5773 (2004).

The injection layer to be used as a constitution layer of the organic EL element of an embodiment of the present invention is described below.

### <Injection layer>: Electron injection layer, Hole injection layer

The injection layer is classified into the electron injection layer and the hole injection layer, which are provided according to necessity. The injection layer may be provided between the anode and the light emission layer or hole transport layer, or between the cathode and the light emission layer or electron transport layer.

The injection layer is a layer provided between the electrode and the organic layer for lowering the driving voltage or raising the luminance of emitted light. The injection layer is described in detail in "Yuuki EL soshi to sono kougyouka saizennsenn (Organic EL element and its Front of Industrialization) Vol. 2, Sect. 2, "Electrode materials" pp. 123 to 166, November 30, 1998, published by NTS Co., Ltd., and includes a hole injection layer (an anode buffer layer) and an electron injection layer (a cathode buffer layer).

The anode buffer layer (hole injection layer) is described in detail in JP-A Nos. 9-45479, 9-260062 and 8-288069, and concrete examples thereof include a phthalocyanine buffer layer typically copper phthalocyanine, an oxide buffer layer typically vanadium oxide, an amorphous carbon buffer layer and a polymer buffer layer using polyaniline (emeraldine) or polythiophene.

The cathode buffer layer (electron injection layer) is also described in detail in JP-A Nos. 6-325871, 9-17574 and 10-74586, and examples thereof include a metal buffer layer typically strontium and aluminum, an alkali metal compound buffer layer typically lithium fluoride, an alkali-earth metal compound buffer layer typically magnesium fluoride and an oxide buffer layer typically aluminum oxide.

The buffer layer (injection layer) is desirably an extremely thin layer and the thickness thereof is preferably 0.1 nm - 100 nm, although the thickness depends of the material.

The injection layer can be formed by making the above material into a thin film by using a known method such as a vacuum evaporation method, a spin coating method, a casting method, an inkjet method or an LB method. The thickness of the injection layer is not specifically limited, however, usually it is 5 to 5,000 nm in accordance with the kind of the material. The injection layer may have a single layer structure comprising one or two or more kinds of the material.

### <Anode>

The anode relating to the organic EL element of an embodiment of the present invention is preferably one comprising a metal, an alloy, an electroconductive compound or a mixture thereof each having high work function (not less than 4 eV) is preferable. Examples of such the electrode material include a metal such as Au and an electroconductive transparent material such as CuI, indium tin oxide (ITO), SnO₂, and ZnO. An amorphous material capable of forming a transparent electrode layer such as IDIXO (In₂O₃-Zn) is usable. The anode may be formed by making a thin layer of such the electrode material by a method such as a vapor deposition or a spattering method and pattering to the desired form by a photolithographic method. The vapor deposition or spattering of the electrode material may be performed through a mask of desired pattern to form the pattern of the electrode when the high precision is not necessary (around 100 µm or more). When the light is putout through the anode, the transparency of the anode is preferably not less than 10% and the sheet resistivity is preferably not more than several hundred Ω/□. The layer thickness is usually from 10 nm to 1,000 nm and preferably from 10 nm to 200 nm.

### <Cathode>

On the other hand, as the cathode relating to an embodiment of the present invention, one comprising a metal (referred to as an electron injective metal), an ally, an electroconductive compound each having low working function (not more than 4 eV) or a mixture thereof is used. Concrete examples of such the electrode material include sodium, sodium-potassium alloy, magnesium, lithium, a magnesium/copper mixture, a magnesium/silver mixture, a magnesium/aluminum mixture, a magnesium/indium mixture, an aluminum/aluminum oxide (Al₂O₃) mixture, indium, a lithium/aluminum mixture, and a rare-earth metal. Among them, a mixture of an electron injective metal and a second metal larger in the working function and stability than the electron injective metal such as the magnesium/silver mixture, magnesium/indium mixture, aluminum/aluminum oxide (Al₂O₃) mixture, lithium/aluminum mixture and aluminum are suitable from the viewpoint of the electron injecting ability and the stability against oxidation. The cathode can be formed by making such the electrode material into a thin layer by a method such as a vapor deposition method or a spattering method. The sheet resistivity of the cathode is preferably not more than several hundred Ω/m and the thickness thereof is usually selected within the range of from 10 nm to 1,000 nm and preferably from 50 nm to 200 nm. It is suitable that at least one of the anode and cathode is transparent or semitransparent for raising the luminance of the emitted light.

### <Substrate (also referred to as base plate, base material or support)>

There is no limitation on the kind of substrate such as glass and plastics relating to the organic EL element of the present invention as long as that is transparent, and glass, quartz and light permeable resin film can be cited as the preferably usable material. Particularly preferable substrate is the resin film which can give flexibility to the organic EL element.

As the resin film, for example, a film comprising polyethylene terephthalate (PET), polyethylene naphthalate PEN), polyether sulfone (PES), polyetherimide, poly(ether ether ketone), poly(phenylene sulfide), polyallylate, polyimide, polycarbonate (PC), cellulose triacetate (TAC) or cellulose acetate propionate (CAP) can be cited.

A layer of inorganic substance or an organic substance or a hybrid layer of them may be formed on the surface of the resin film, and the film is preferably one having high barrier ability of a steam permeability of not more than 0.01 g/m²·day·atm.

The output efficiency at room temperature of emitted light of the organic EL is preferably not less than 1% and more preferably not less than 2%, wherein the output efficiency is expressed by the following expression: External Quantum Efficiency (%) = Number of photon emitted from organic EL element to exterior/Number of electron applied to organic EL element x 100.

A film having roughened surface such as an anti-glare film also can be used for reducing the unevenness of light emission when the element is used as an illuminator.

When the element is used for a multi-color display, the apparatus has at least two kinds of organic EL elements having different emission peak wavelengths from each other. A suitable example of production of the organic EL is described below.

### <Production method of organic EL element>

As an example of production method of the organic EL element of an embodiment of the present invention having the constitution of Anode/Hole injection layer/Hole transport layer/Light emission layer (3 or more layers)/Hole blocking layer/Electron transport layer/Cathode buffer layer/Cathode is described below.

On a suitable substrate, a thin layer of a desired electrode material such as the anode material is formed by a method such as vapor deposition or spattering so that the layer thickness is preferably within the range of from 10 nm to 200 nm to form an anode. On the anode, thin layers containing organic compounds such as the hole injection layer, the hole transport layer, the light emission layer (3 or more layers), the hole blocking layer are formed.

As the method for forming the thin layer containing the organic compound, the spin coating method, casting method, inkjet method, vacuum evaporation method and printing method are applicable, and the vacuum vapor deposition method and spin coating method are particularly preferable from the viewpoint that uniform layer can be easily formed and pinhole tends not to form. Further, different layer forming methods may be applied for each of the layers. When the thin layers are formed by the vacuum evaporation method, it is desirable that the deposition conditions are suitably selected from the range of boat heating temperature of from 50 °C to 450 °C, vacuum degree of from 10⁻⁶ Pa to 10⁻² Pa, a deposition rate of from 0.01 nm to 50 nm/second, a substrate temperature of from -50 °C to 300 °C and a layer thickness of from 0.1 nm to 5 µm.

After formation of these layers, the cathode is provided on the layer by a method such as the vacuum evaporation and spattering so that the thickness becomes not more than 1 µm and preferably from 50 nm to 200 nm to obtain the desired organic EL element. It is preferably that the formation of the hole injection layer to the cathodes is consistently performed by once evacuation but it is allowed that the element is take out on half way for subjecting to a different layer formation procedure. In such the case, it is necessary to consider that the operation is carried out under an inert gas atmosphere.

### <Display>

The display is described below.

A display incorporating an embodiment of the present invention may be mono-color or multi-color display. The multi-color display is described here. In the case of the multi-color display, a shadow mask is only applied at the formation of light emission layer and the other layers can be uniformly formed by the vapor deposition method, casting method, spin coating method, inkjet method or printing method.

When the light emission layer is only patterned, the patterning by the vacuum evaporation method, ink-jet method or printing method is preferable, though the method is not specifically limited. When the vacuum evaporation method is used, pattering using a shadow-mask is preferably employed.

The order of layer formation may be reversed so that the order becomes the cathode, electron transport layer, hole blocking layer, light emission layer (3 or more layers), hole transport layer and anode.

When a multi-color display is applied with a direct current voltage, light emission can be observed when a DC voltage of from about 2 to 40 V is applied to the element so that the polarity of the anode is positive and that of the cathode is negative. If the polarity is reversed, the electric current is not caused and light is not emitted at all. When AC voltage is applied, light is emitted only at the time when the anode is positive and cathode is negative. The wave shape of the AC voltage to be applied may be optional.

The multi-color display can be applied for a display device, a display and various lighting sources. In the display device and display, full color image can be displayed by the use of three kinds of organic EL elements emitting blue, green and red light.

Examples of the display device and display include a television, a personal computer, a mobile apparatus, an AV apparatus, a display for letter broadcasting and a car display. The apparatus may be used for reproducing a still image and a moving image. When the apparatus is used for displaying the moving image, either of a simple matrix (passive matrix) system and an active matrix system may be applied.

As the lighting source, the element can be applied for domestic lighting, car lighting, backlight for a watch or liquid crystal display, light for a sign board, a signal light, light source for a light memory medium, light source of an electrophotographic copy machine, light source of a light communication apparatus and light source for a photosensor but the use is not limited thereto.

### <Illuminator>

An illuminator incorporating an embodiment of the present invention is described below.

The organic EL element of an embodiment of the present invention may be used as an organic EL element having a resonator structure therein. Such the organic EL element having resonator structure can be used as, for example, a light source of light memory medium, a light source of electrophotographic copier, a light source of light communication apparatus and a light source for light sensor but the use of that is not limited to the above-mentioned.

The organic EL element of an embodiment of the present invention may be used as a kind of lamp such as the lighting light source and the exposing light source and as a projection apparatus for projecting an image or a display for directly watching a still or a moving image. The driving system for displaying the moving image may be either a simple matrix (passive matrix) system or an active matrix system. A full color display can be produced by using two or more kinds of the organic EL element of an embodiment of the present invention each different from each other in the color of emitting light.

An example of the display having the organic EL element of an embodiment of the present invention is described below referring drawings.

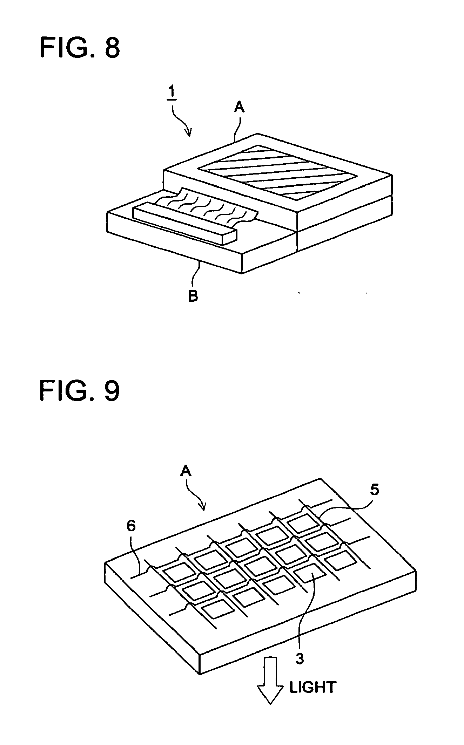

Fig. 8 shows a schematic drawing of an example of display constituted by the organic EL element. The schematic drawing shows an apparatus for displaying image information by emitted light by the organic EL element such as a display of a portable telephone.

Display 1 comprises a display A having plural pixels and a controlling device B for scanning the display 1 according to image information.

The controlling device B electrically connected with the display A sends scanning signals and image data to each of the plural pixels according to image information sent from outside. The pixels of each of the scanning line successively emit light by the scanning signals each corresponding to image date signals to display the image information on the display A.

Fig. 9 shows schematic drawing of the display A.

The display A has wiring including plural lines for scanning 5 and that for data 6 and plural pixels 3 on a substrate. Principal parts of the display A are described below.

In the drawing, light emitted from the pixel 3 is taken out in the direction of the white arrow (downward).

The scanning lines 5 and the data lines 6 are each composed of an electroconductive material and the scanning line and the date line are crossed in lattice form at a right angle as a lattice and connected to the pixel 3 at the crossing point (detail of that is not shown in the drawing).

The pixel 3 receives image data from the date line 6 when the scanning signal is applied from the scanning line 5 and emits light corresponding to the image data. Full color image can be displayed by arranging pixels emitting red range light, green range light and blue range light on the same substrate.

When white light emitting organic EL elements are used, full color display can be performed by using B, G and R color filters.

The light emitting process of the pixel is described below.

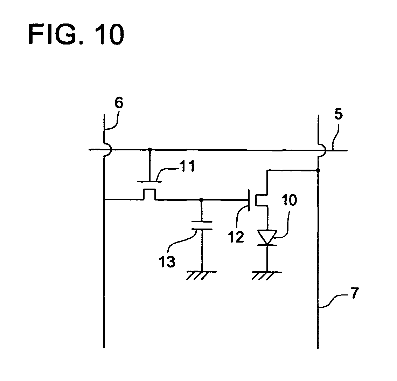

Fig. 10 shows a schematic drawing of the pixel.

The pixel has the organic EL element 10, a switching transistor 11 and a driving transistor 12 and a condenser 13. Full color display can be realized by using the white light emitting organic EL element divided into plural pixels combined with B, G and R color filters.

In Fig. 10, the switching transistor is turned ON when the date signals are applied to the drain of the switching transistor from the controlling device B through the data line 6 and the scanning signals are applied to the gate of the switching transistor 11 from the controlling device B through the scanning line 5 so that the date signal applied to the drain is transferred to the condenser 13 and the gate of the driving transistor 12.

The condenser 13 is charged according to the potential of the image data and the driving of the driving transistor 12 is turned ON by the transfer of the image data signal. The drain of the driving transistor is connected to the power source line 7 and the source of that is connected to the electrode of the organic EL element 10. Electric current is supplied from the power source line 7 to the organic EL element 10 corresponding to the potential of the image data signal applied to the gate.

The driving of the switching transistor 11 is turned OFF when the scanning signal is moved to the next scanning line 5 by the successive scanning by the controlling device B. However, the light emission by the organic EL element 10 is continued until next scanning signal is applied since the driving of the driving condenser is kept at ON state even when the switching transistor is turned OFF because the condenser 13 holds the charged potential. When the next scanning signal is applied by the successive scanning, the driving transistor 12 is driven corresponding to the potential of the image data signals synchronized with the scanning signals and the organic EL element 10.

The organic EL element 10 of each of the plural pixels 3 emits light by providing the switching transistor 11 as an active element and the driving transistor 12 to the organic EL element 10 of each of the plural pixels. Such the light emission system is called as the active matrix system.

The light emission of the organic EL element 10 may be light emission with gradation corresponding to multi-value data signal having plural gradation potentials or on-off of the designated light amount according to the bi-value image data signal.

The potential of the condenser 13 may be held until application of the next scanning signal or discharged just before the application of the next scanning signal.

In an embodiment of the present invention, the light emission may be preformed according to the passive matrix system, not limited to the active matrix system, in which the light is emitted according to the data signal only when the scanning signal is supplied.

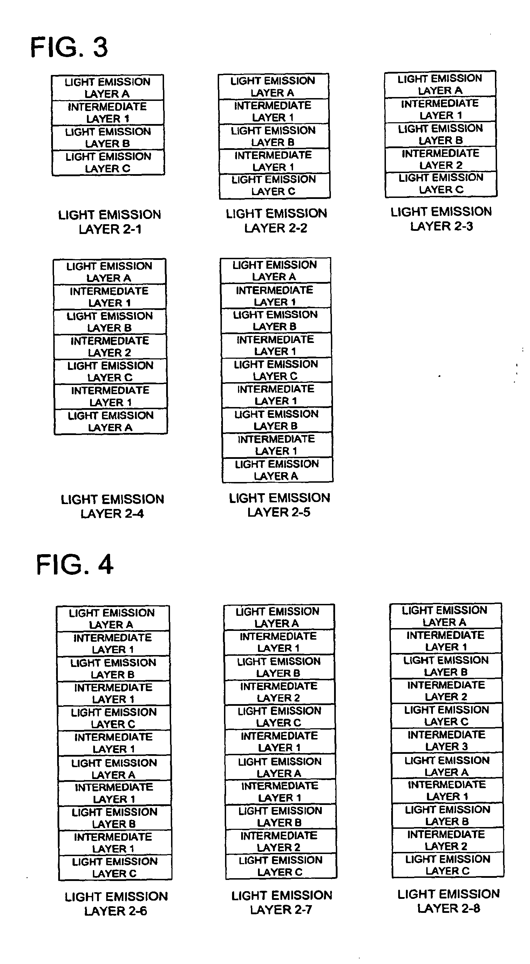

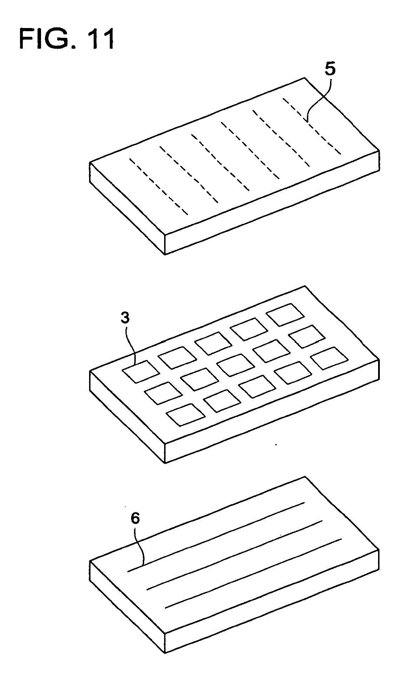

Fig. 11 shows a schematic drawing of a display by the passive matrix system. In Fig. 4, plural scanning lines 5 and the plural image data lines 6 are separately provided on both sides of the pixel 3 so as to face to each other for forming lattice state.

When the scanning signal is applied to the scanning line 5 by successive scanning, the pixel 4 connected to the scanning line to which the signal is applied emits light corresponding to the image data signal. In the passive matrix system, any active element is not necessary and the production cost can be reduced.

The materials of the organic EL element relating to an embodiment of the present invention can be applied for an organic EL element emitting substantial white light as an illuminator.

In the white light emitting organic electroluminescence element relating to the present invention, patterning may be carried out according to necessity by a metal mask or an ink-jet printing method. The patterning treatment may be given only to the electrode, to the electrode and the light emitting layer or to the entire layers of the element.

As above-described, the white light emitting organic EL element of an embodiment of the present invention can be usefully applied for domestic lighting and car room lighting as various kinds of light source and illuminators, and for a light source for exposing as a kind of lamp, and for displayes such as the backlight of the liquid crystal display additionally to the displaying device and the display.

Additionally to the above, various use can be cited such as a backlight of watch, an advertising signboard, a signal, a light source for light memory media, a light source for electrophotographic copier, a light source for light communication apparatuses, a light source for light sensors and a household electric apparatus having displaying means.

### EXAMPLES

Embodiments of the present invention will now be described below referring to examples but the present invention is not limited thereto.

### EXAMPLE 1

### «Preparation of Organic EL Elements 1-1 to 1-12»

### <Preparation of Organic EL Element 1-1 >

A layer of ITO (indium tin oxide) having a thickness of 100 nm formed on a glass substrate plate of 100 mm x 100 mm x 1.1 mm (NA45 manufactured by NH Technoglass Co., Ltd.), was subjected to a patterning treatment to prepare an anode. The transparent substrate plate carrying the ITO transparent electrode was washed by ultrasonic wave using isopropyl alcohol, dried by dried nitrogen gas and cleaned by UV-ozone cleaning for 5 minutes. The resultant transparent substrate was fixed on a substrate holder of a vacuum vapor deposition apparatus available on the market.

Then the pressure in the vacuum chamber was reduced to 4 x 10⁻⁴ Pa and the tantalum resistance heating crucible containing α-NPD was heated by applying electric current for depositing α-NPD on the transparent substrate at a depositing rate of 0.1 nm/sec to form a hole transport layer of 25 nm.

Next, the tantalum resistance heating crucible containing HTM1 was heated by applying electric current for depositing HTM1 having a thickness of 15 nm on the transparent substrate at a depositing rate of 0.1 nm/sec.

After that, using light emission layers A and B and intermediate layer 1 each having the composition shown in Table 2, a light emission layer having light emission layer constitution 1-1 shown in Fig.2 was found.

Each of the above light emission layer was formed by charging the host compound and dopants having the mixing ratio shown in Table 2 in a resistance heating crucible, and heating the crucible by passing electric current through the crucible to vacuum deposit the layer having the thickness shown in the table at a depositing rate of 0.1 nm/sec.

In the same manner as above, the intermediate layer having the thickness shown in the table was formed by charging the compound for the intermediate layer in a boat followed by heating.

Subsequently, on it, a layer of H-13 having a thickness of 10 nm was vacuum deposited to form a hole blocking layer.

Further, an electron transport layer of 30 nm was deposited on the hole blocking layer at a rate of 0.1 nm/second by passing through electric current to the crucible containing Alq₃.

After that, 0.5 nm of lithium fluoride layer was deposited as a cathode buffer layer (an electron injection layer) and then 110 nm of aluminum layer as the cathode was deposited to prepare Organic EL Element 1-1.

### <Preparation of Organic EL Elements 1-2 to 1-12>

In the same manner as Organic EL Element 1-1, Organic EL Elements 1-2 to 1-12 were prepared by vacuum depositing and laminating each light emission layer shown in Table 2 to have the constitution of the light emission layer shown in Figs. 2 - 4 and the thickness.

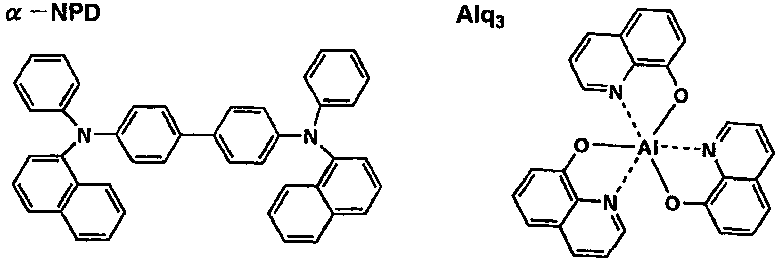

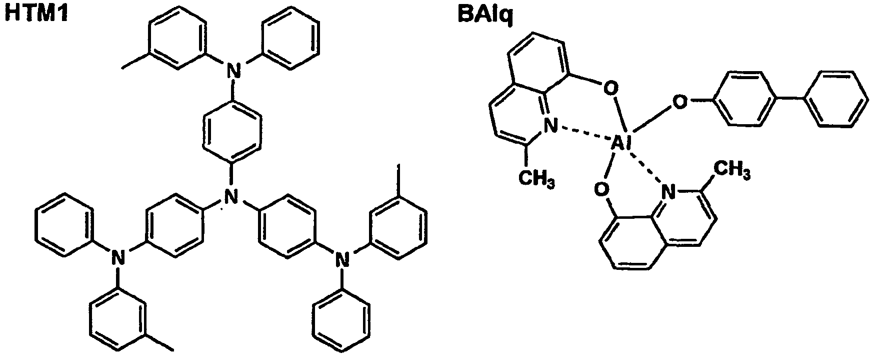

**Table 2**

| | * constitution | * A | * B | * C | * D | Intermediate layer 1 | Intermediate layer 2 | Remarks |
|---|---|---|---|---|---|---|---|---|
| 1-1 | * 1-1 | H-14:Ir-12 | H-14:Ir-9 | None | None | M-1 3nm | None | Inv. |
| | | 3 ** 15nm | 8 ** 8nm | | | | | |
| 1-2 | * 1-1 | H-14:Ir-12 | H-6 :Ir-9 | None | None | M-1 3nm | None | Inv. |
| | | 3 ** 15nm | 8 ** 8nm | | | | | |
| 1-3 | * 1-5 | H-14:Ir-12 | H-14:Ir-9 | None | None | H-13 3nm | None | Inv. |
| | | 3 ** 6nm | 8 ** 3nm | | | | | |
| 1-4 | * 2-1 | H-14:Ir-13 | H-14:Ir-1 | H-14:Ir-9 | None | M-1 3nm | None | Inv. |
| | | 3 ** 8nm | 6 ** 4nm | 8 ** 6nm | | | | |
| 1-5 | * 2-3 | H-14:Ir-13 | H-14:Ir-1 | H-14:Ir-9 | None | M-1 3nm | H-14 3nm | Inv. |
| | | 3 ** 8nm | 6 ** 4nm | 8 ** 6nm | | | | |
| 1-6 | * 2-6 | H-14:Ir-13 | H-14:Ir-1 | H-14:Ir-9 | None | M-1 3nm | None | Inv. |
| | | 3 ** 5nm | 6 ** 2nm | 8 ** 3nm | | | | |
| 1-7 | * 3-2 | H-14:Ir-13 | H-14:Ir-1 | H-14:Ir-9 | H-14:Ir-5 | M-2 3nm | None | Inv. |
| | | 3 ** 5nm | 6 ** 2nm | 8 ** 3nm | 8 ** 2nm | | | |
| 1-8 | * 1-1 | H-15:Ir-12 | H-15:Ir-9 | None | None | BAlq 3nm | None | Comp. |
| | | 3 ** 15nm | 8 ** 8nm | | | | | |
| 1-9 | * 1-1 | H-14:Ir-12 | H-14:Ir-9 | None | None | BAlq 3nm | None | Comp. |
| | | 3 ** 15nm | 8 ** 8nm | | | | | |
| 1-10 | * 2-6 | H-14:Ir-13 | H-14:Ir-1 | H-14:Ir-9 8 ** 3nm | None | BAlq 3nm | None | Comp. |
| | | 3 ** 5nm | 6 ** 2nm | | | | | |
| 1-11 | * 1-1 | Ir-14:H-23 | H-23:D-49 | None | None | None | M-1 | Inv. |
| | | 11 ** 5nm | 9 ** 15nm | | | | | |
| 1-12 | * 1-1 | Ir-14:H-23 | H-23:D-49 | None | None | None | H-23 | Inv. |
| | | 11 ** 5nm | 9 ** 15nm | | | | | |

| | | | | | | | | |
|---|---|---|---|---|---|---|---|---|
| *: Light emission layer, **: weight-%, Inv.: Inventive, Comp.: Comparative | | | | | | | | |

Here, in each light emission layer, for example, H-14:Ir-12 3% 15 nm means that the deposited layer contains 3 % by weight of dopant Ir-12 based on the weight of host compound H-14 and that 15 nm represents the thickness. «Evaluation»

### <External quantum efficiency>

The external quantum efficiency (%) of each of the organic El elements 1-1 to 1-12 was measured by constantly applying an electric current of 2.5 mA/cm² to the element at 23 °C under an atmosphere of dried nitrogen gas. A spectral irradiance meter CS-1000 (manufactured by Minolta Co., Ltd.) was used for measurement.

### <Evaluation of chromaticity deviation>

The deviation of chromaticity is expressed by the difference between the chromaticity at a luminance of 100 cd/m² and that at 5,000 cd/m² in CIE chromaticity diagrams.

The measurement was carried out at 23 °C using CS-1000 manufactured by Minolta Co., Ltd., under dried nitrogen gas atmosphere.

The Förster distances between the employed phosphorescent compounds were given in above Table 1.

Thus obtained results are shown in Table 3.

**Table 3**

| Element No. | External quantum efficiency | Chromaticity deviation | Remarks |
|---|---|---|---|
| 1-1 | 160 | 0.01 | Inventive |
| 1-2 | 165 | 0.01 | Inventive |
| 1-3 | 155 | 0.004 | Inventive |
| 1-4 | 140 | 0.014 | Inventive |
| 1-5 | 165 | 0.01 | Inventive |
| 1-6 | 160 | 0.006 | Inventive |
| 1-7 | 155 | 0.009 | Inventive |
| 1-8 | 100 | 0.03 | Comparative |
| 1-9 | 115 | 0.04 | Comparative |
| 1-10 | 80 | 0.02 | Comparative |
| 1-11 | 170 | 0.009 | Inventive |
| 1-12 | 168 | 0.008 | Inventive |

It is observed that the organic EL elements of embodiments of the present invention show high external quantum efficiencies small chromaticity deviations.

### EXAMPLE 2

Organic EL Elements 2-1 to 2-12 were prepared in the same manner as Organic EL Elements 1-1 to 1-12, except that α-NPD was replaced with a co-deposition layer of HTM1:TCNQ (3 % by weight) Alq₃ was replaced with a co-deposition layer of Bphen:Cs=1:1, and LiF was not deposited.

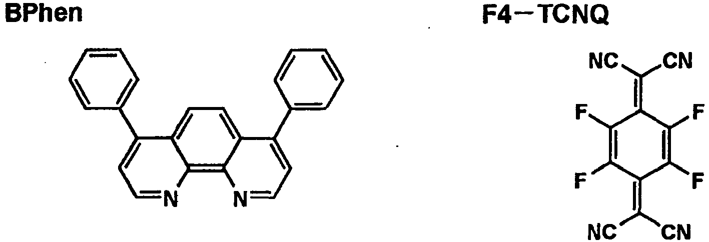

It was confirmed that the driving voltage of each of Organic EL elements 2-1 to 2-12 was lower by 3 - 6 V compared to those of Organic EL Elements 1-1 to 1-12.

These results show that it is possible to obtain an element having a high energy efficiency (lm/W).

### Example 3

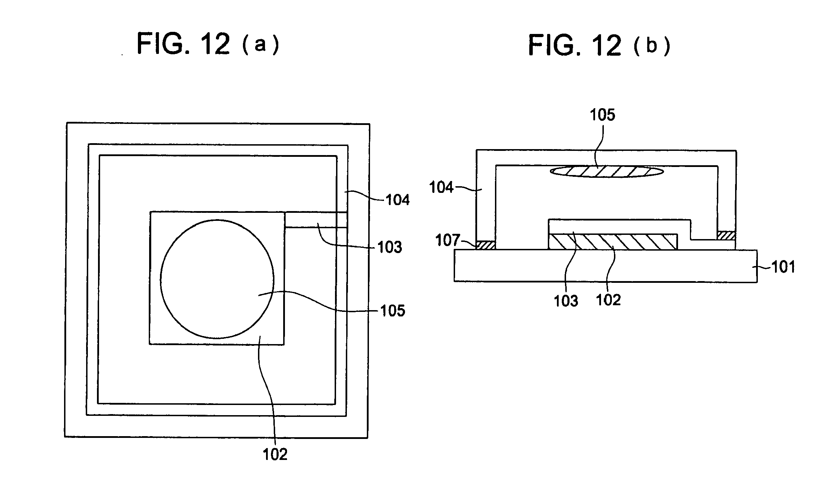

The non-light emission surface of Organic EL element 1-6 was covered with a glass case to prepare an illuminator. The illuminator could be used as a thin shaped illuminator capable of emitting white light which had high light emission efficiency and long lifetime. Fig. 12 is a schematic drawing of the illuminator, and (a) is a schematic plan view and (b) is a schematic cross section of the illuminator. The organic EL layer 102 provided on the glass substrate with the transparent electrode 101 was covered with a glass cover 104; a UV curable adhesive 107 was used for adhering the glass cover. The number 103 indicates the cathode. The interior of the glass cover 104 was filled with nitrogen gas and a dessicant 105 was provided.

### [Possibility for Industrial Use]

According to an embodiment of the present invention, a white light emitting or multi-color organic electroluminescence element exhibiting a small color shift when voltage·current is alightly changed, and a high emission efficiency can be obtained.

## Claims

1. An organic electroluminescence element comprising
an anode and a cathode having therebetween two or more light emission layers exhibiting different emission peaks and an intermediate layer provided between the light emission layers, wherein
the light emission layers comprise a phosphorescent compound as a light emission compound selected from: 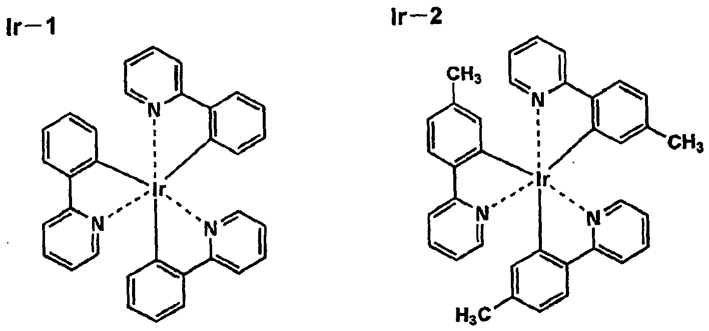 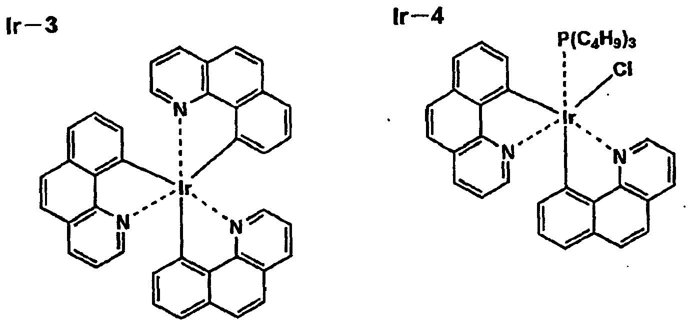 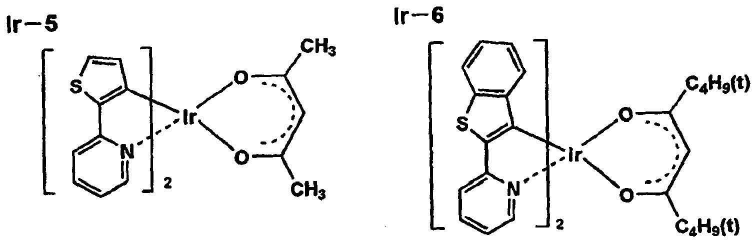 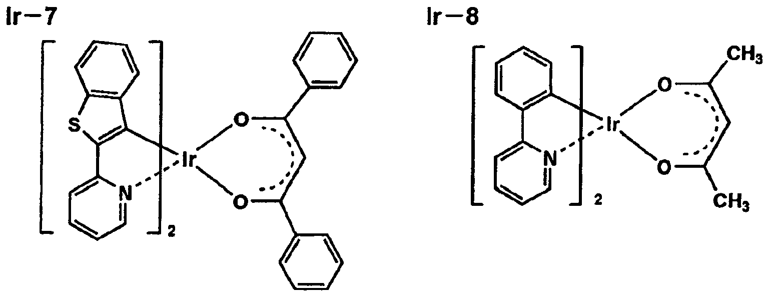 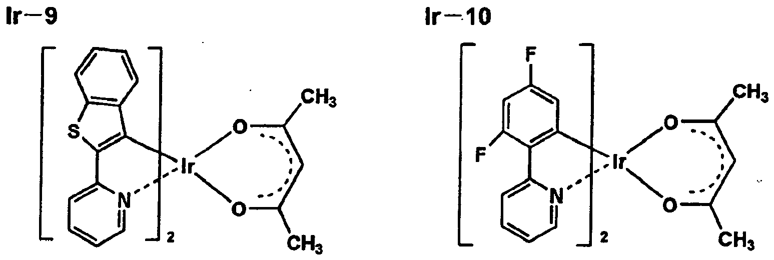 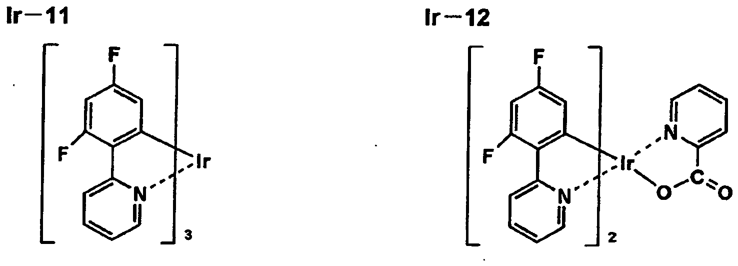 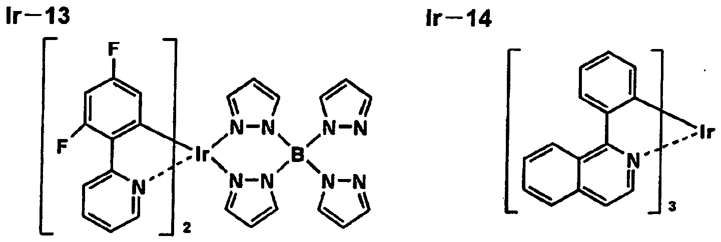 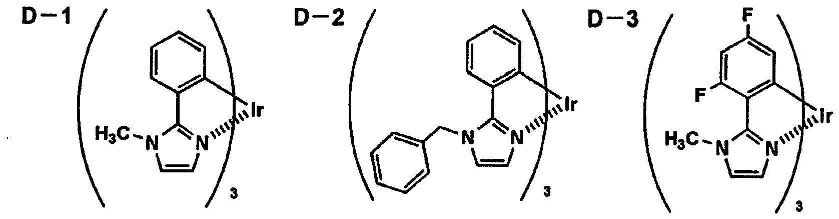 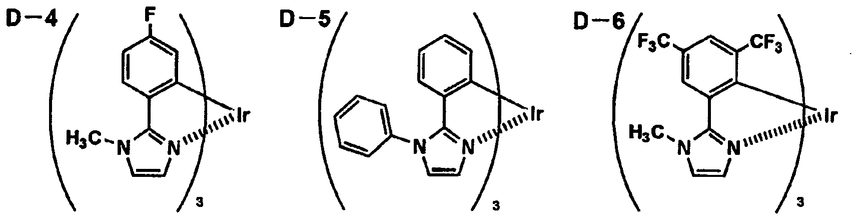 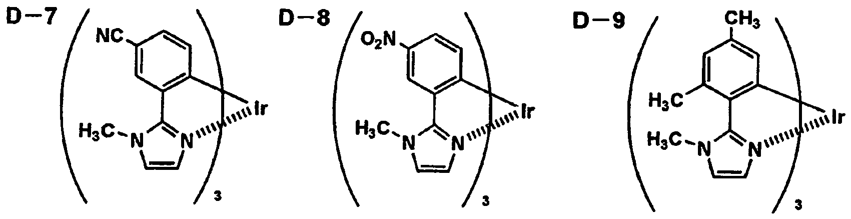 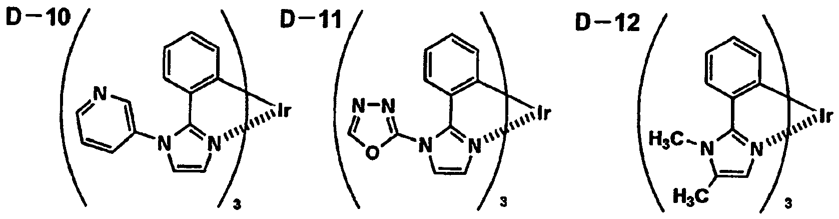 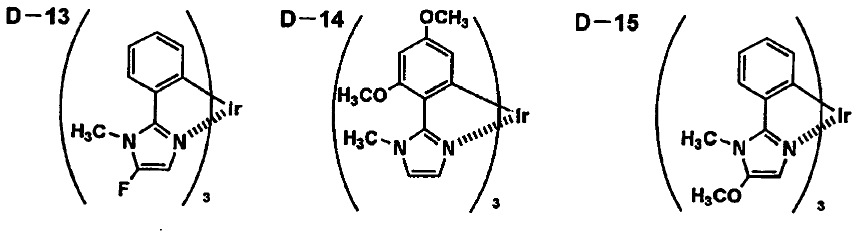 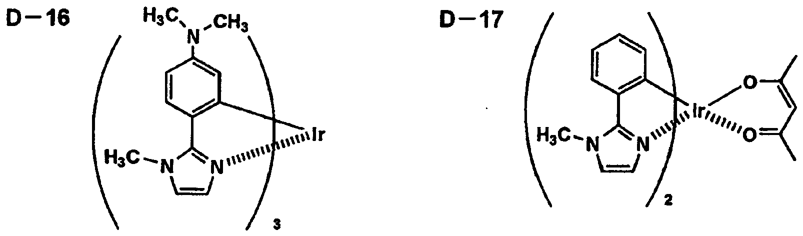 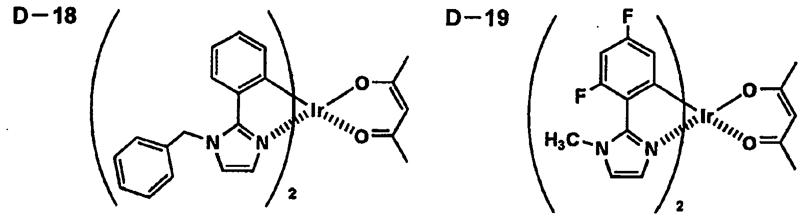 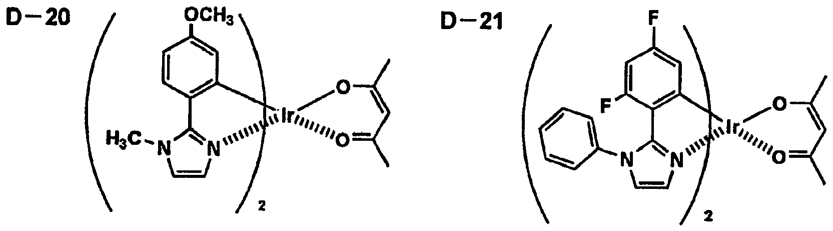 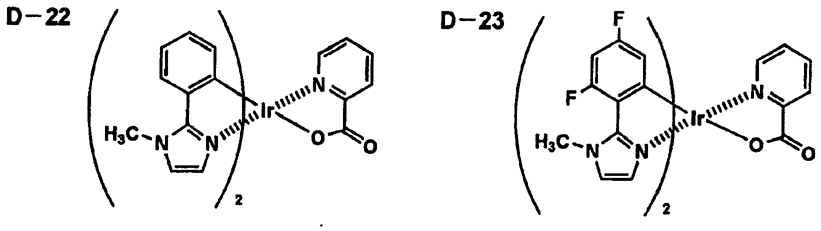 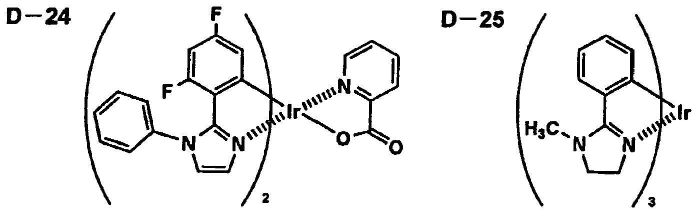 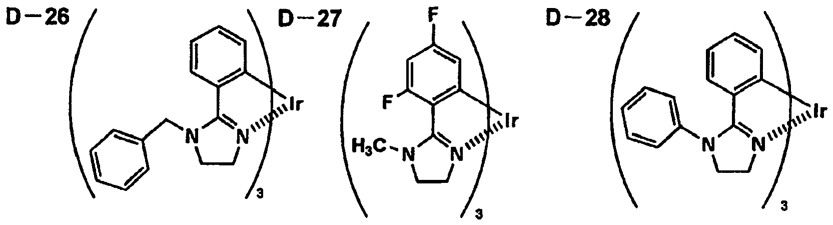 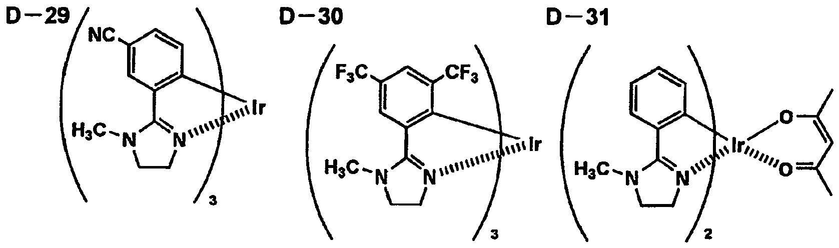 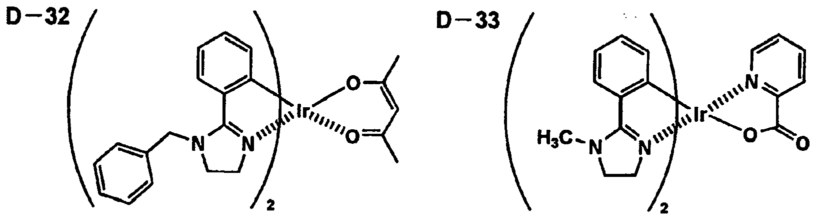 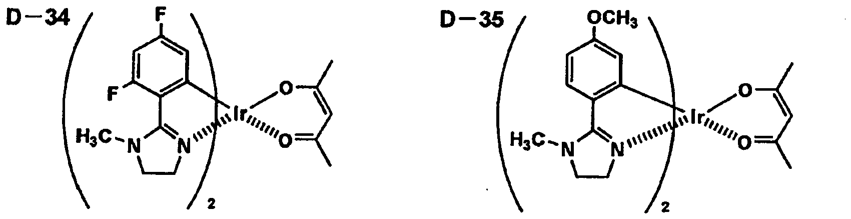 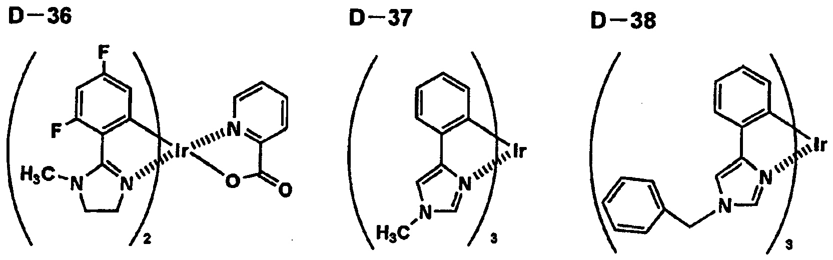 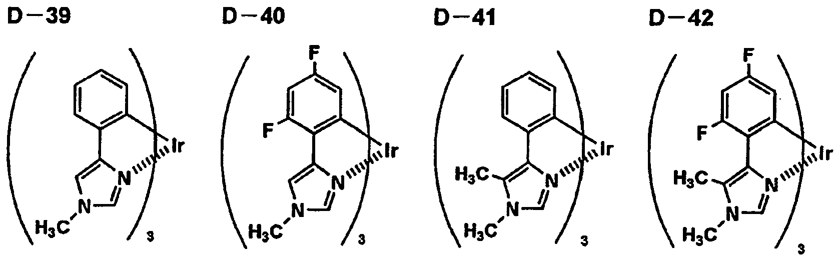 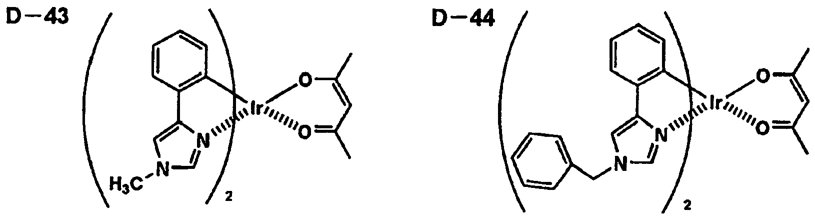 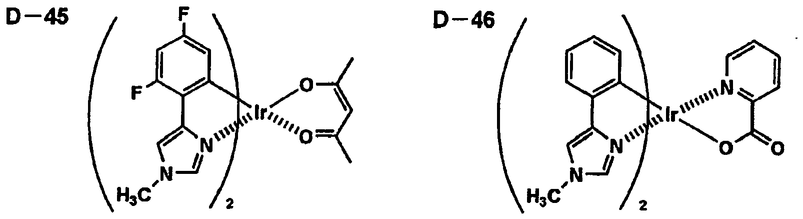 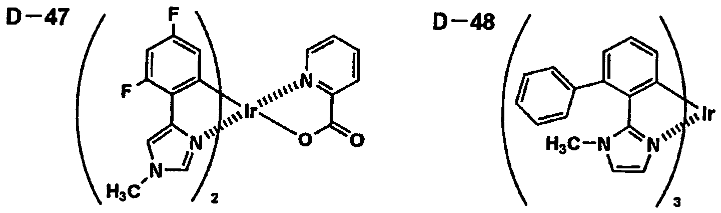 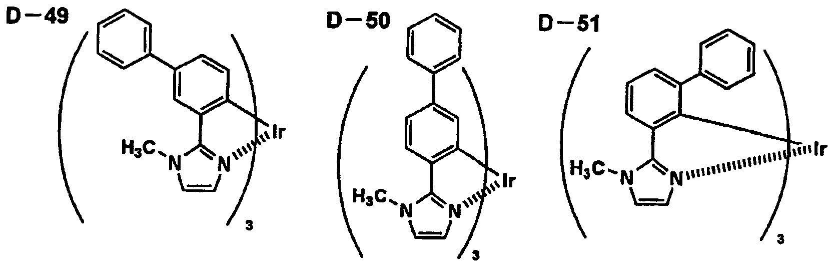 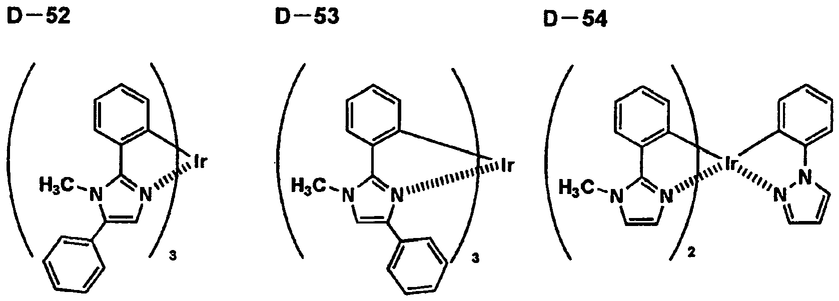 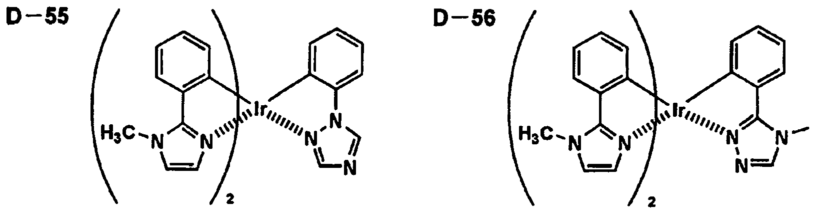 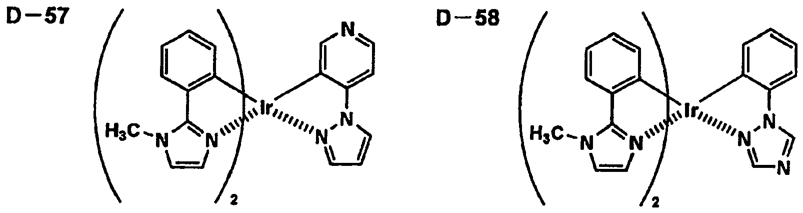 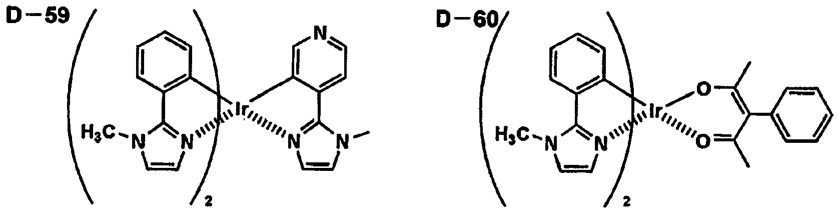 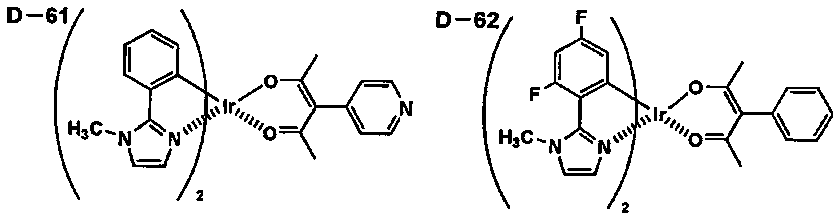 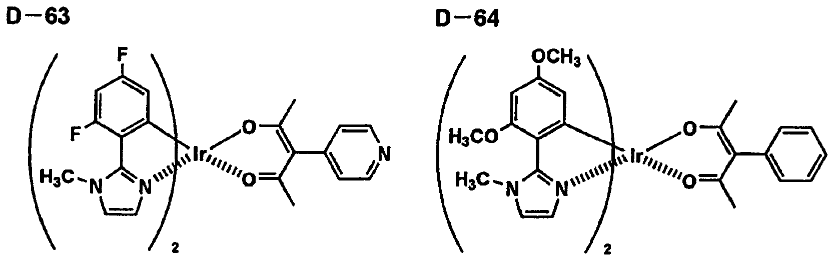 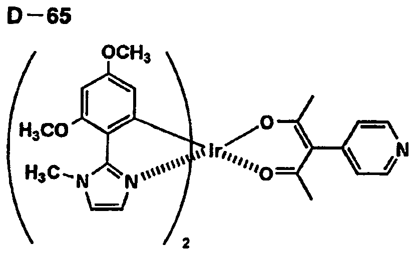 and a host compound selected from: 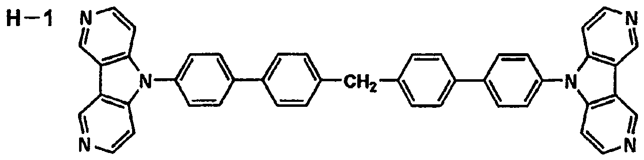 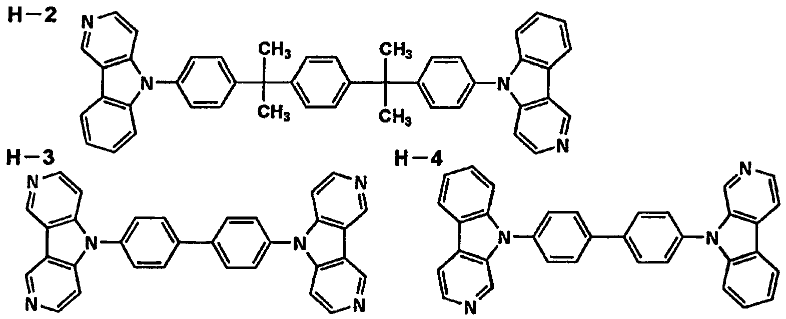 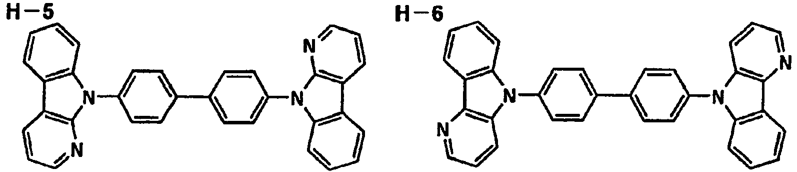 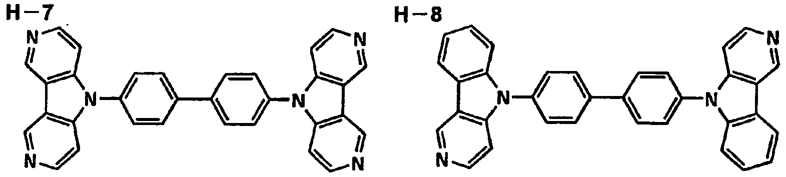 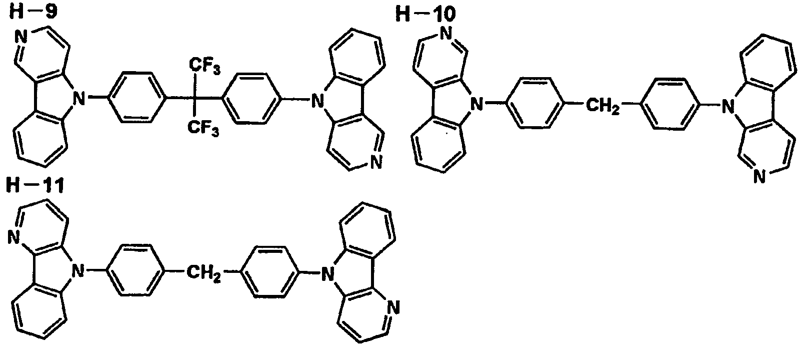 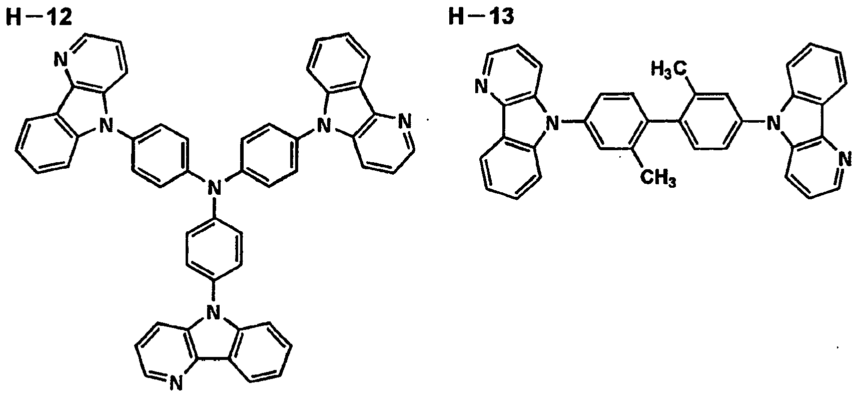 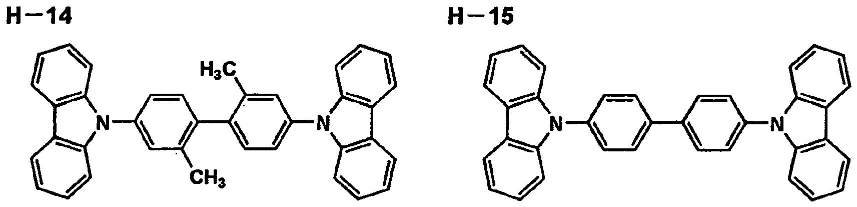 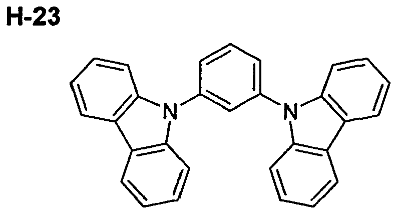 an excited triplet energy of a compound forming the intermediate layer is larger than an excited triplet energy of the phosphorescent compound and the compound forming the intermediate layer is selected from: 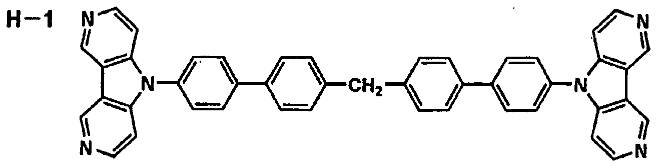 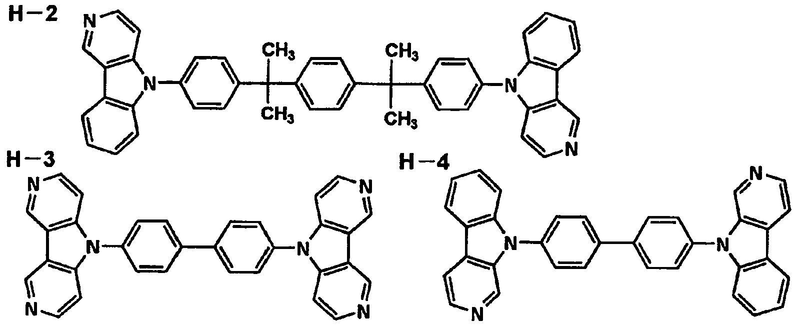 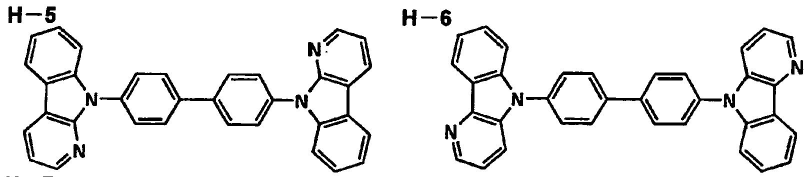 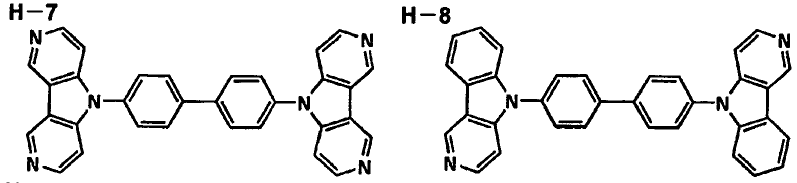 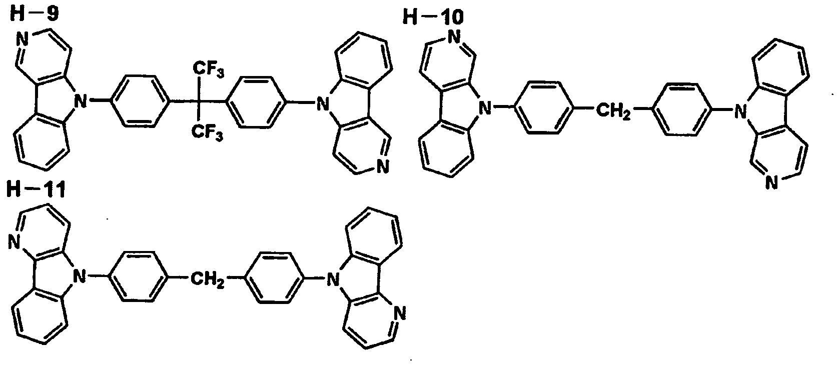 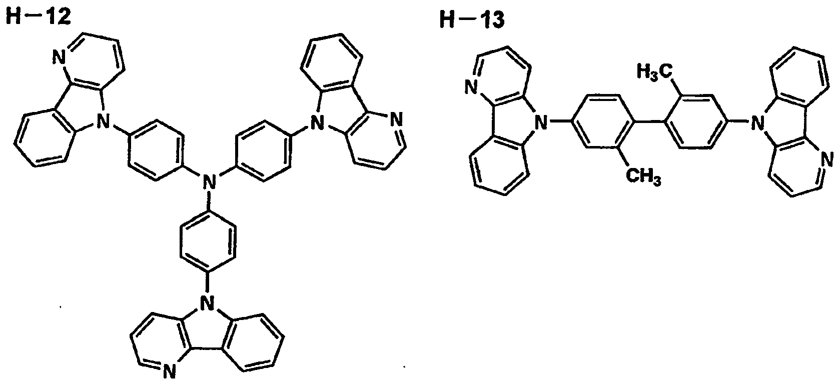 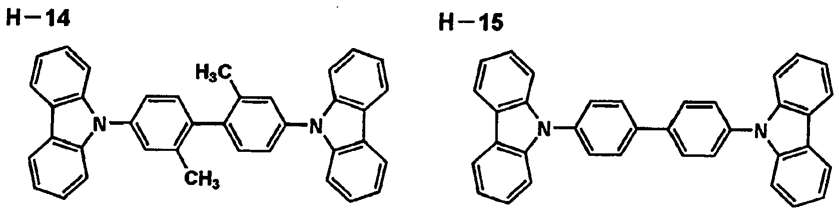 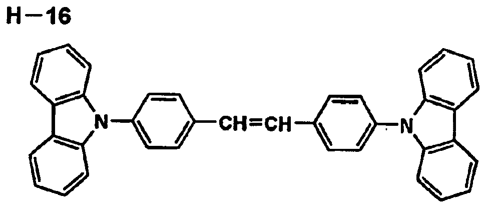 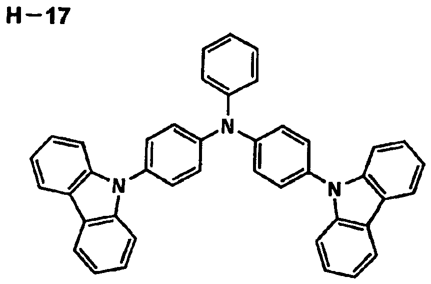 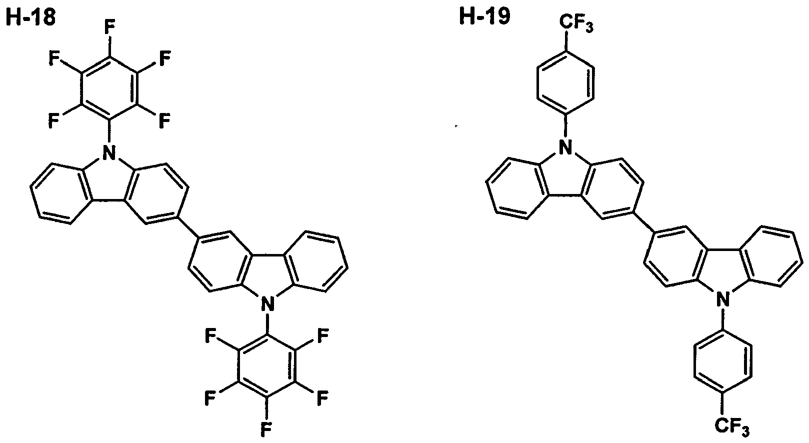 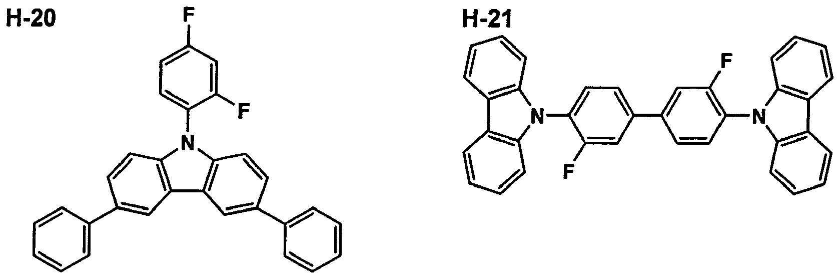 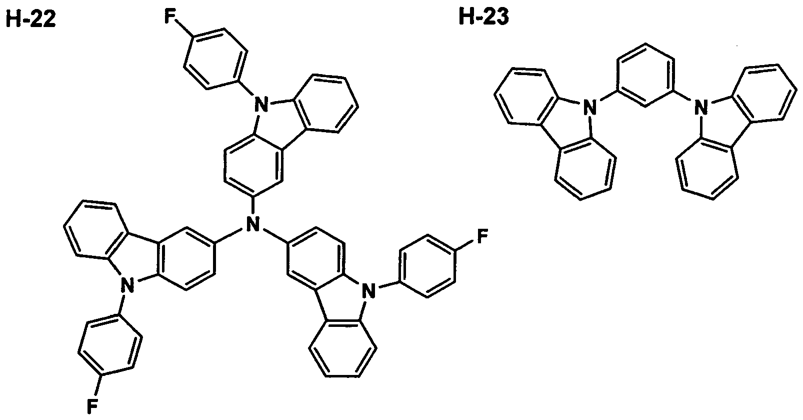 and: 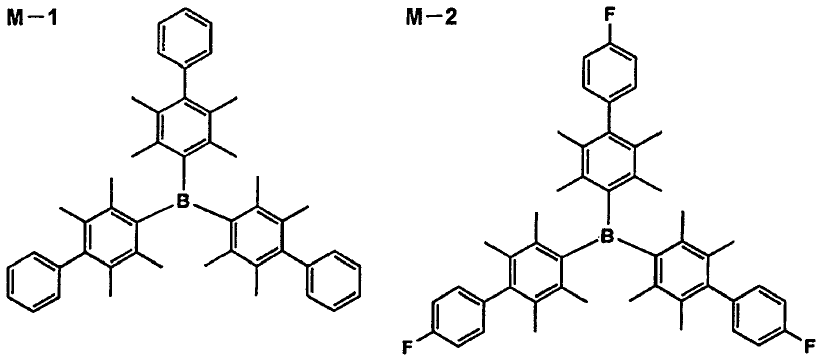 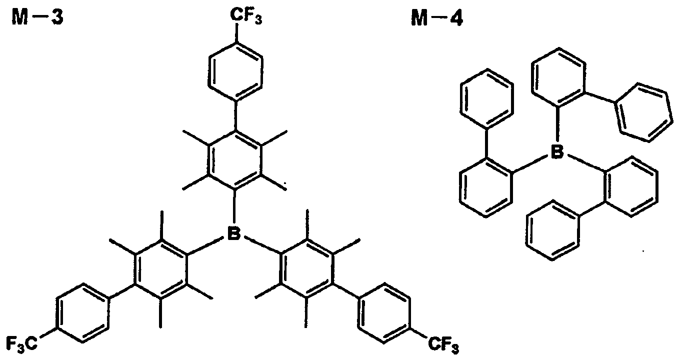 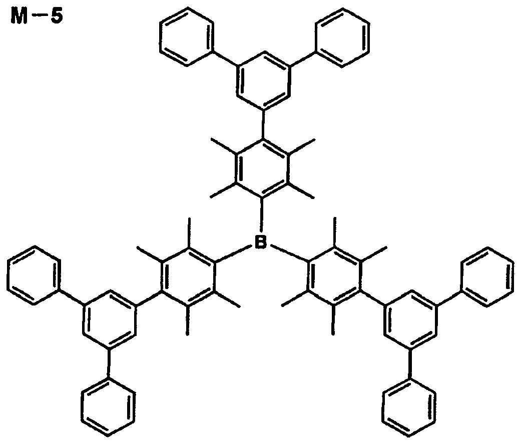 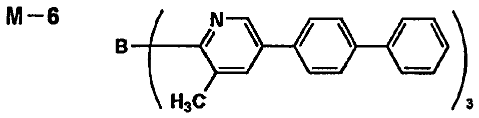 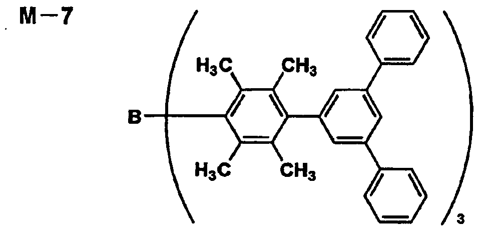 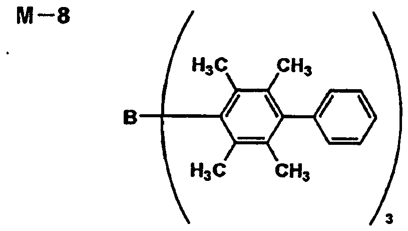 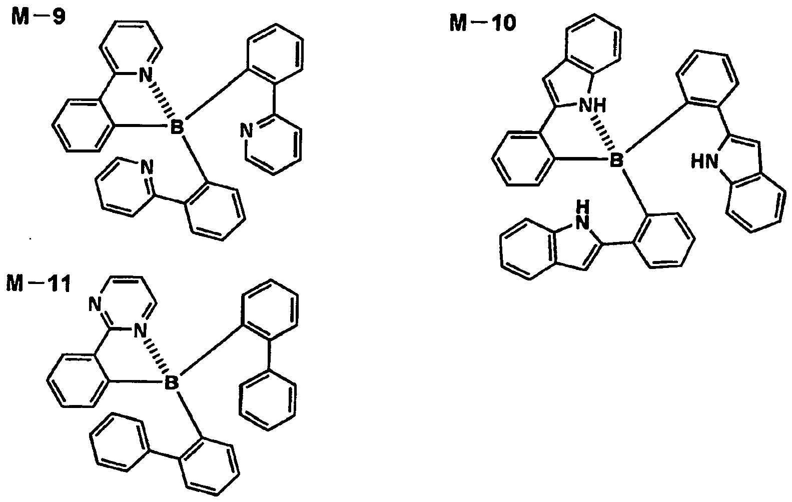 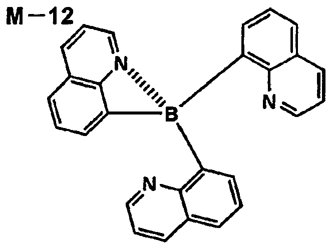 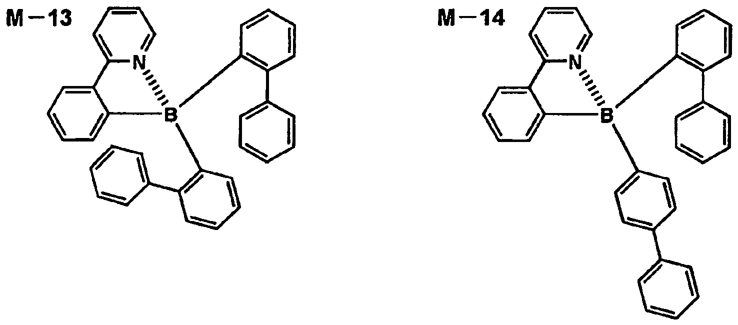 and
with the proviso that when the host compound of each of the two or more emission layers is the same, the compound forming the intermediate layer is different from the host compound.

2. The organic electroluminescence element of claim 1, wherein a thickness of the intermediate layer is larger than a Förster distance between two light emission compounds, each light emission compound being independently contained in one of the light emission layers sandwiching the intermediate layer.

3. The organic electroluminescence element of any one of claims 1 to 2 further comprising a hole blocking layer between a light emission layer and the cathode, the hole blocking layer being adjacent to the light emission layer.

4. The organic electroluminescence element of any one of claims 1, 2 and 3 further comprising an electron blocking layer between a light emission layer and the anode, the electron blocking layer being adjacent to the light emission layer.

## Patentansprüche

1. Organisches Elektrolumineszenz-Element, umfassend:
eine Anode und eine Kathode, die dazwischen zwei oder mehrere Lichtemissionsschichten aufweisen, die verschiedene Emissions-Peaks zeigen, sowie eine Zwischenschicht, die zwischen den Lichtemissionsschichten vorliegt, wobei die Lichtemissionsschichten eine phosphoreszierende Verbindung als Lichtemissionsverbindung umfassen, ausgewählt aus: 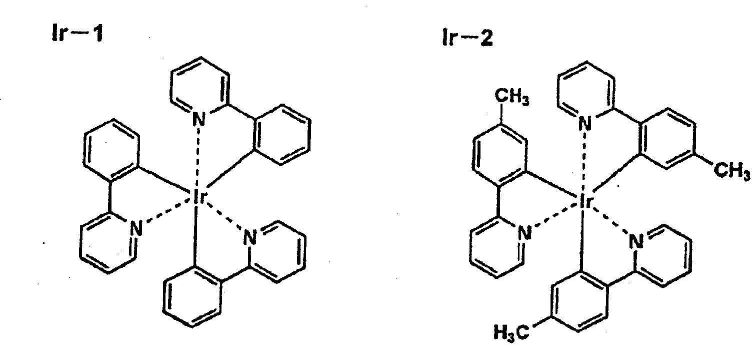 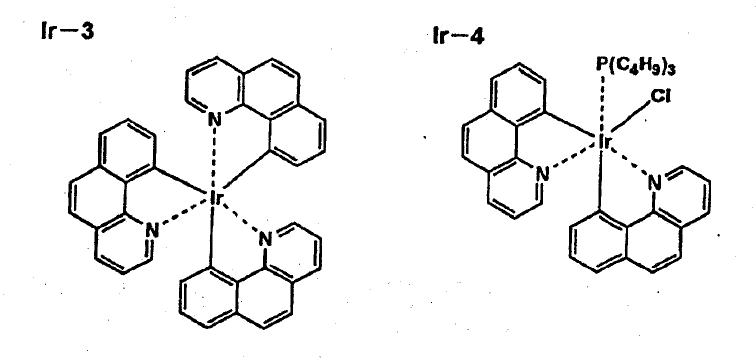 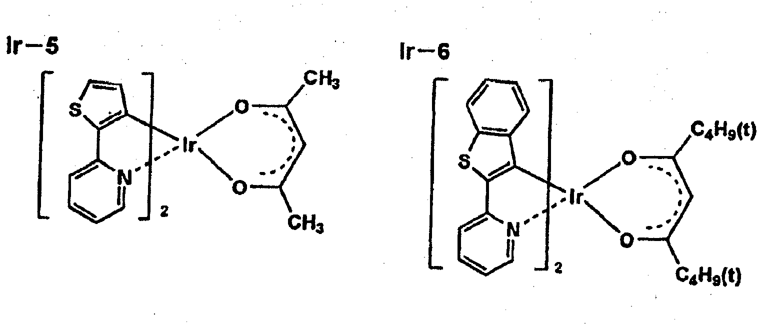 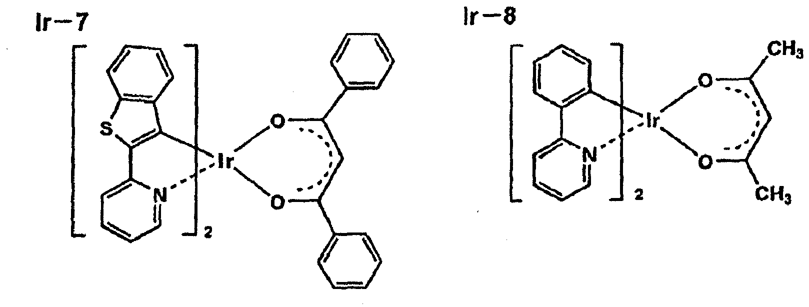 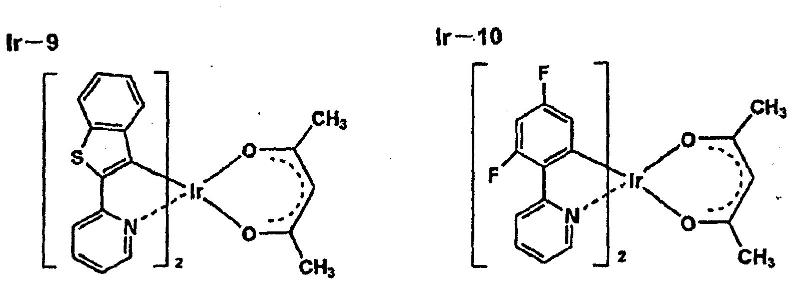 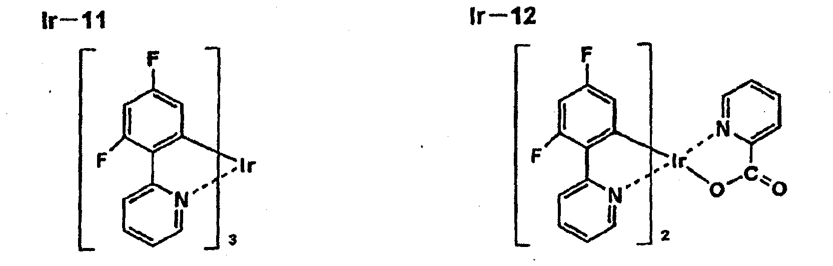 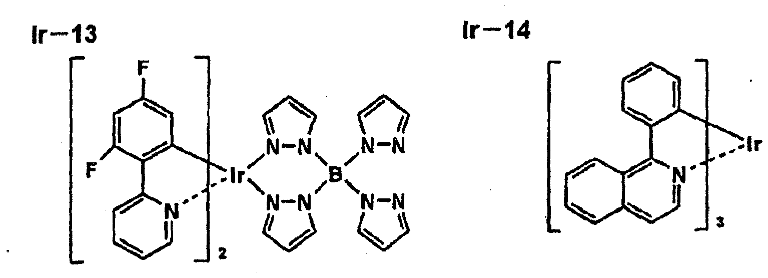 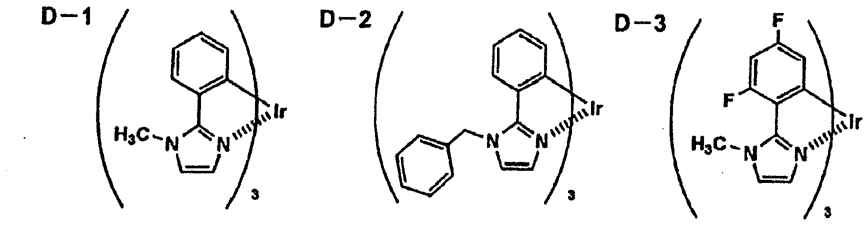 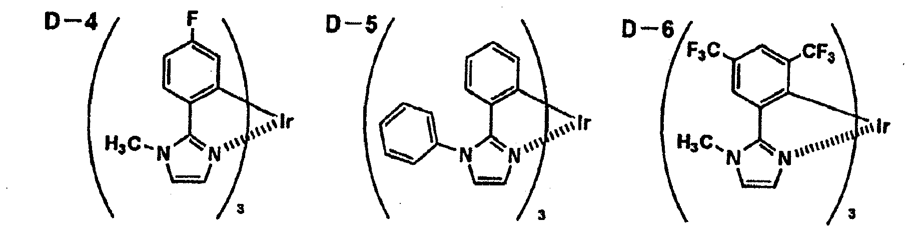 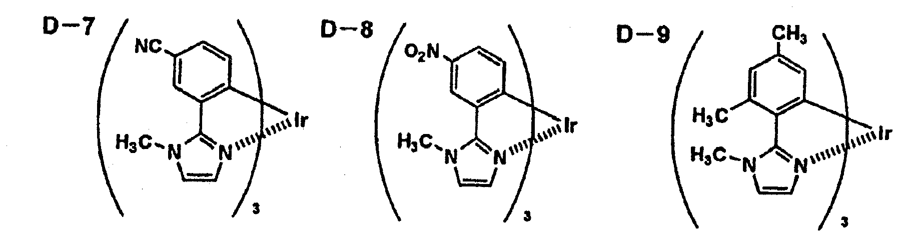 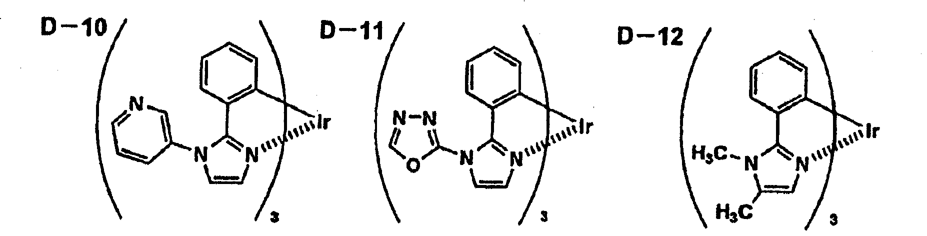 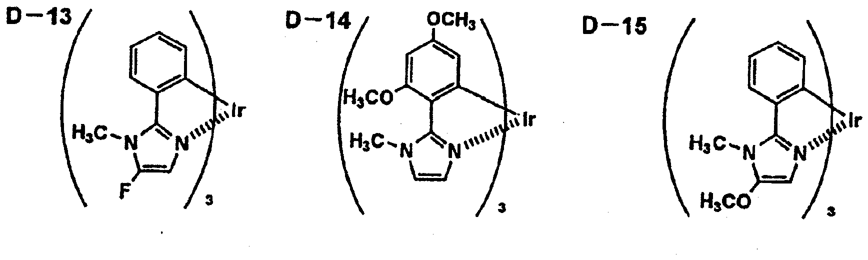 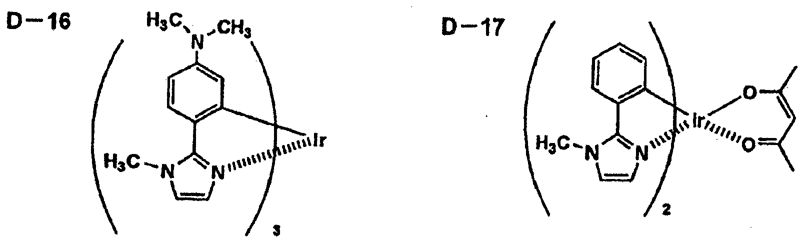 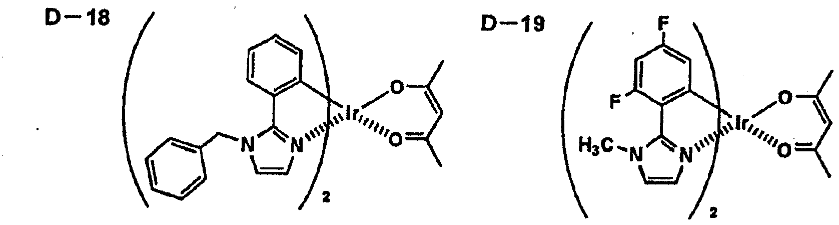 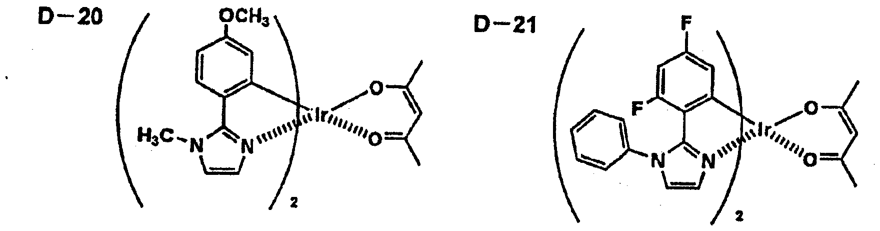 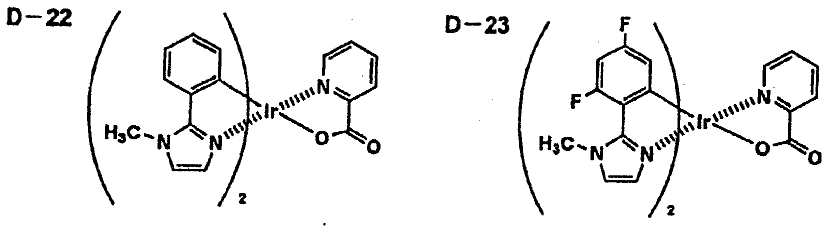 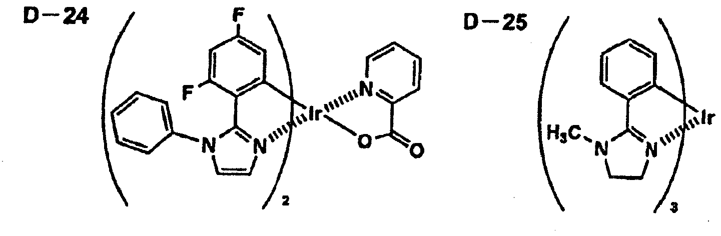 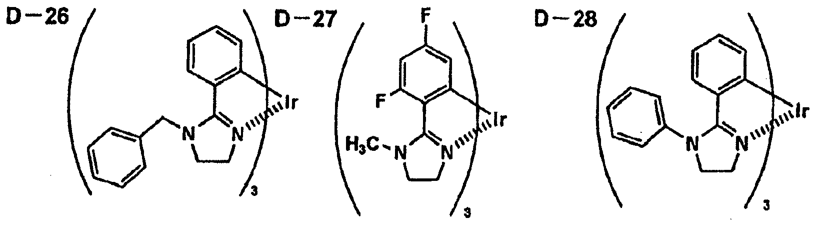 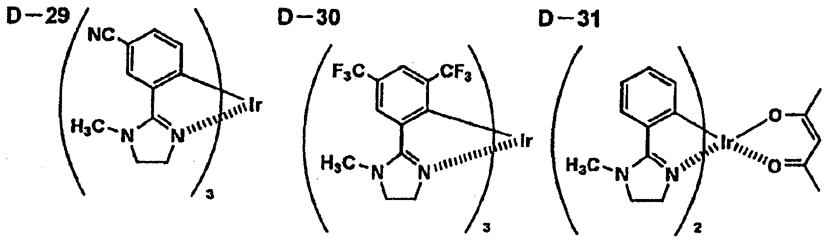 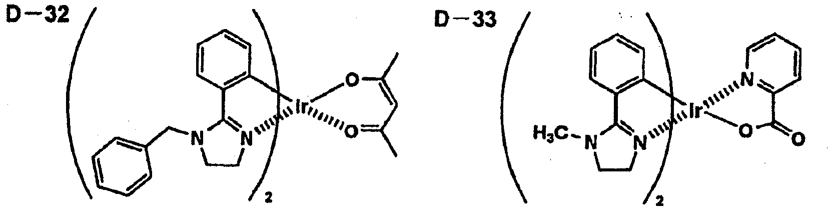 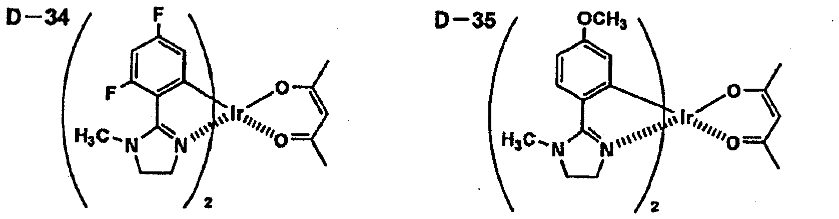 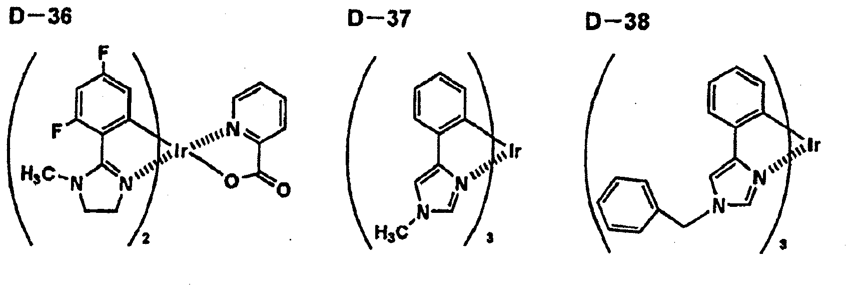 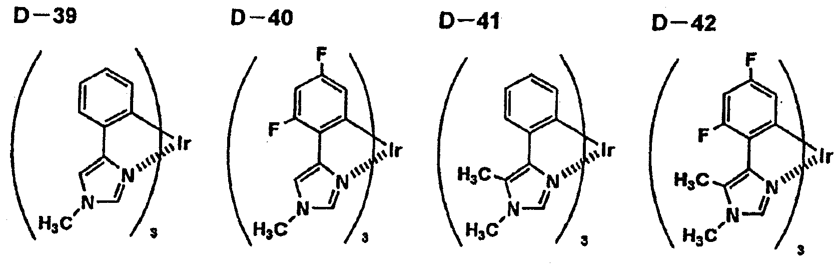 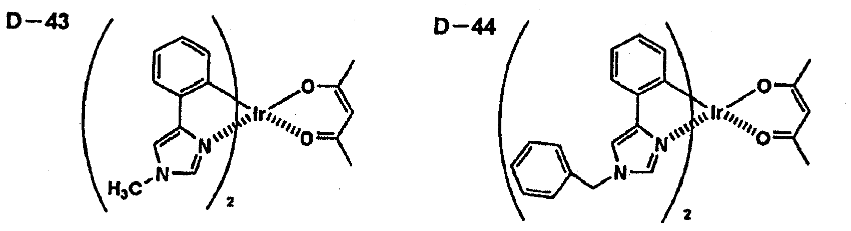 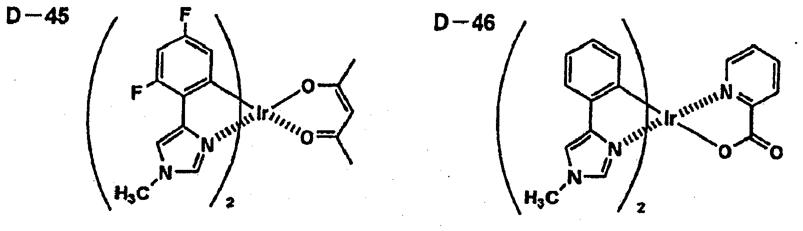 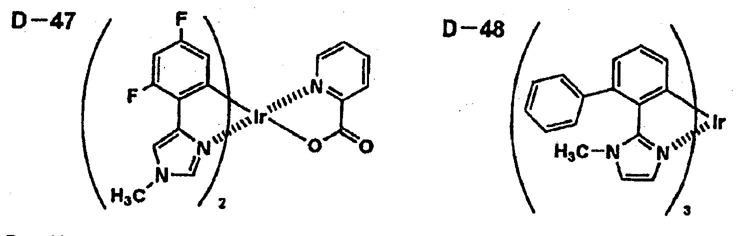 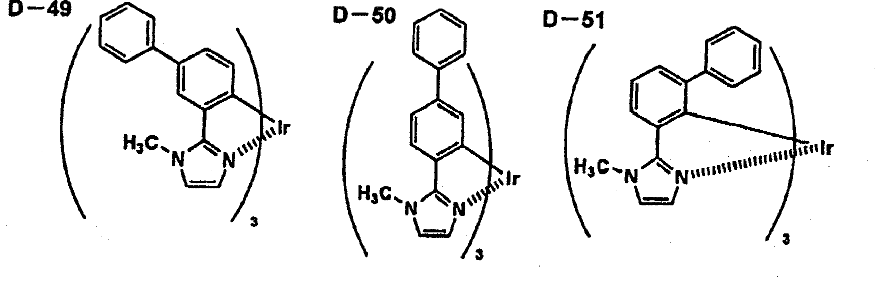 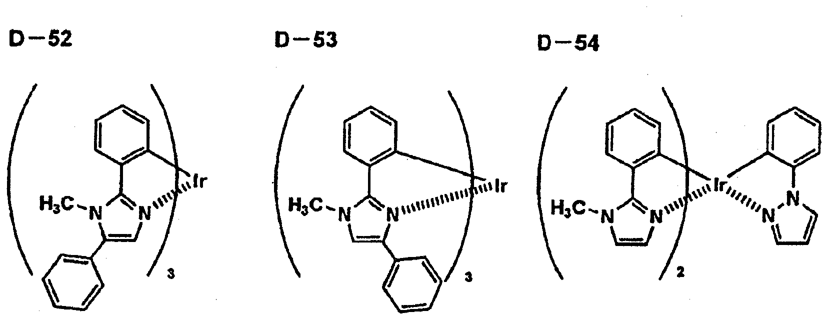 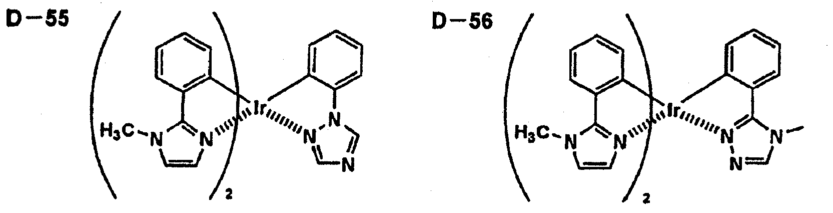 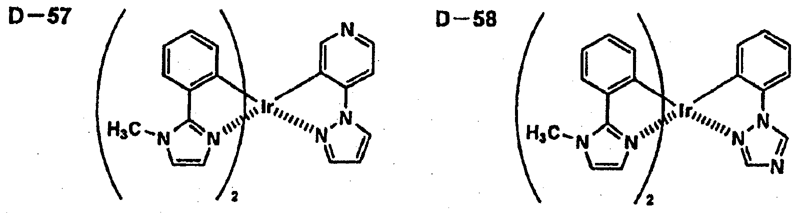 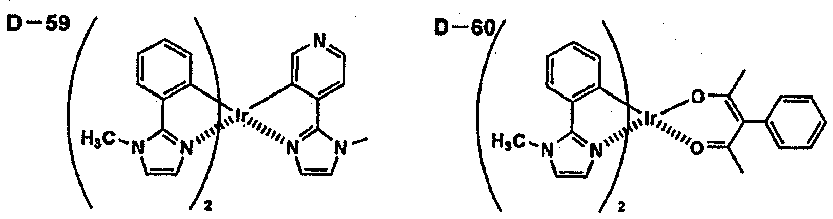 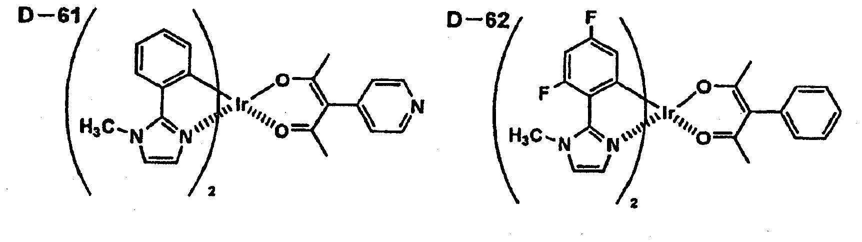 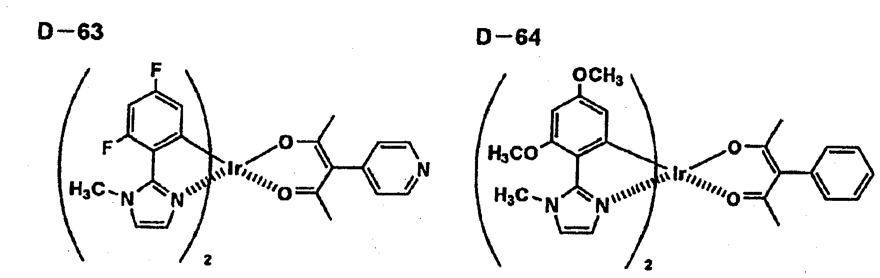 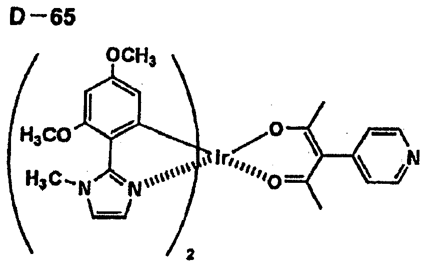 sowie eine Wirtsverbindung, ausgewählt aus: 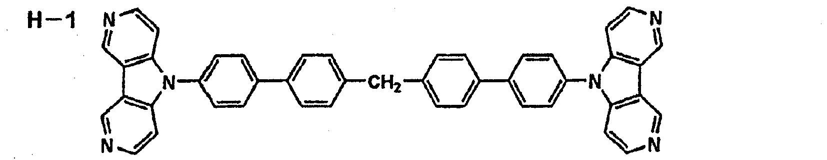 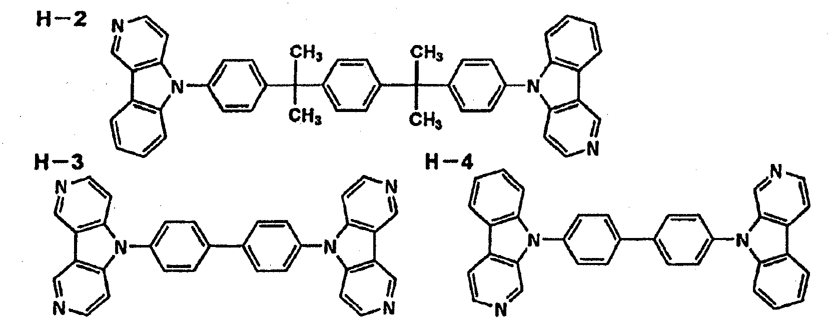 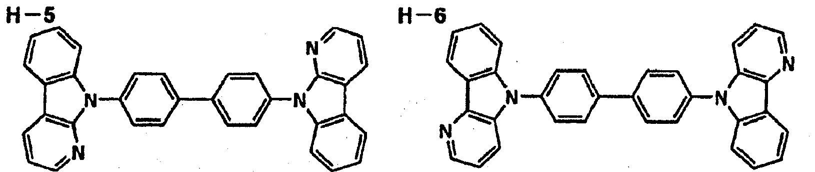 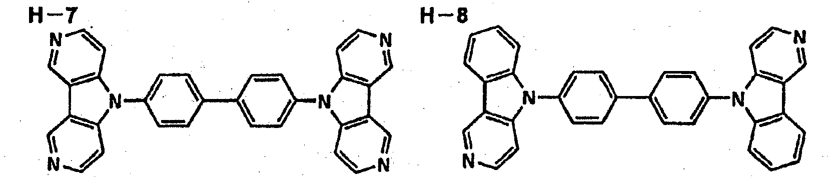 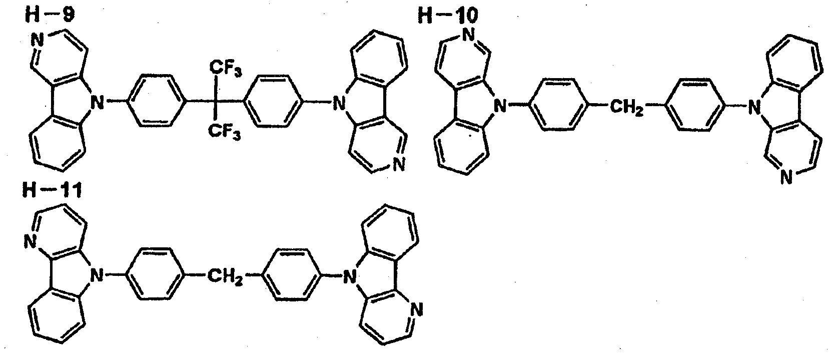 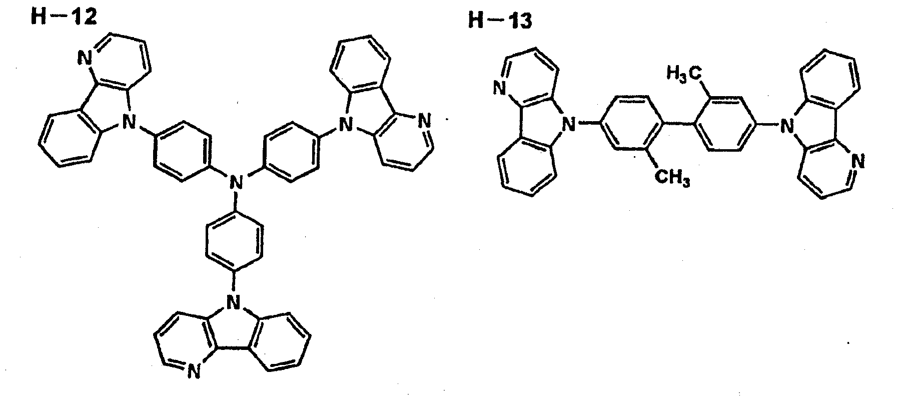 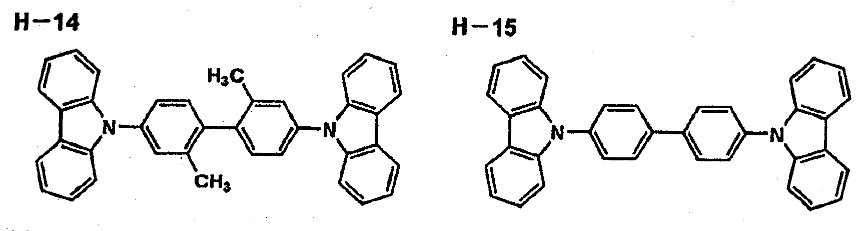 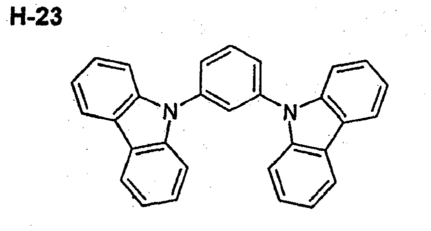
wobei die angeregte Triplett-Energie einer Verbindung, die die Zwischenschicht bildet, größer ist als die angeregte Triplett-Energie der phosphoreszierenden Verbindung, und die Verbindung, die die Zwischenschicht bildet, ist ausgewählt aus: 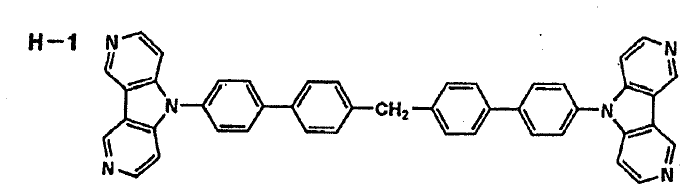 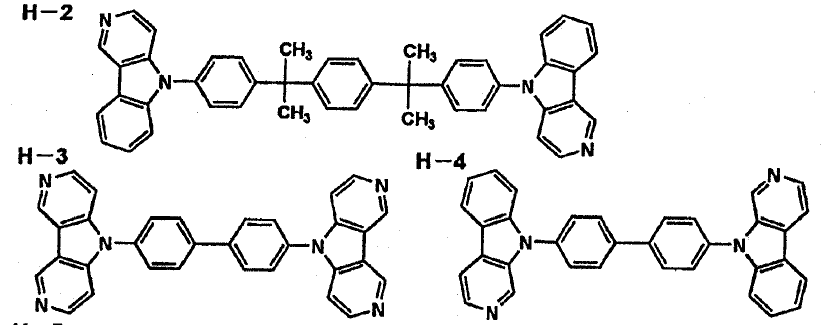 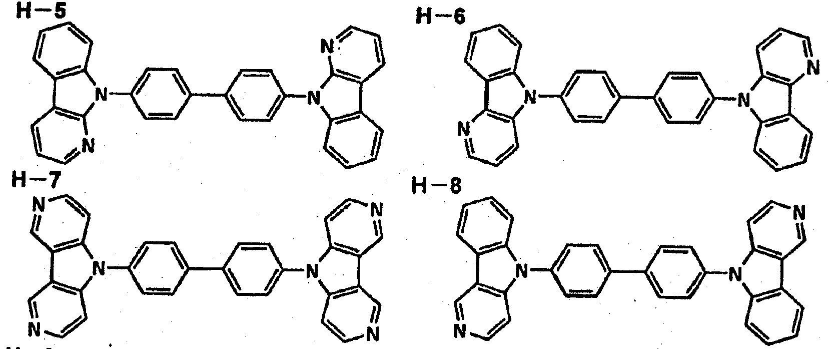 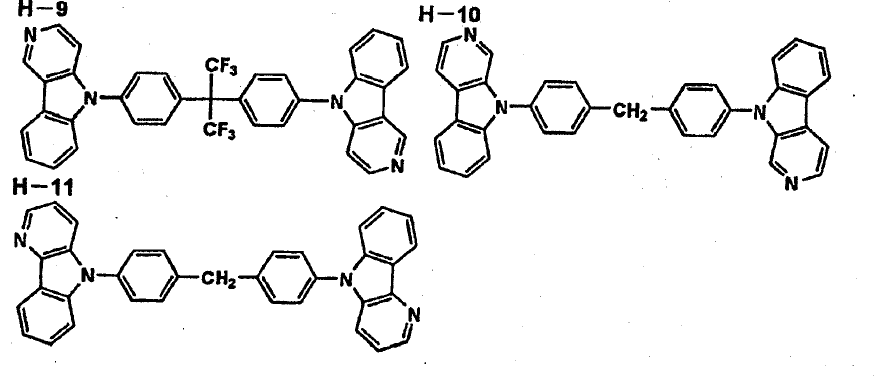 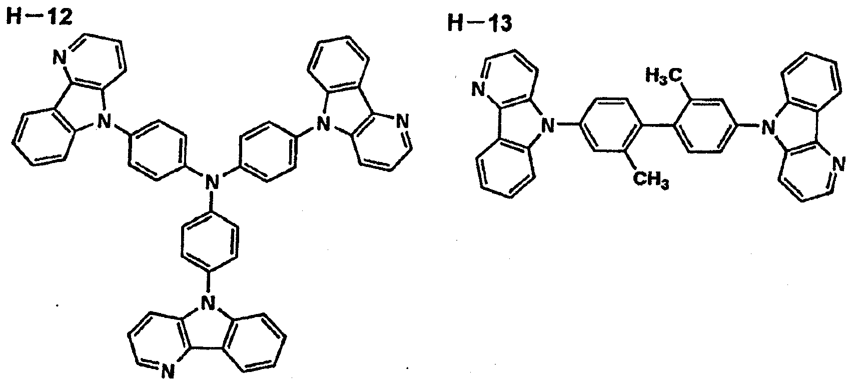 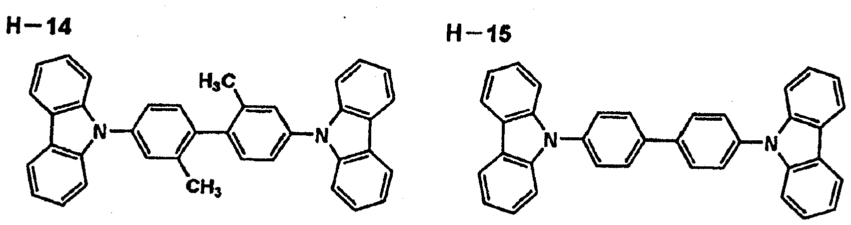 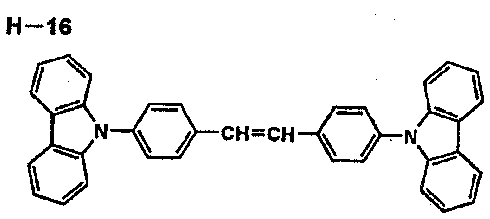 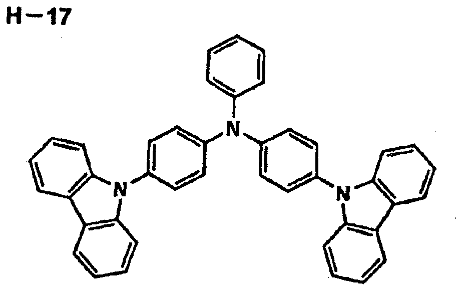 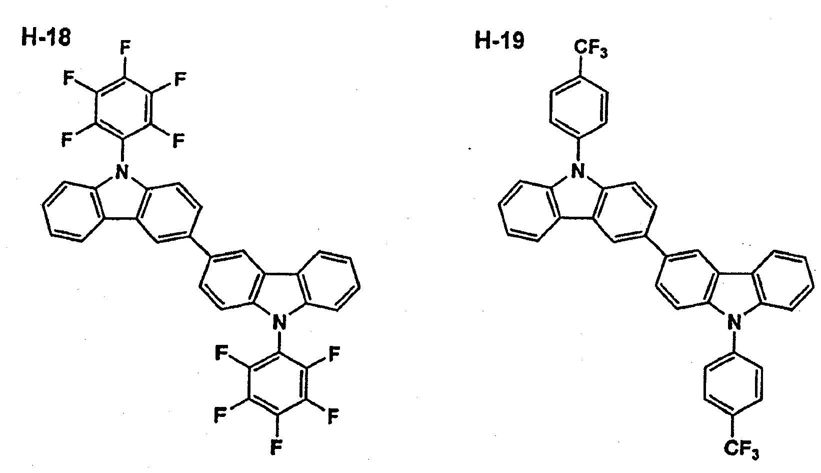 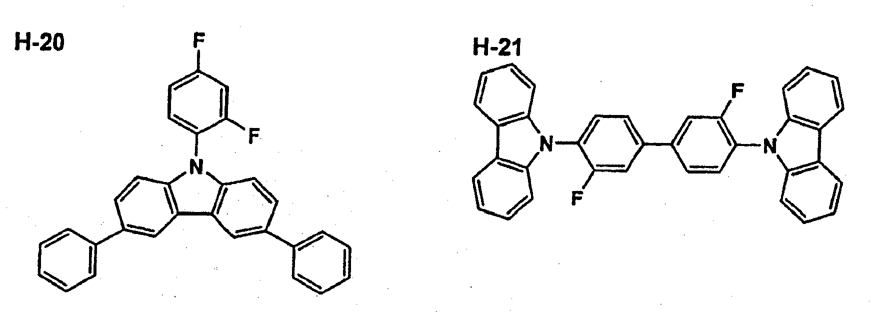 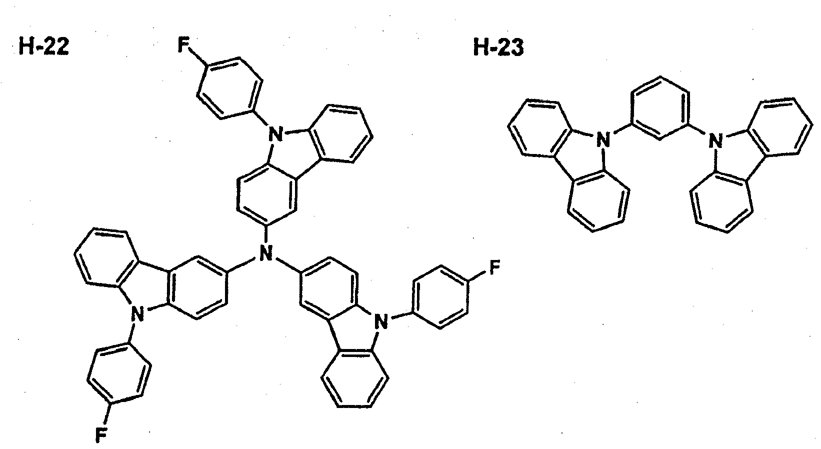 und: 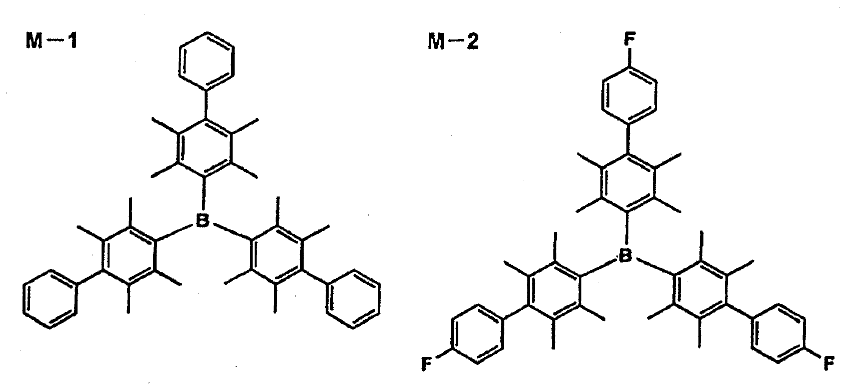 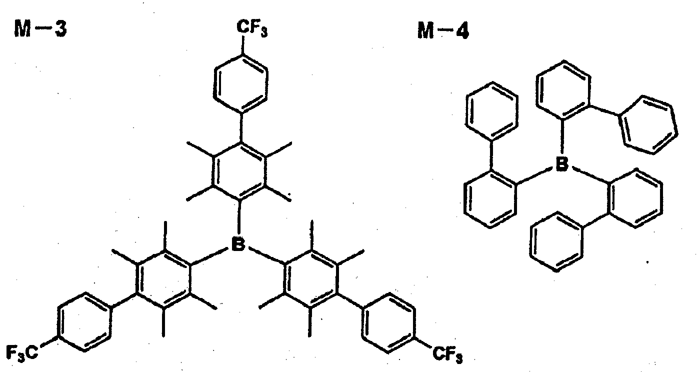 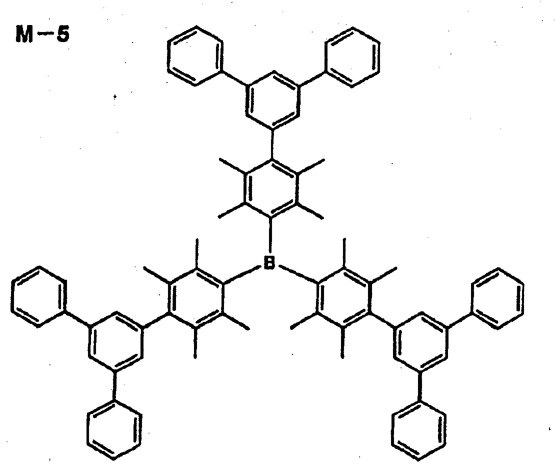 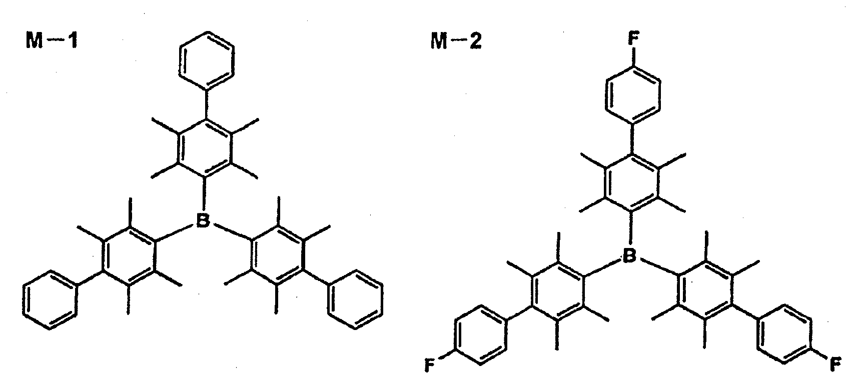 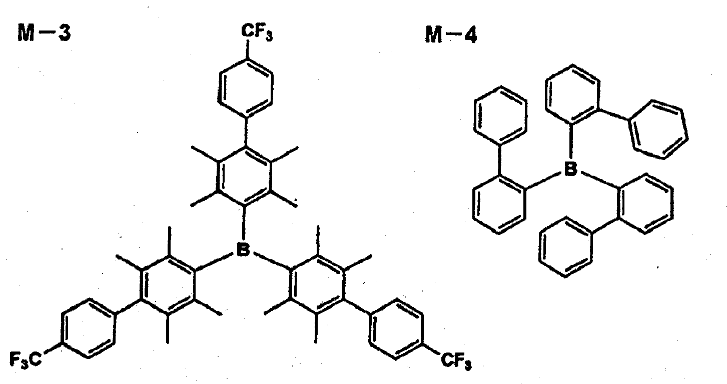 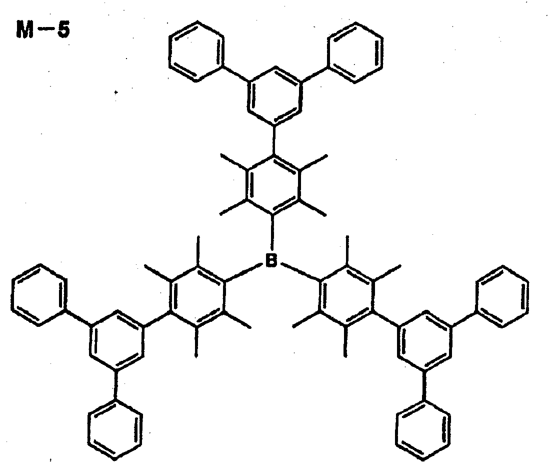 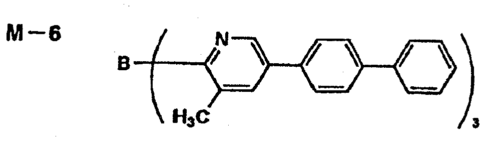 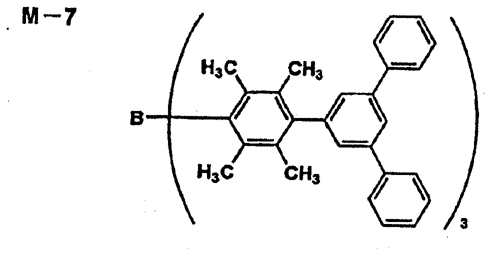 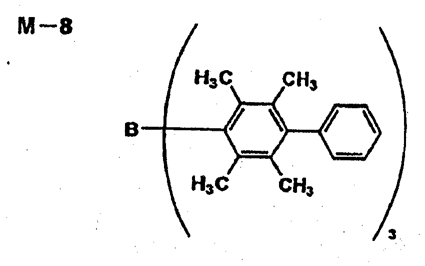 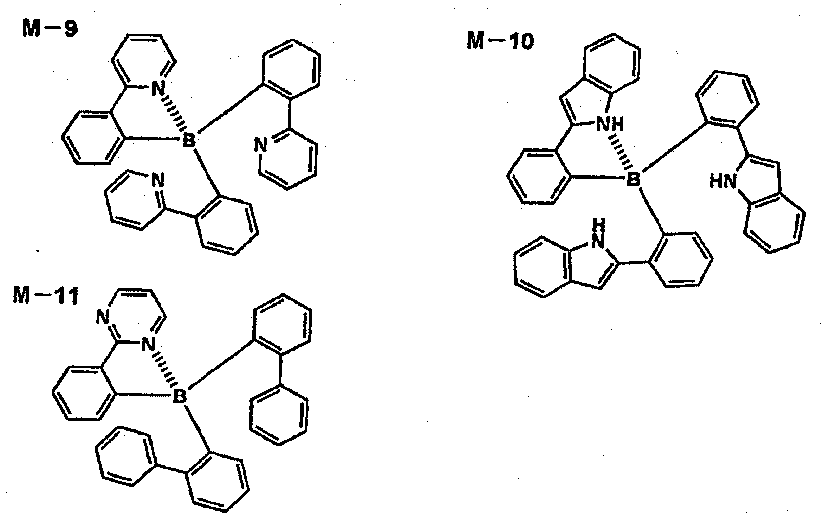 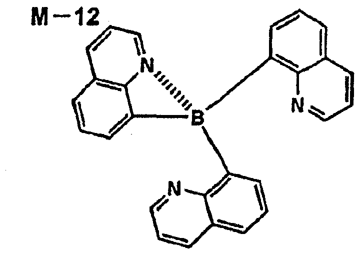 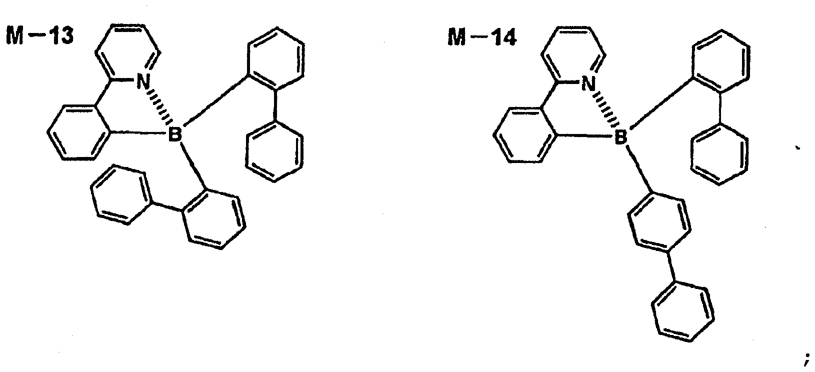 und
mit der Maßgabe, dass, wenn die Wirtsverbindung jeder der beiden Emissionsschichten dieselbe ist, die Verbindung, die die Zwischenschicht bildet, von der Wirtsverbindung verschieden ist.

2. Organisches Elektrolumineszenz-Element gemäß Anspruch 1, wobei die Dicke der Zwischenschicht größer ist als der Förster-Abstand zwischen den beiden Lichtemissionsverbindungen, wobei jede Lichtemissionsverbindung unabhängig in einer der beiden Lichtemissionsschichten, zwischen die die Zwischenschicht eingeschoben ist, enthalten ist.

3. Organisches Elektrolumineszenz-Element gemäß Anspruch 1 oder 2, des Weiteren umfassend eine Lochblockierschicht zwischen einer Lichtemissionsschicht und der Kathode, wobei die Lochblockierschicht an die Lichtemissionsschicht angrenzt.

4. Organisches Elektrolumineszenz-Element gemäß einem der Ansprüche 1, 2 und 3, des Weiteren umfassend eine Elektronenblockierschicht zwischen einer Lichtemissionsschicht und der Anode, wobei die Elektronenblockierschicht an die Lichtemissionsschicht angrenzt.

## Revendications

1. Elément électroluminescent organique comprenant une anode et une cathode comportant entre elles deux ou plus de deux couches luminescentes présentant des pics d'émission différents et une couche intermédiaire fournie entre les couches luminescentes, dans lequel
les couches luminescentes comprennent un composé phosphorescent comme composé luminescent choisi entre : 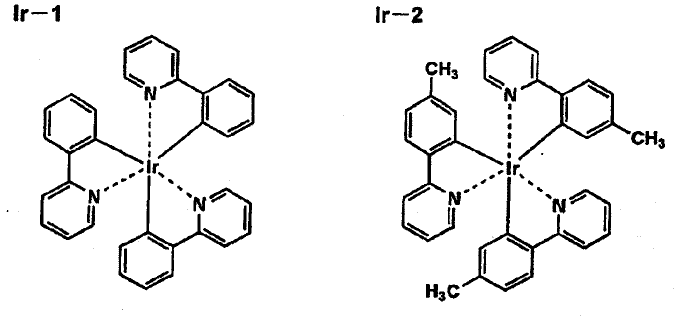 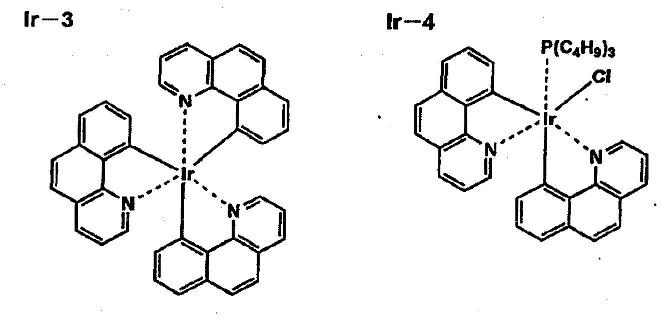 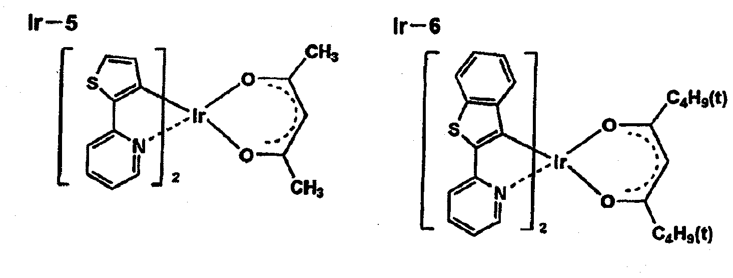 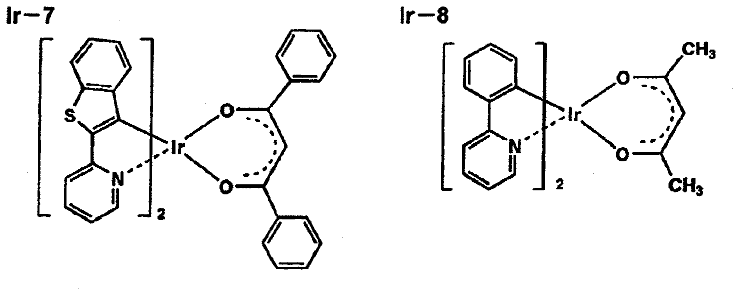 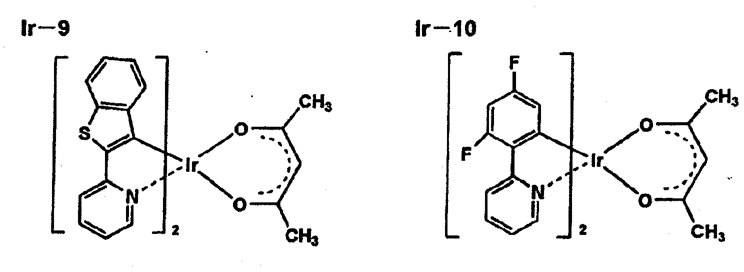 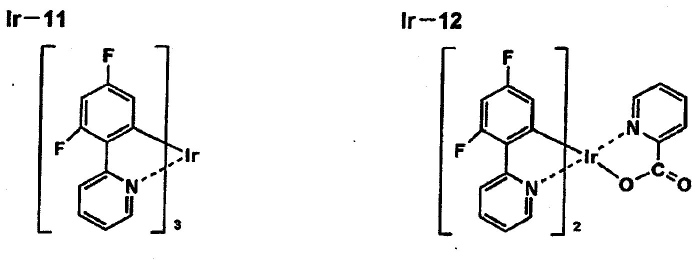 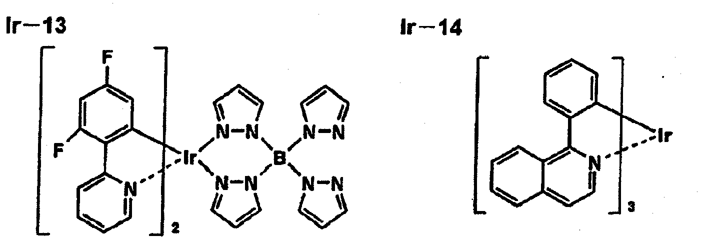 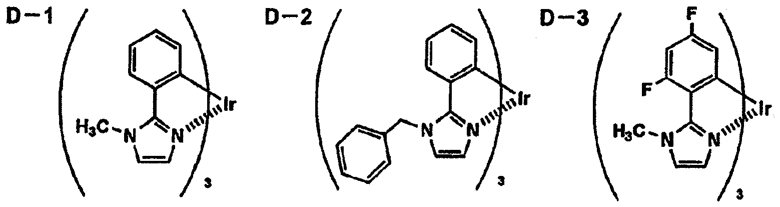 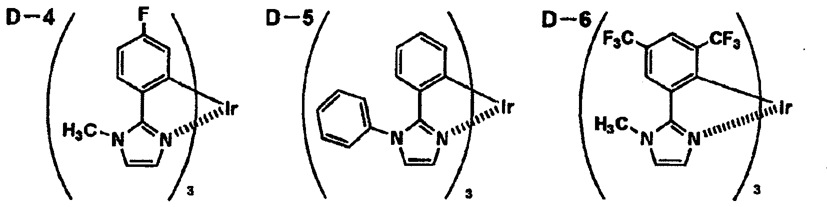 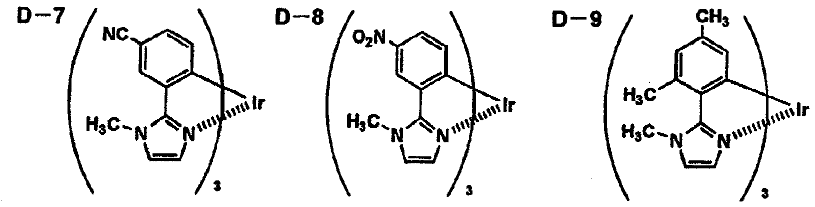 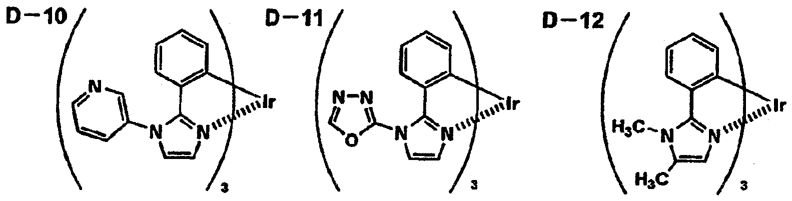 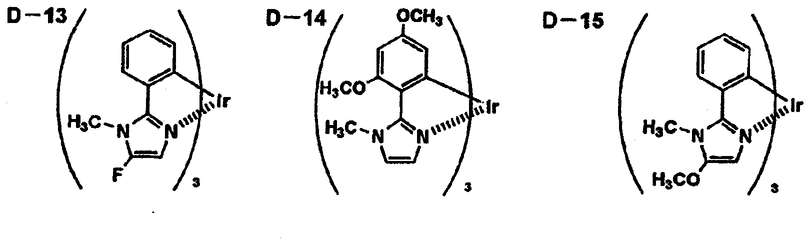 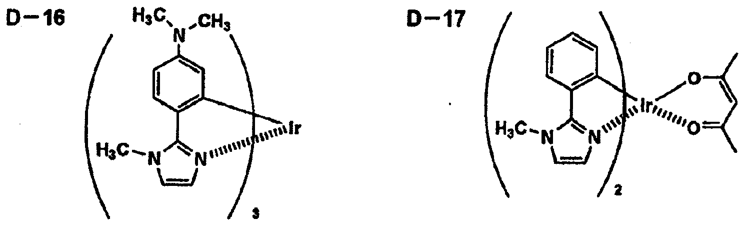 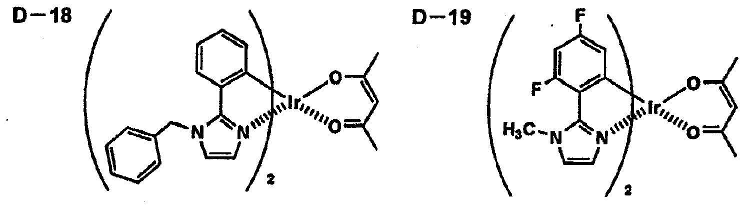 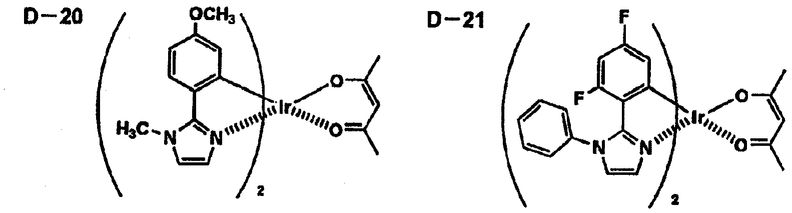 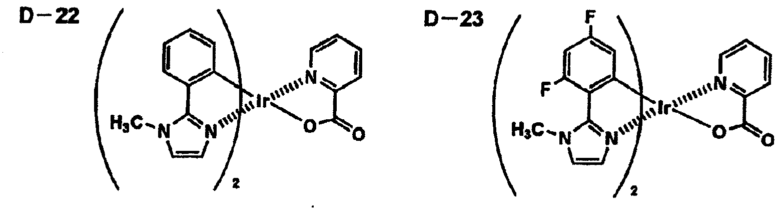 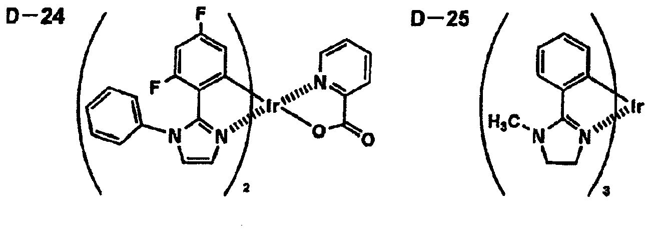 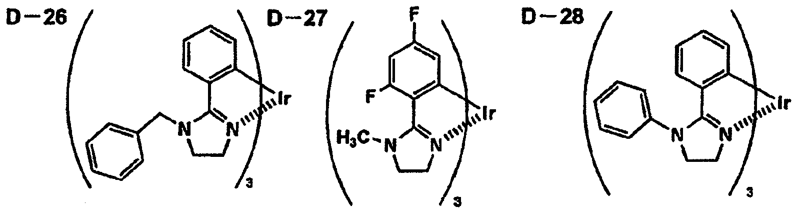 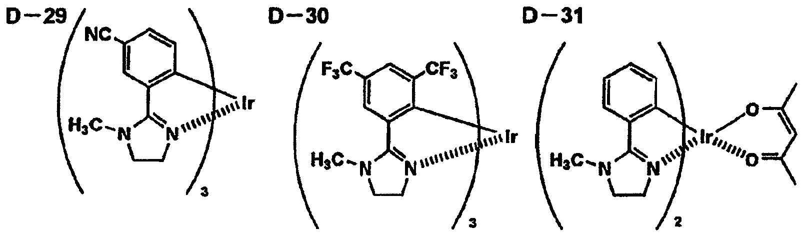 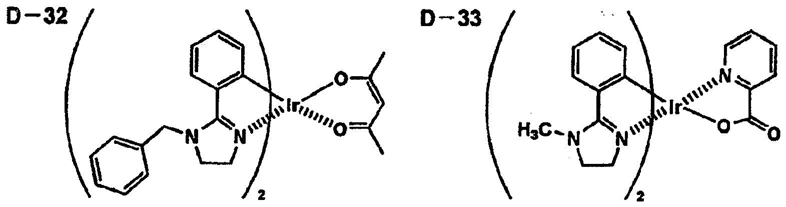 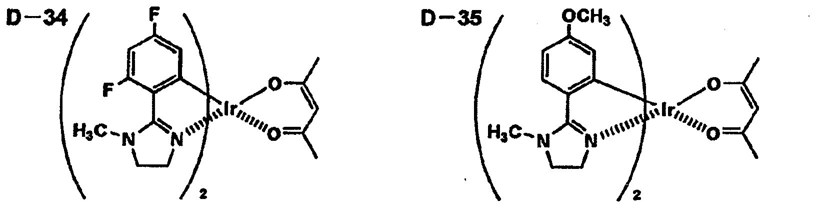 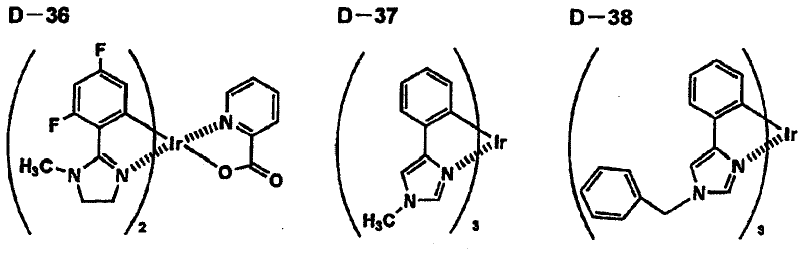 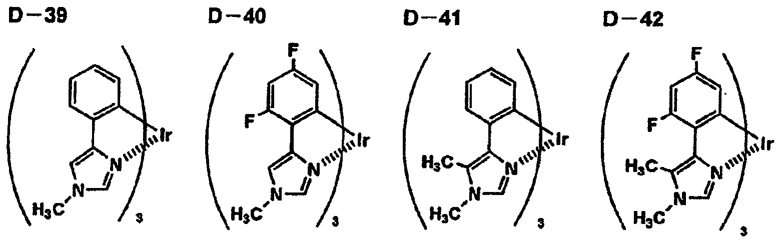 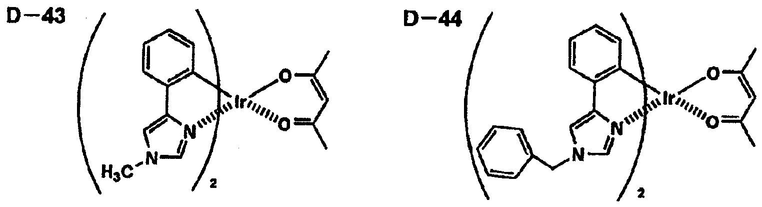 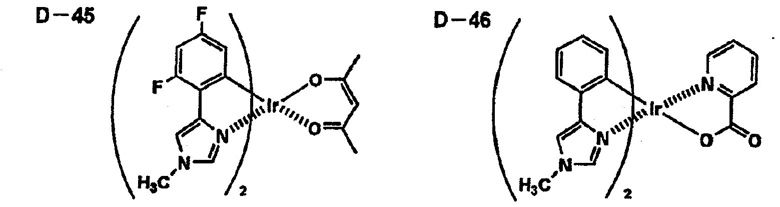 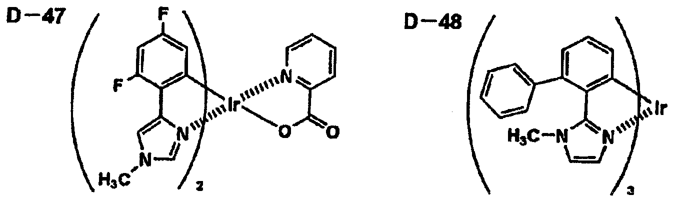 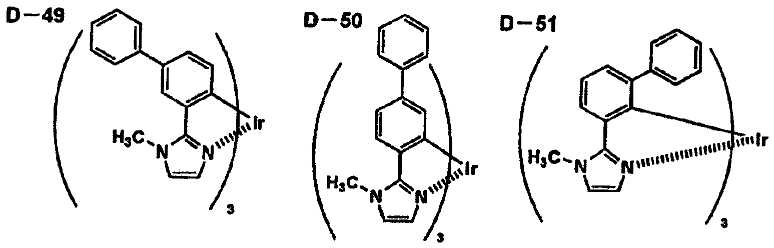 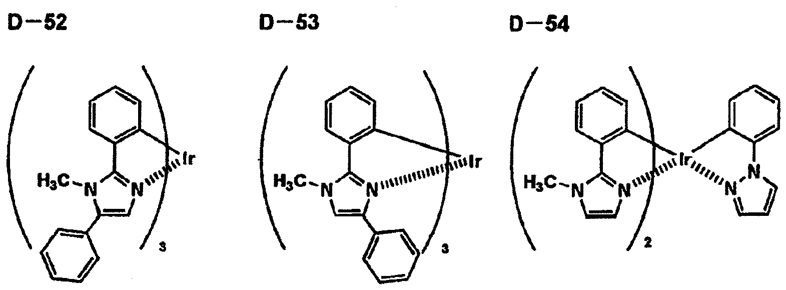 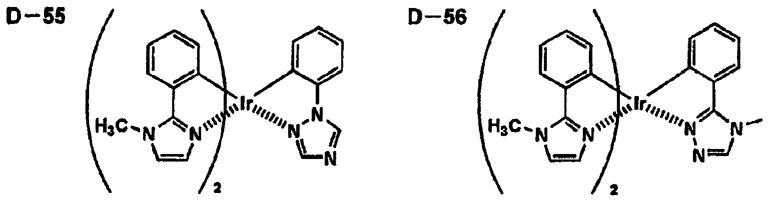 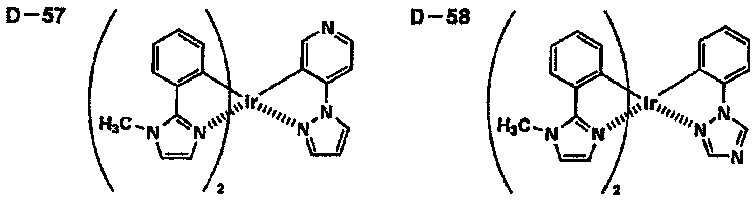 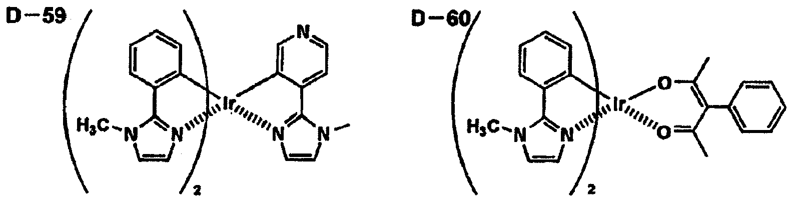 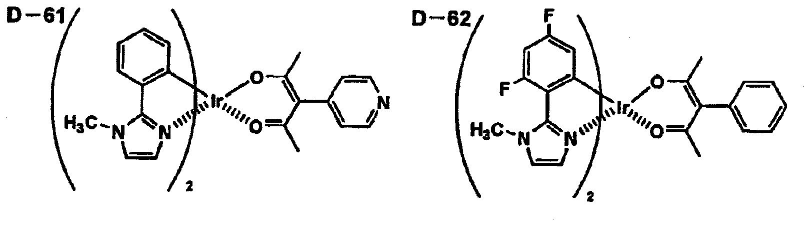 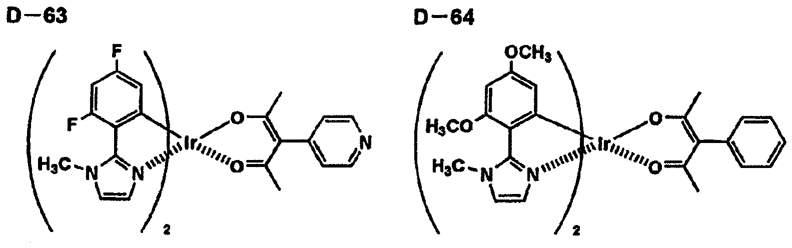 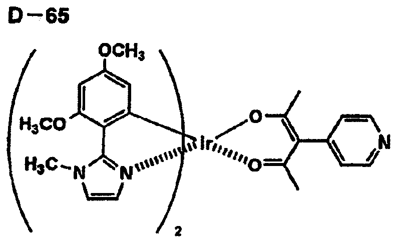 et un composé incluant choisi entre : 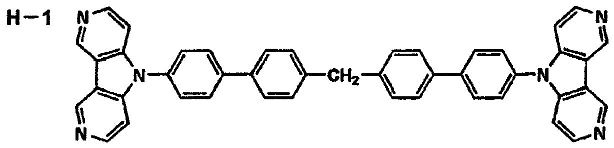 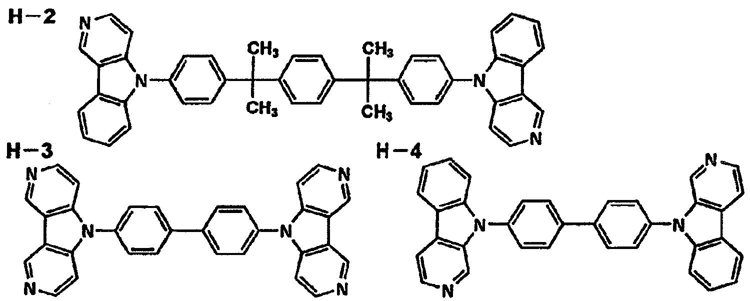 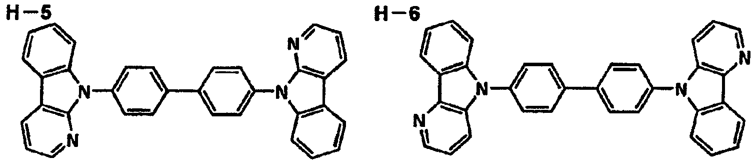 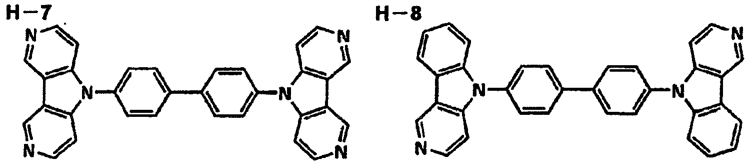 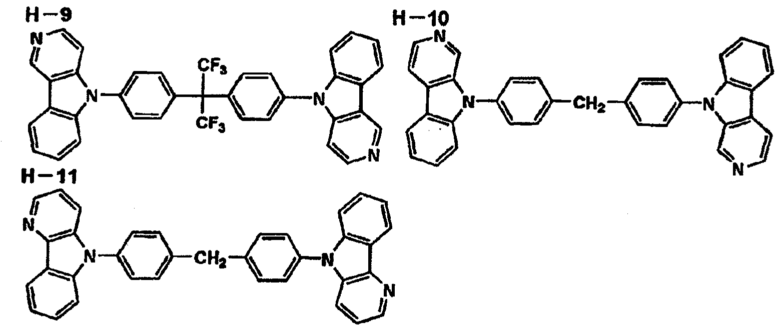 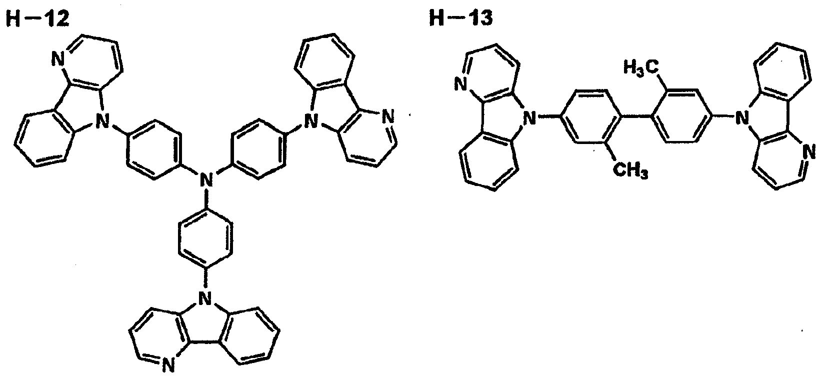 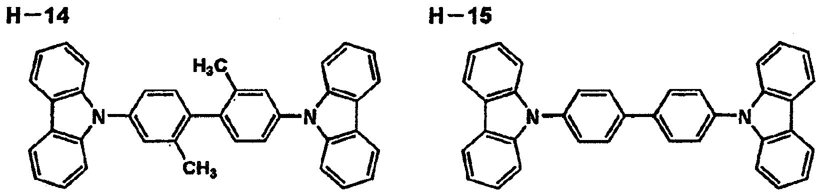 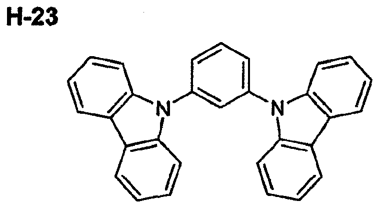 l'énergie de triplet à l'état excité d'un composé formant la couche intermédiaire étant supérieure à l'énergie de triplet à l'état excité du composé phosphorescent et le composé formant la couche intermédiaire étant choisi entre : 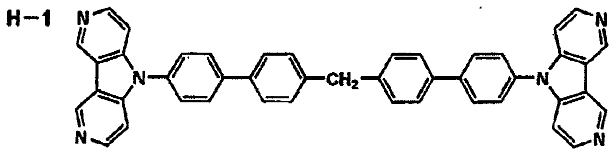 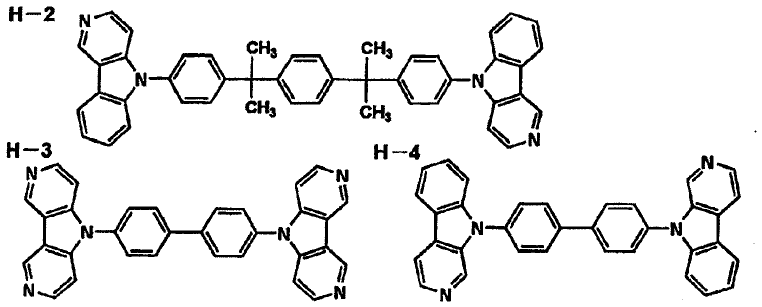 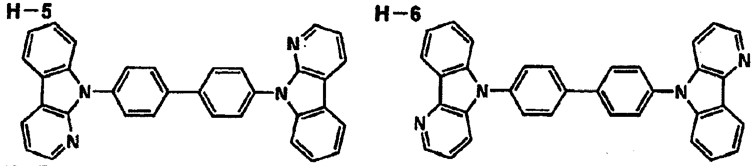 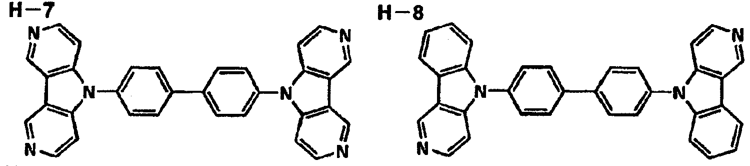 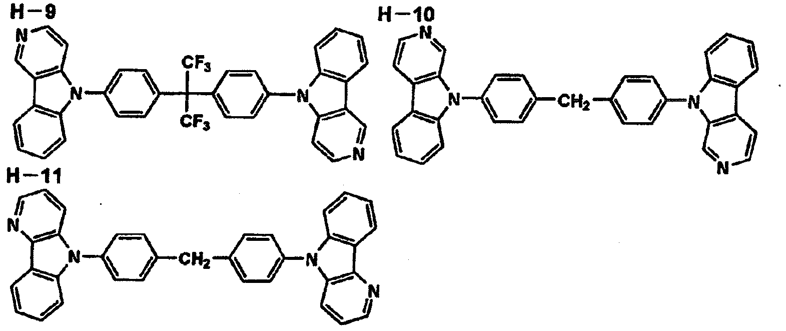 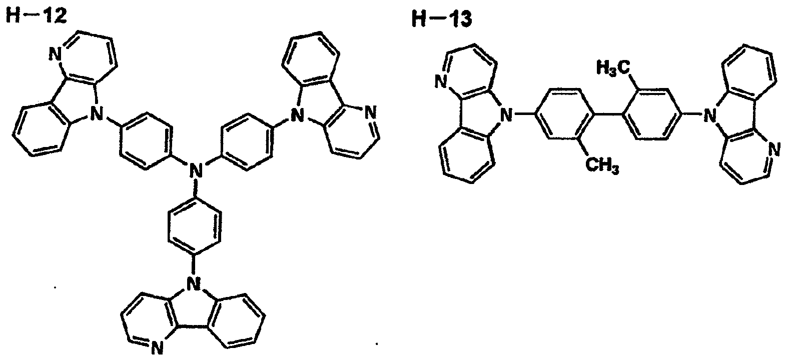 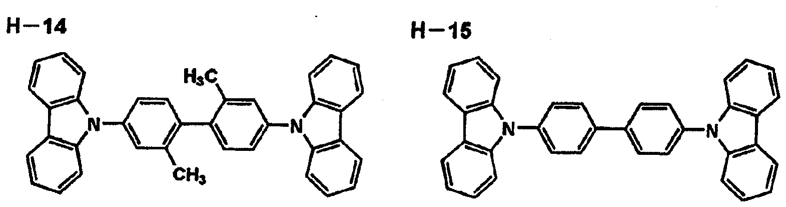 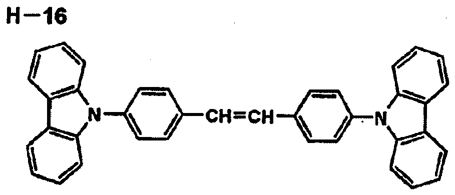 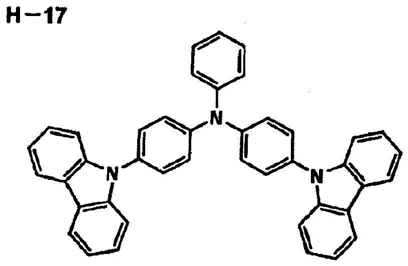 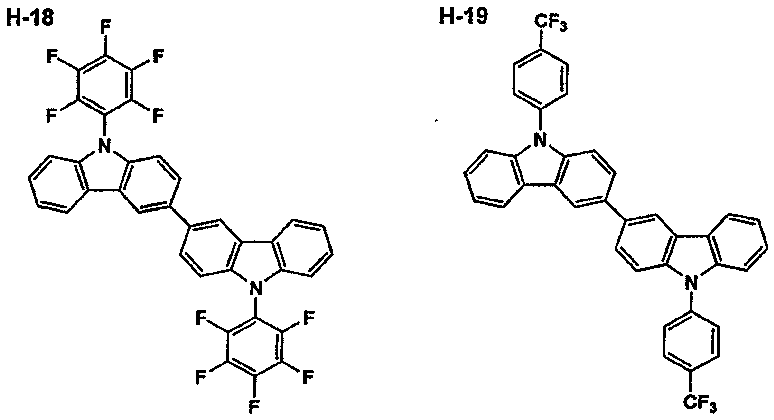 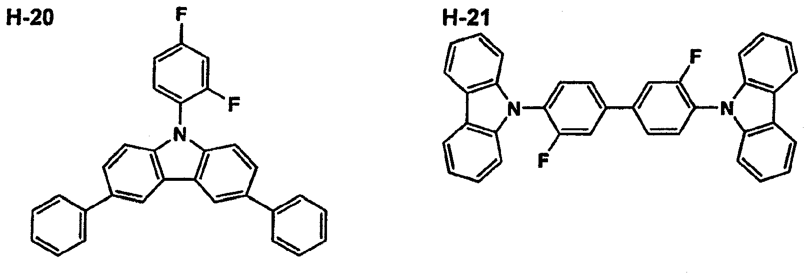 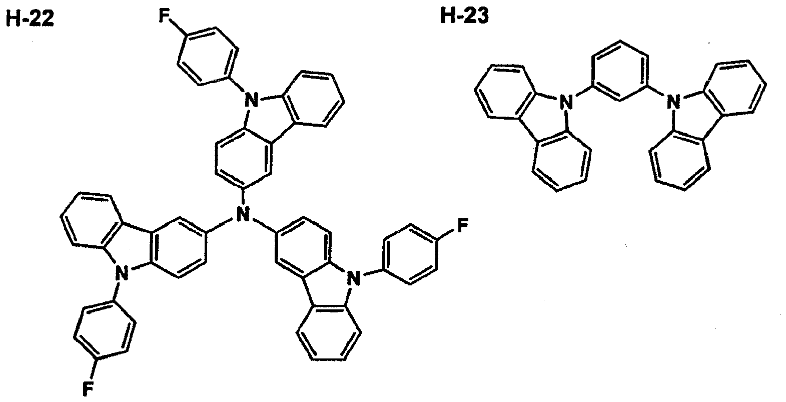 et : 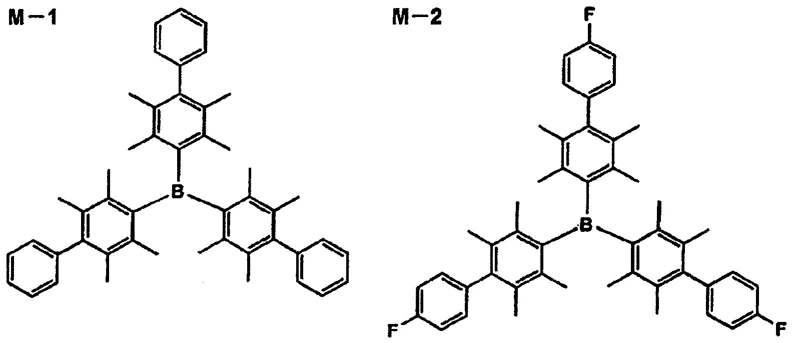 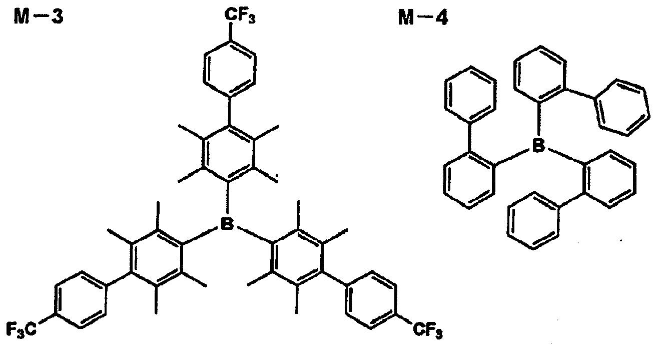 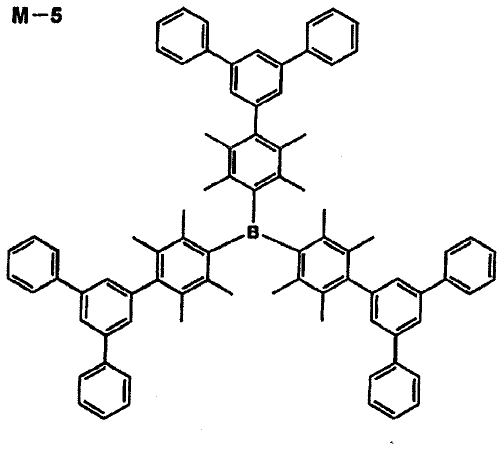 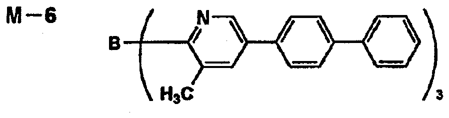 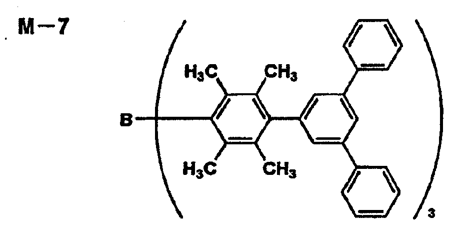 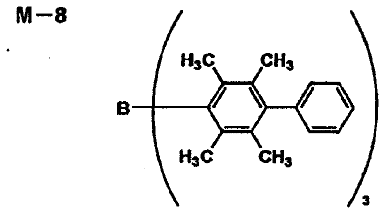 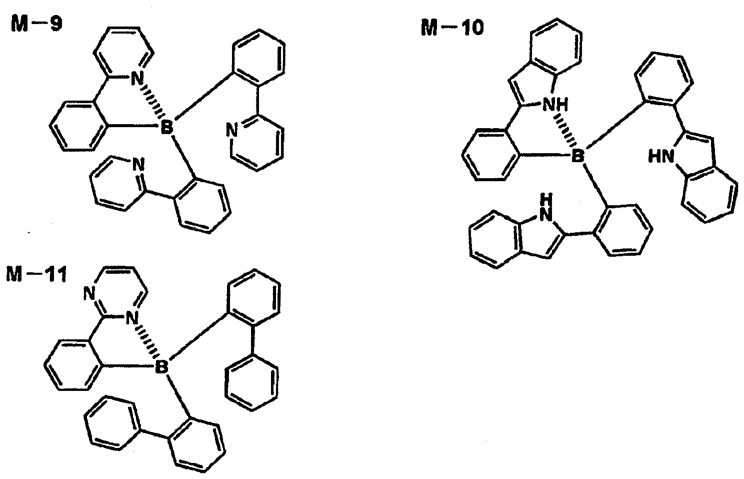 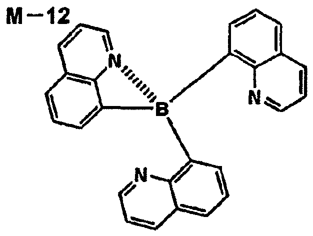 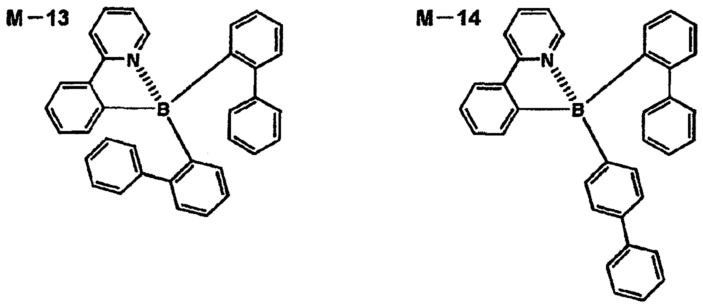 et
sous réserve que, lorsque le composé incluant de chacune des deux ou plus de deux couches émissives est le même, le composé formant la couche intermédiaire soit différent du composé incluant.

2. Elément électroluminescent organique suivant la revendication 1, dans lequel l'épaisseur de la couche intermédiaire est supérieure à la distance de Fôrster entre les deux composés luminescents, chaque composé luminescent étant présent indépendamment dans une des couches luminescentes entre lesquelles est intercalée la couche intermédiaire.

3. Elément électroluminescent organique suivant l'une quelconque des revendications 1 et 2, comprenant en outre une couche de blocage de trous entre une couche luminescente et la cathode, la couche de blocage de trous étant adjacente à la couche luminescente.

4. Elément électroluminescent organique suivant l'une quelconque des revendications 1, 2 et 3, comprenant en outre une couche de blocage d'électrons entre une couche luminescente et l'anode, la couche de blocage d'électrons étant adjacente à la couche luminescente.
